Europäisches Patentamt

(19) European Patent Office

Office européen des brevets

(11) **EP 1 163 632 B1**

(12) **EUROPÄISCHE PATENTSCHRIFT**

(45) Veröffentlichungstag und Bekanntmachung des Hinweises auf die Patenterteilung:
**10.12.2003 Patentblatt 2003/50**

(21) Anmeldenummer: **99915736.5**

(22) Anmeldetag: **01.04.1999**

(51) Int Cl.$^7$: **G06K 19/067**, G01S 13/02

(86) Internationale Anmeldenummer:
**PCT/EP99/02288**

(87) Internationale Veröffentlichungsnummer:
**WO 00/055806 (21.09.2000 Gazette 2000/38)**

(54) **OBERFLÄCHEN-WELLEN-WANDLER-EINRICHTUNG SOWIE IDENTIFIKATIONSSYSTEM HIERMIT**

SURFACE ACOUSTIC WAVE CONVERTER AND IDENTIFICATION SYSTEM USING THE SAME

TRANSDUCTEUR A ONDES ACOUSTIQUES DE SURFACE ET SYSTEME D'IDENTIFICATION EQUIPE DE CE DERNIER

(84) Benannte Vertragsstaaten:
**AT BE CH DE DK ES FI FR GB GR IE IT LI NL PT SE**

(30) Priorität: **15.03.1999 DE 19911369**

(43) Veröffentlichungstag der Anmeldung:
**19.12.2001 Patentblatt 2001/51**

(73) Patentinhaber: **Nanotron Technologies GmbH 10555 Berlin (DE)**

(72) Erfinder:
• **IANELLI, Zbigniew D-13355 Berlin (DE)**
• **KOSLAR, Manfred D-10629 Berlin (DE)**

(74) Vertreter: **Eisenführ, Speiser & Partner Patentanwälte Rechtsanwälte Postfach 10 60 78 28060 Bremen (DE)**

(56) Entgegenhaltungen:
**DE-C- 4 336 897**     **US-A- 5 469 170**

**Beschreibung**

Die Erfindung betrifft eine Oberflächen-Wellen-Wandler-Einrichtung - auch TAGs genannt - sowie Identifikationssysteme in denen diese angewendet wird.

Das Dokument US-A-5 469 170 zeigt eine Oberflächen-Wellen-Wandler-Einrichtung, die aus einer dispersiven Übertragungseinrichtung und einer Vielzahl von nichtdispersiven Wandlern besteht. Ein Identifikationscode wird durch den Abstand der aktiven Wandler zueinander festgelegt.

Aus DE 42 17 049 ist ein drahtlos abfragbarer, passiver Oberflächen-Sensor bekannt. Hierbei wird über ein Abfragegerät per Funk an den Sensor Energie übermittelt, wobei die Abfrage mittels gechirpter Sendesignale erfolgt. Der Sensor weist Wandler und Reflektoren auf. Die Reflektoren reflektieren das Chirpsignal in zeitlich gestaffelter Folge, so daß der Sensor ein zeitlich gestaffeltes Chirpsignal zum Abfragegerät zurücksendet. Der vorbeschriebene Oberflächenwellen-Sensor (hier nachfolgend auch SAW (surface acoustic wave)- oder OFW (akustischer Oberfiächenwellen)-Sensor genannt) weist durch das Reflexionsprinzip eine sehr hohe Einfügungsdämpfung auf, die beispielsweise in der Größenordnung von 50 dB liegt. Nach Empfang des Chirp-Signals durch einen OFW-Interdigitalwandler als Eingangswandler erzeugt dieser eine Oberflächenwelle, die sich auf dem Substrat der OFW-Anordnung in Richtung der Reflektoren ausbreitet. Jedes einzelne Reflektorelement sendet bei Empfang einer OFW eine entsprechend reflektierte OFW an den OFW-Wandler zurück, welcher seinerseits aus der OFW ein elektro-magnetisches Signal erzeugt. Da jedoch jedes Reflektorelement nicht nur eine OFW an den OFW-Wandter zurücksendet, sondern die Reflektorelemente auch untereinander Signale reflektieren, müssen die Reflexionen relativ klein sein und es geht ein Großteil der vom OFW-Wandler kommenden Energie in der Reflektoranordnung verloren, so daß nur eine geringe Ausgangsleistung erzielt werden kann. Das Problem der "Eigenreflexion" der Reflektoren läßt sich prinzipiell nicht vermeiden.

Aus US-PS 5,734,326 ist eine OFW-Anordnung bekannt, welche aus einem Synchronisationswandler und einer Vielzahl von "tap transducer" besteht. Diese OFW-Anordnung sendet bei Anregung mit einem Radiofrequenzpulssignal ein bestimmtes Identifikationssignal aus, so daß der Empfänger in der Abfrageeinheit, das ausgesandte TAG-Signal empfangen und verarbeiten kann. Diese Verarbeitung setzt jedoch voraus, daß ein Filter in der Abfrageeinheit genau auf das TAG abgestimmt ist, von welchem das TAG-Signal empfangen wird. Die Verarbeitung eines TAG-Signals setzt demgemäß voraus, daß die Abfrageeinheit bereits weiß, nach welchem TAG-Kennzeichen sie zu suchen hat, so daß zur Verwertung des TAG-Signals das Filter in der Abfrageeinheit entsprechend voreingestellt werden kann. Somit offenbart US-Patent 5,734,326 ein TAG-System, welches über sehr begrenzte Einsatzmöglichkeiten verfügt. Kennt die Abfrageeinheit die Identifizierung des TAGs nicht, ist es praktisch unmöglich, das Filter in der Abfrageeinheit auf das TAG abzustimmen, weil es zu lange dauern würde, bis alle denkbaren Varianten abgefragt worden sind.

Ein weiterer Nachteil der aus US-Patent 5,734,326 bekannten TAGs ist es, daß die tap transducer (Tap-Wandler) nicht programmierbar sind, was ihre Herstellung erheblich verkompliziert und teuer macht.

Soll das TAG über eine große Abfragedistanz verfügen, müßte man die Energie des RF-Pulssignals erheblich anheben. Hierzu müßte das Signal jedoch so leistungsstark sein, daß es gegen die üblichen Auf lagen der Zulassungsbehörden verstößt, welche die Signalformen und Leistungsspektren von Sendern auf ein bestimmtes Maß begrenzen, damit es nicht zu unerwünschten Störungen kommt, wie sie beispielsweise auch aus der Radartechnik bekannt sind, dort jedoch wegen wichtiger Überwachungsfunktionen (Flugüberwachung) in einem bestimmten Frequenzbereich zugelassen werden.

Ferner sind aus "1996 IEEE International Frequency Control Symposium", Seiten 208-215 "Wireless Integrated System For SAW-Identification Marks And SAW-Sensor Components" sowie 1993 "Ultrasonic Symposium", Seiten 125-130, "Programable Reflectors For SAW-ID-Tags" sowie "IEEE Ultrasonics Symposium", Oktober 1998, "SAW Delay Lines For Wirelessly Requestable Conventional Sensors" sowie 1993 "Ultrasonics Symposium", Seiten 1267-1270 "2.5 GHz-Range SAW Propagation And Reflections Characteristics And Application To Passiv Electronic Tag And Matched Filter" und ferner aus IEEE "Ultrasonics Symposium 1998" "On-Chip Correlation- A New Approach To Narrow Band SAW Identification Tags" weitere SAW-TAG-Anordnungen bekannt, die ebenfalls eine sehr hohe Einfügungsdämpfung (TAG Attenuation) aufweisen und dementsprechend auch nur eine sehr geringe Distanz von 1.3 m zulassen, die zwischen einer Abfrageeinrichtung und dem TAG liegen darf, damit überhaupt eine Kommunikation zwischen dem Abfragegerät und dem TAG möglich ist. Darüber hinaus zeichnen sich die bekannten SAW-Tag-Einrichtungen durch eine geringe Bitkapazität von etwa 20 Bit aus.

Ferner sind verschiedene Identifikationssysteme mit codierten passiven Transpondern oder SAW-Strukturen aus folgenden Schriften bekannt: DE 44 05 647 A1, DE 42 00 076 A1, DE 34 38 050 A1, US 4,059,831, DE 34 38 053 C2, DE 43 36 504 C1, DE 43.10 610 A1, DE 34 38 052 C2, DE 43 36 897 C1, DE 31 02 334 C2, US 4,096,477, US 5,734,326, US 5,374,863, US 4,604,623, DE 34 38 051 A1 sowie DE 34 38 051 C2. Alle diese Veröffentlichungen offenbaren jedoch Systeme, welche bestimmte Nachteile aufweisen, beispielsweise sind entweder die Abfragedistanzen sehr gering (< 1,3m), die Einfügungsdämpfungen dementsprechend zu hoch oder die dargestellten Lösungen lassen sich unter Kostengesichtspunkten kaum mehr vertreten oder erlauben nur eine geringe Flexibilität aufgrund einer geringen Bit-Kapazität.

Es ist Aufgabe der Erfindung, eine Oberflächen-Wellen-Wandler-Einrichtung vorzusehen, welche über eine geringe Einfügungsdämpfung verfügt, eine erheblich höhere Abfragedistanz als bei bisher bekannten TAGs erlaubt und deren Bitkapazität vergrößert ist, wobei eine freie Programmierung gegeben sein soll, die sich einfach durchführen läßt. Erfindungsgemäß wird eine Oberflächen-Wandlereinrichtung mit den Merkmalen nach Anspruch 1 vorgeschlagen. Vorteilhafte Weiterbildungen sind in den Unteransprüchen beschrieben.

Die Erfindung basiert auf dem Gedanken, auf einer Oberflächen-Wellen-Wandler-Einrichtung eine Kombinationsanordnung einer dispersiven Wandlereinrichtung mit einer nichtdispersiven Wandlereinrichtung vorzusehen. Eine dispersive Wandlereinrichtung ist in der Lage, aus einem Chirp-Signal ein Oberflächen-Wellen-Pulssignal zu erzeugen, welches von der nichtdispersiven Wandlereinrichtung, bestehend aus n Wandlern, empfangen und von dieser in eine Code-Pulssignalfolge, die die Oberflächen-Wellen-Wandler-Einrichtung identifiziert, umgesetzt wird. Die Pulssignalfolge wird dann von der Oberflächen-Wellen-Wandler-Einrichtung über eine Antenne ausgesendet und kann von einer Abfrageeinheit innerhalb eines Identifikationssystems empfangen und hinsichtlich des Identifikationskennzeichens bewertet werden.

Eine erfindungsgemäße OFW-Wandler-Einrichtung zeichnet sich durch erheblich größere als bislang bekannte Abfragedistanzen aus, verfügt über eine sehr große Bit-Kapazität und ist sehr leicht zu programmieren. Die große Abfragedistanz und die dementsprechend geringe Einfügungsdämpfung ist dadurch begründet, daß die erfindungsgemäße OFW-Wandler-Einrichtung bei Empfang eines Signals von einer Abfrageeinheit (Interrogator) einmal das Abfragesignal in der dispersiven OFW-Wandler-Einrichtung in ein zeitkomprimiertes Oberflächenwellen-Signal umgewandelt wird, welches von der nichtdispersiven Wandlereinrichtung empfangen wird.

Auch die nichtdispersive Wandlereinrichtung empfängt das Abfragesignal und erzeugt entsprechende OFW-Signale, welche von dem dispersiven Wandler empfangen werden. Nach dem Empfang wandelt dieser die Oberflächenwellen in entsprechende elektromagnetische Signale um. Aufgrund der identischen Laufzeiten der Signale von der dispersiven Wandlereinrichtung zur nichtdispersiven Wandlereinrichtung und umgekehrt, überlagern sich ausgangsseitig zwei identische Signale, so daß das von dem TAG auszusendende Codesignal über eine größere Signalleistung verfügt. Das Antwortsignal des TAGs auf ein Abfragesignal besteht demgemäß aus zwei Komponenten, da beide Komponenten jedoch zeitgleich von dem TAG ausgesandt werden und beide Signalkomponenten über die identische Signalform verfügen, verfügt das erfindungsgemäße TAG über eine höhere Leistungseffizienz und das TAG-Sendesignal ist erheblich leistungsstärker als das TAG-Signal bei vergleichbaren OFW-Anordnungen, wobei sich die Leistungsstärke stets auf vergleichbare Interrogator-Abfragesignale bezieht.

Die erfindungsgemäße Oberflächen-Wellen-Wandler-Einrichtung besitzt vorteilhafterweise keine Reflektoren, so daß die Einfügungsdämpfung erheblich geringer ist als bei Reflektoranordnungen. Die Einfügungsdämpfung beträgt bei bekannten SAW-TAGs mit Reflektoranordnung etwa 50 dB. Mit einer erfindungsgemäßen Oberflächen-Wellen-Wandler-Einrichtung und somit einem erfindungsgemäßen TAG läßt sich die Einfügungsdämpfung auf einen Bereich von etwa 30 bis 35 dB absenken, wodurch die Abfrageentfernung drastisch ansteigt. Als Abfragesignal wird zweckmäßigerweise ein Chirpsignal verwendet, welches auf dem erfindungsgemäßen SAW-TAG in ein zeitkomprimiertes Pulssignal umgewandelt wird. Das TAG-Antwortsignal besteht bei einem Chirp-Abfragesignal aus zeitkomprimierten, zeitversetzten Pulssignalen, wobei die Modulation der Antwortsignale von der Programmierung der n-Wandler innerhalb der nichtdispersiven Wandleranordung abhängt. Ist beispielsweise ein einzelner Wandler der n Wandler nicht an die gemeinsamen Busleitungen angeschlossen, so erfolgt auch kein Antwortsignal durch diesen Wandler. Eine solche Antwort kann als logisch "Null" aufgefaßt werden.

Die Vorteile der Erfindung und besonders zweckmäßige Ausführungsformen werden nachfolgend anhand verschiedener Ausführungsbeispiele inden Zeichnungen erläutert. In den Zeichnungen ist dargestellt:

Fig. 1    Blockschaltbild eines Identifikationssystems mit einer erfindungsgemäßen Identifikationseinrichtung;

Fig. 2    verschiedene Meßdiagramme für das Signal-zu-RauschVerhältnis bei unterschiedlichen Bedingungen;

Fig. 3    -

Fig. 4    -

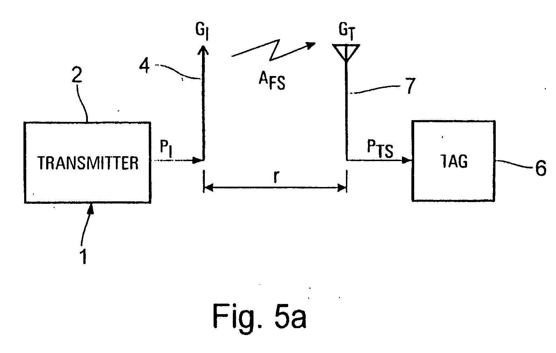

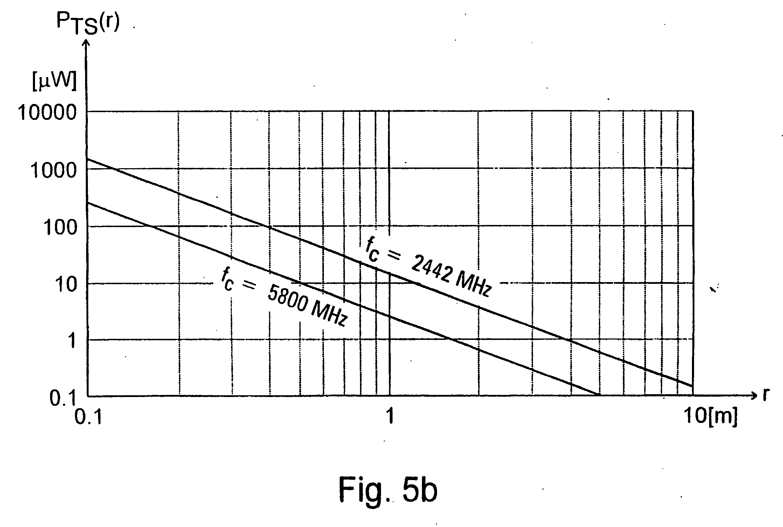

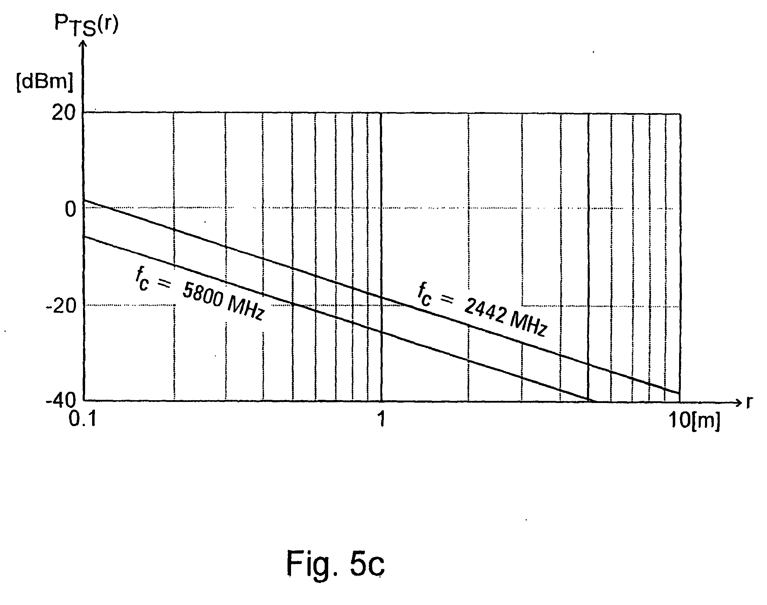

Fig. 5    Darstellung der Empfangsleistung im TAG, abhängig von der Entfernung zwischen TAG und Interrogator;

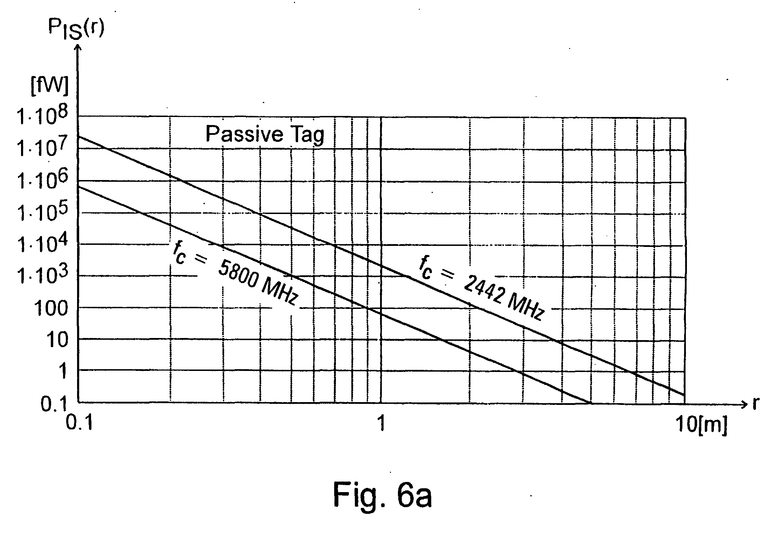

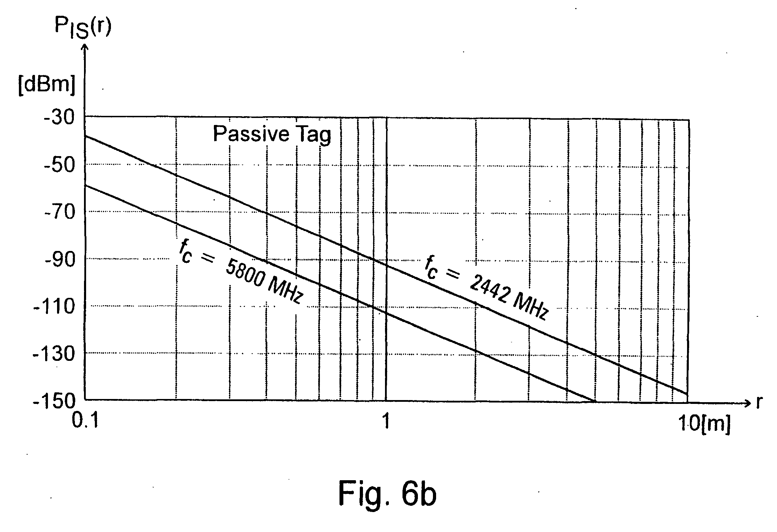

Fig. 6    Darstellung der Empfangsleistung in der Abfrageeinrichtung, abhängig von der TAG-Entfernung;

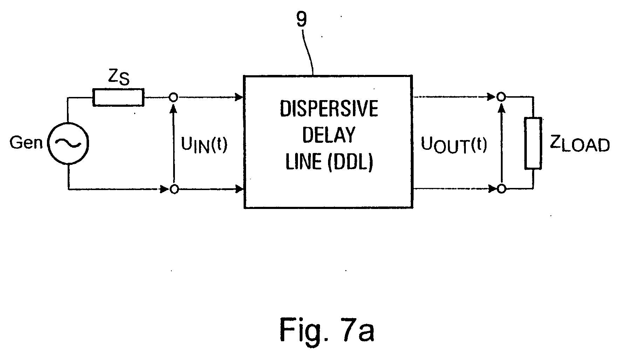

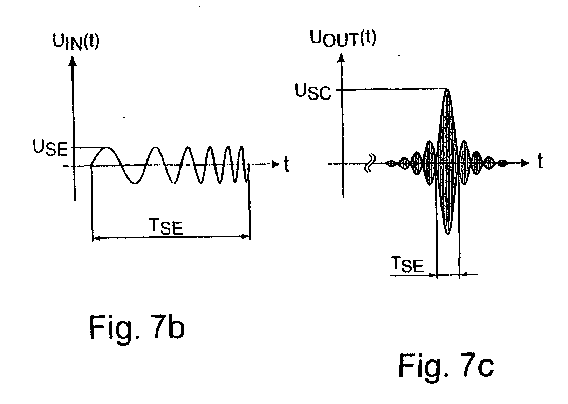

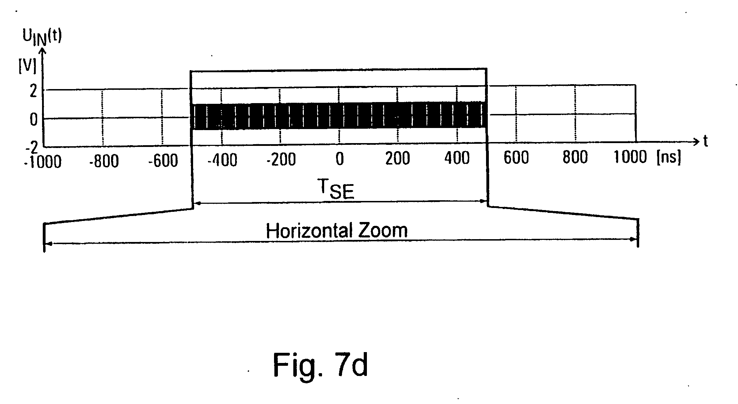

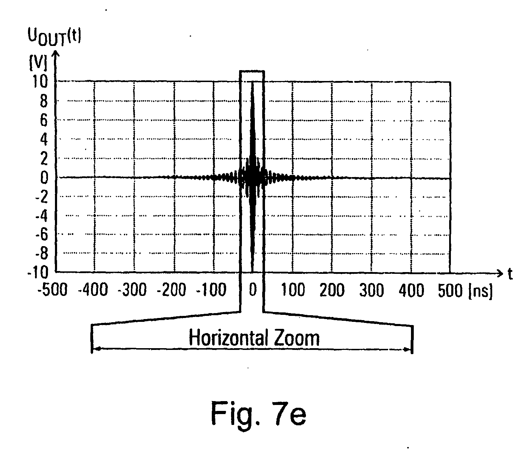

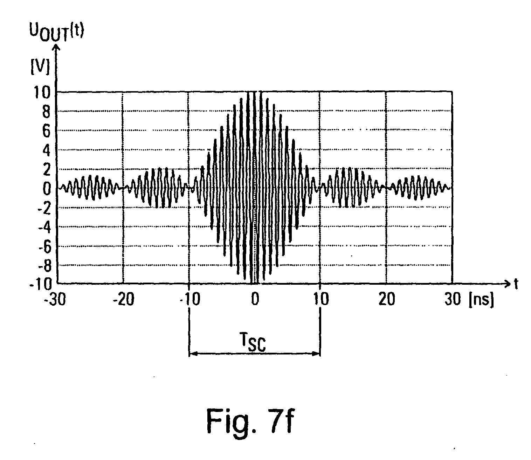

Fig. 7    Darstellung eines Chirp-Signals sowie eines hieraus generierten Pulssignals;

Fig. 8        -

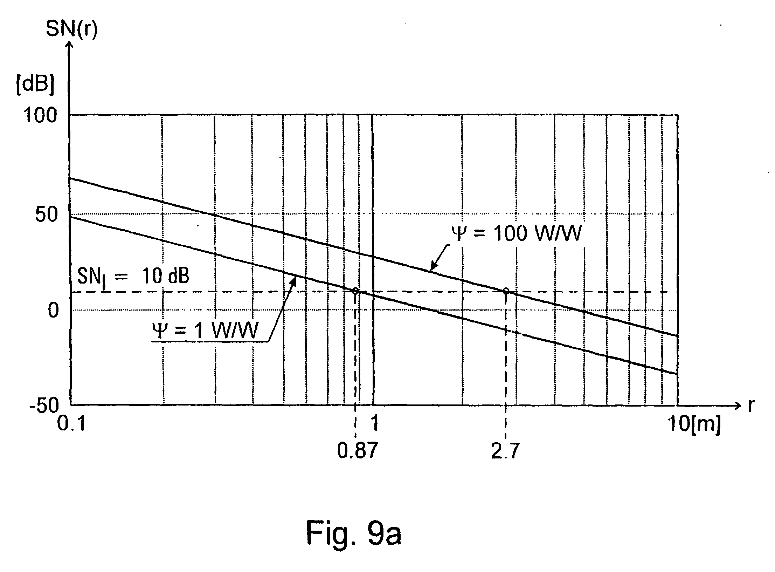

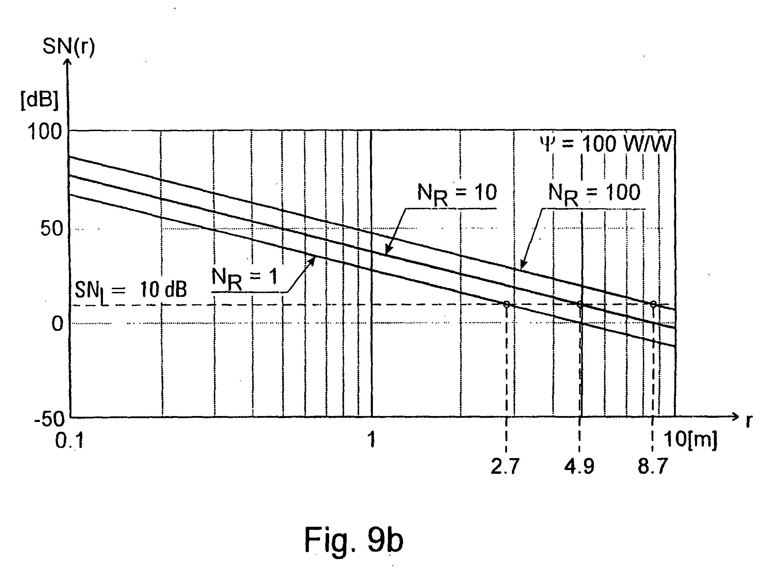

Fig. 9        Darstellung des Signalrauschabstandes bei verschiedenen Bedingungen und mehreren Messungen;

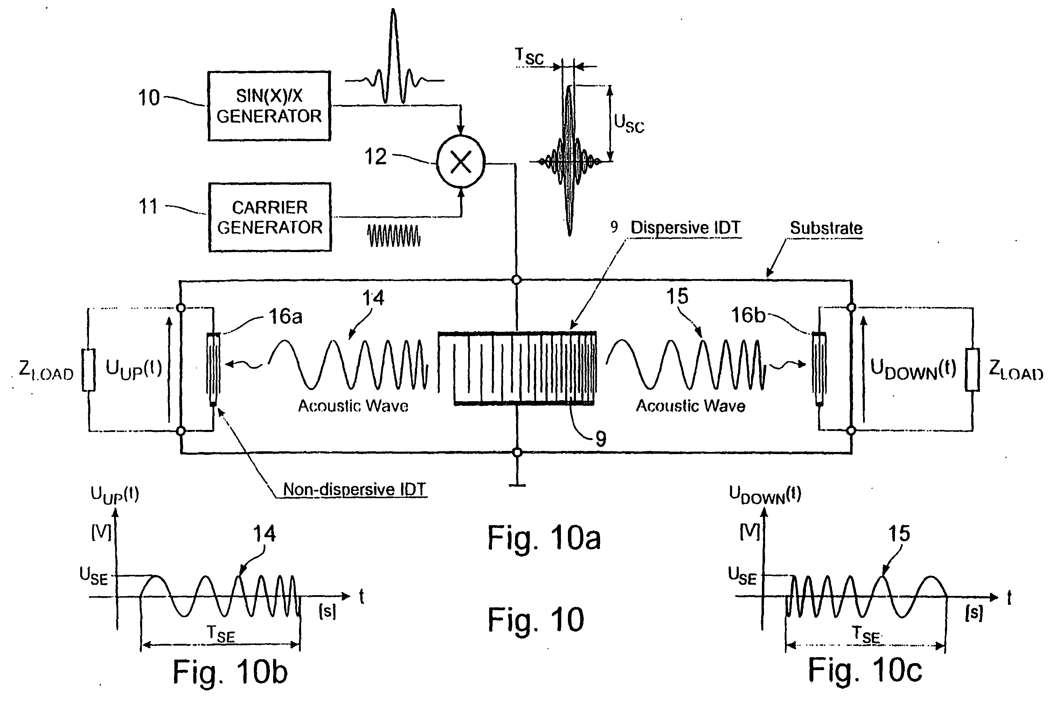

Fig. 10       Darstellung einer komplementären dispersiven Verzögerungsleitung zur Erzeugung von Chirp-Impulsen;

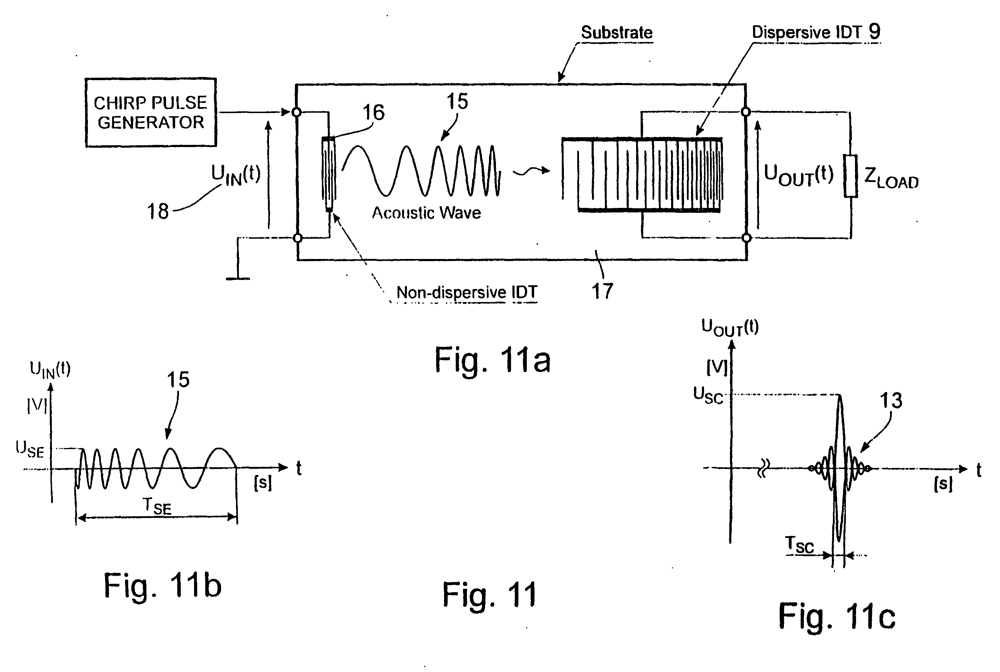

Fig. 11       Darstellung einer dispersiven Verzögerungsleitung zur Erzeugung einer Chirp-Puls-Kompression;

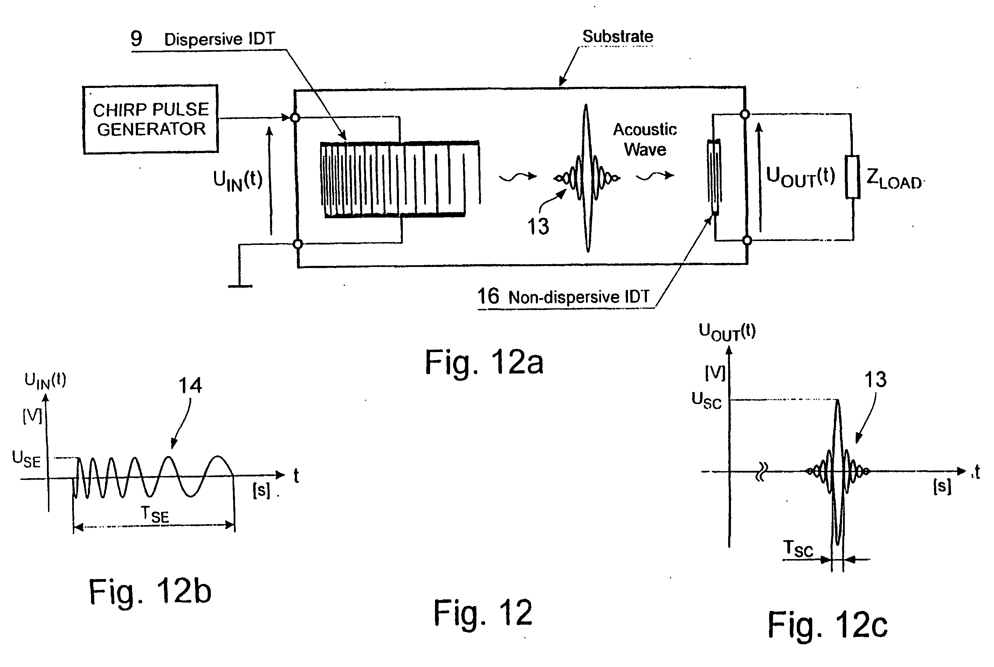

Fig. 12       Darstellung einer dispersiven Verzögerungsleitung mit einem zu Fig. 11 reziproken Verfahren zur Erzeugung einer Chirp-Pulskompression;

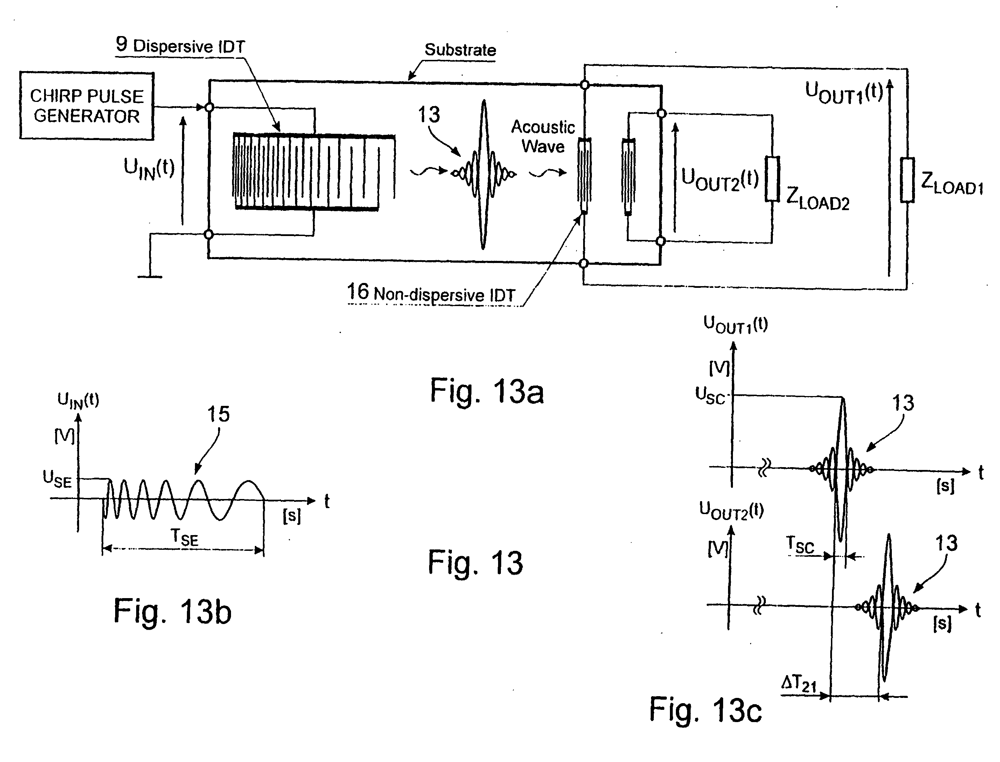

Fig. 13       Darstellung einer Oberflächen-Wellen-Wandler-Einrichtung mit einer dispersiven Wandlereinrichtung und einer Wandlereinrichtung mit zwei nichtdispersiven Wandlern;

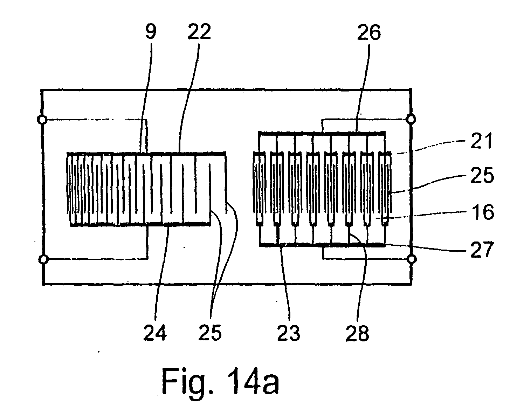

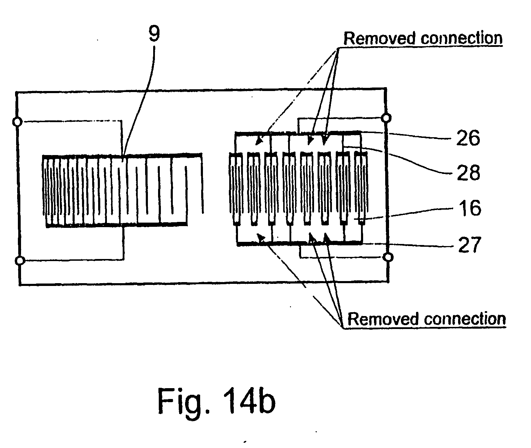

Fig. 14       Darstellung einer erfindungsgemäßen Oberflächen-Wellen-Wandler-Anordnung vor und nach Programmierung/Codierung mit einem dispersiven Wandler und einer Mehrzahl von nichtdispersiven Wandlern;

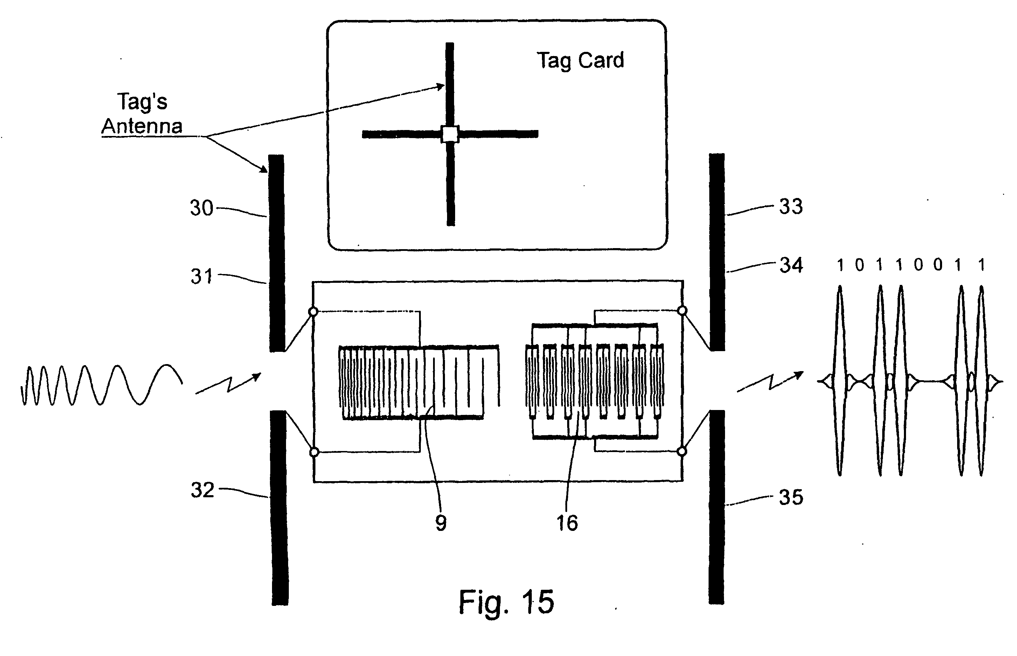

Fig. 15       Darstellung der prinzipiellen Funktionsweise eines TAGs mit dispersivem Wandler am Eingang und codierter nichtdispersiver Wandlereinrichtung am Ausgang;

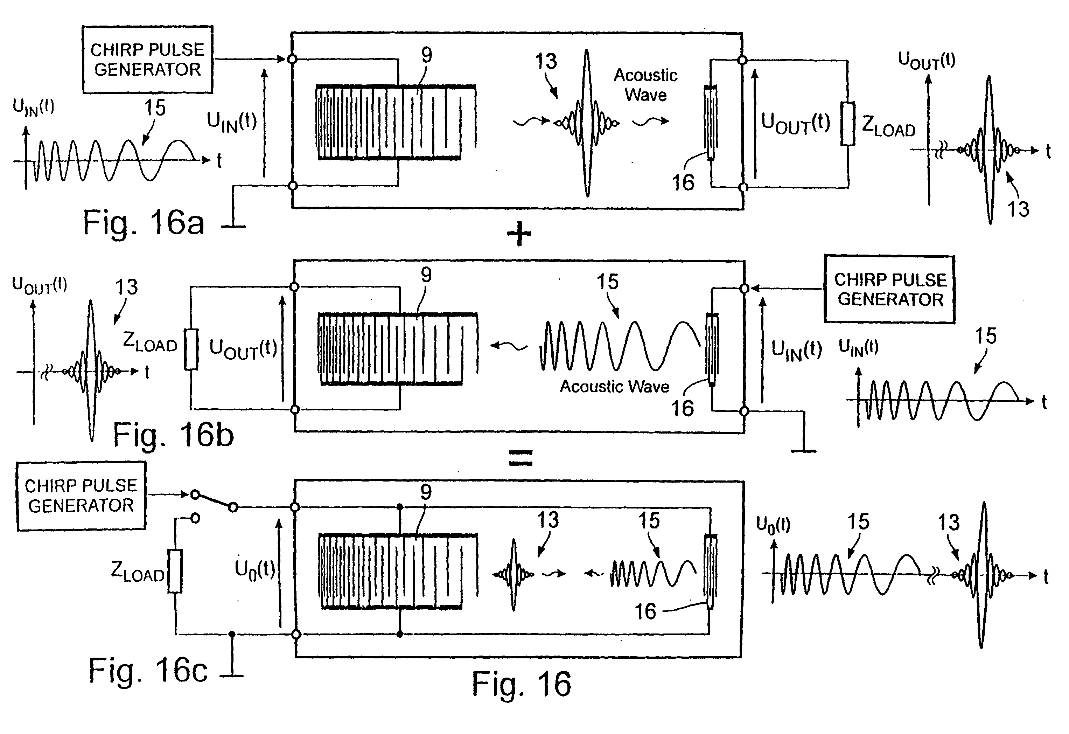

Fig. 16       Prinzipdarstellung der Betriebsweise einer dispersiven SAW-Wandlereinrichtung mit einer gemeinsamen Eingangs- und Ausgangsleitung;

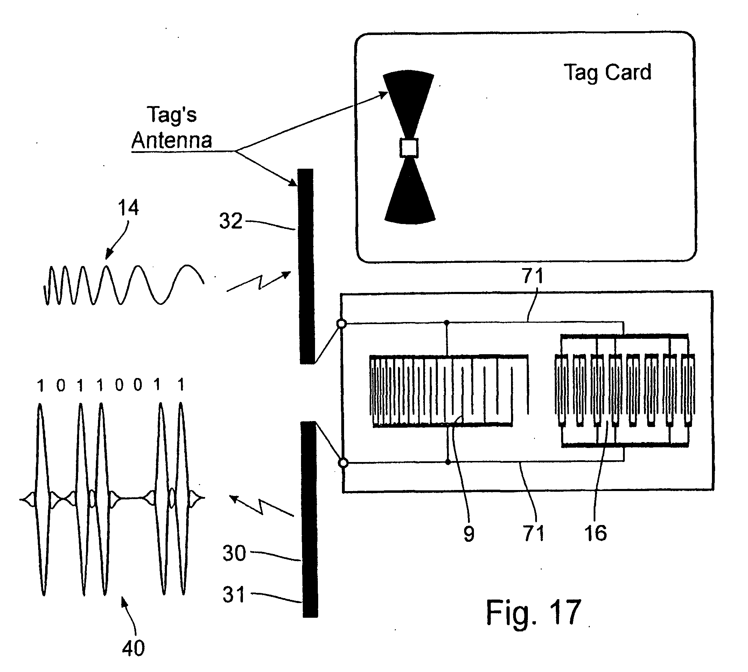

Fig. 17       Prinzipdarstellung eines erfindungsgemäßen SAW-TAGs;

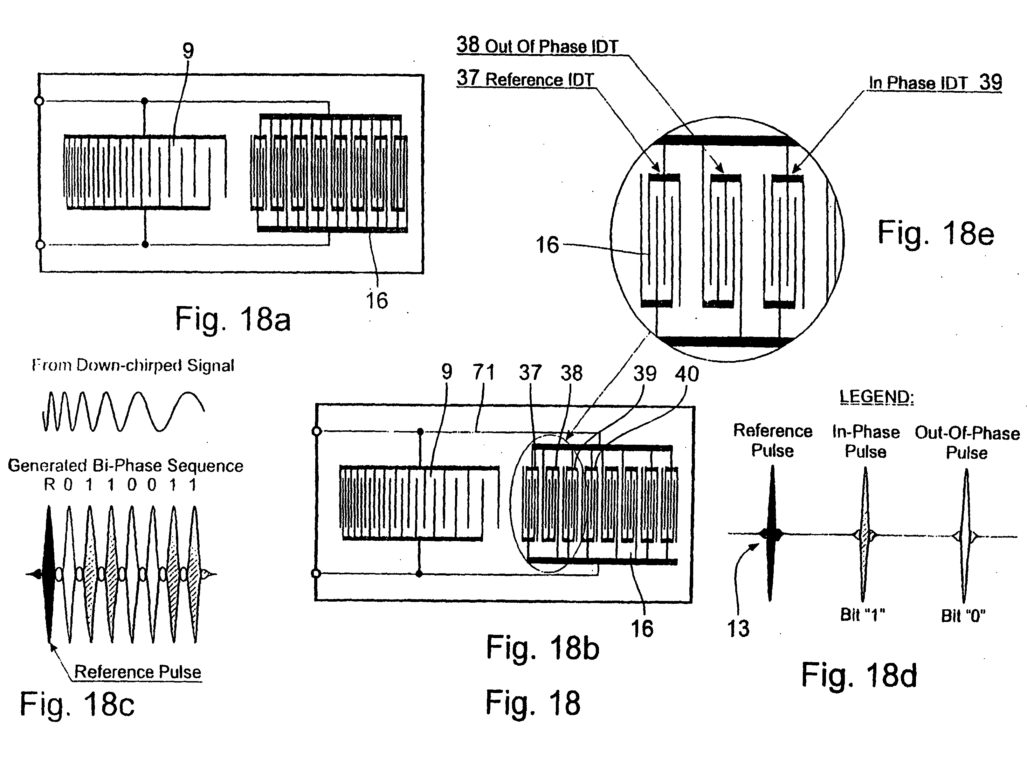

Fig. 18       Darstellung einer erfindungsgemäßen biphasen codierten SAW-Wandler-Einrichtung;

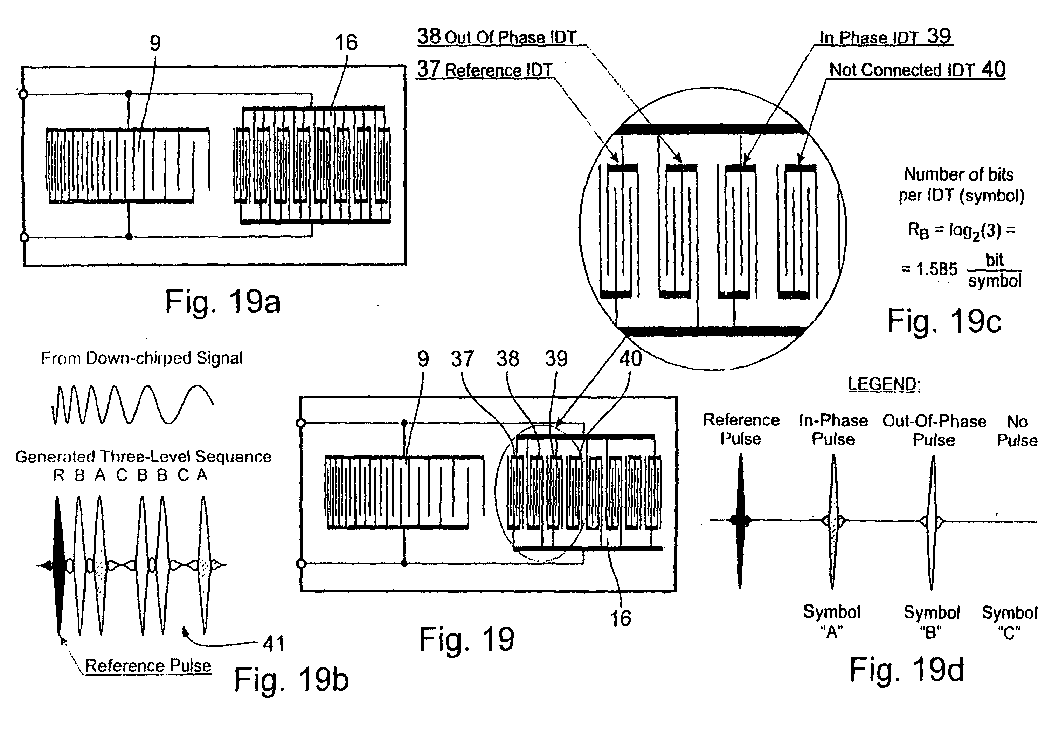

Fig. 19       Darstellung eines programmierten TAGs mit einem Antwortsignal mit drei logischen Zuständen A, B, C;

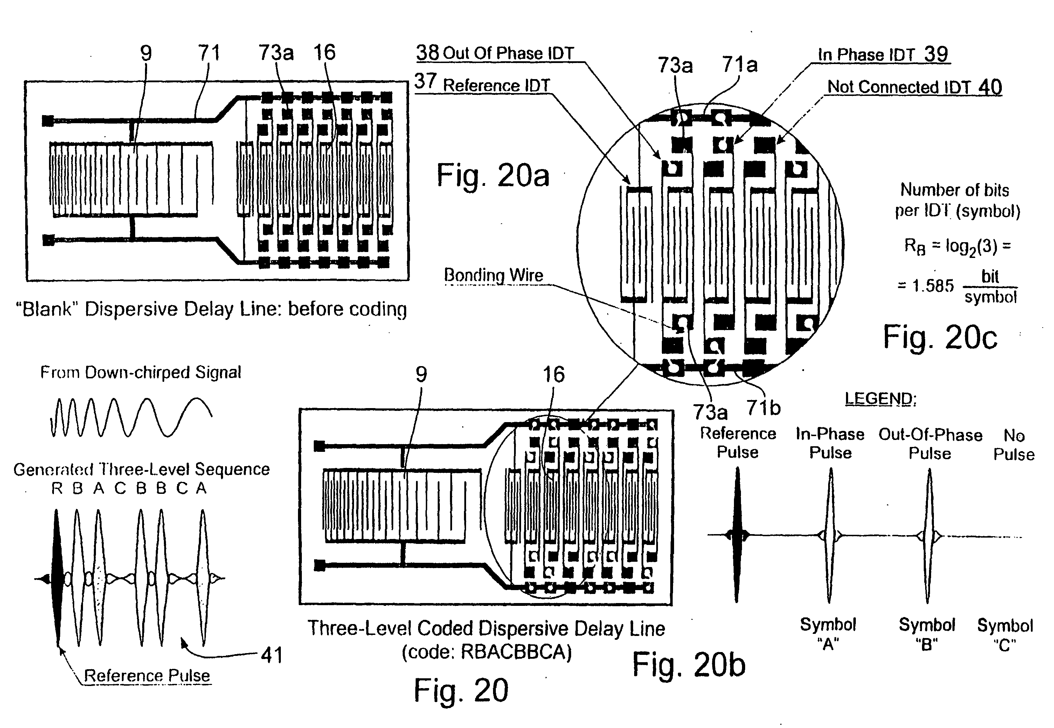

Fig. 20       Darstellung eines TAGs mit einer Programmierung durch Leitungs-Verbindung (Bonding);

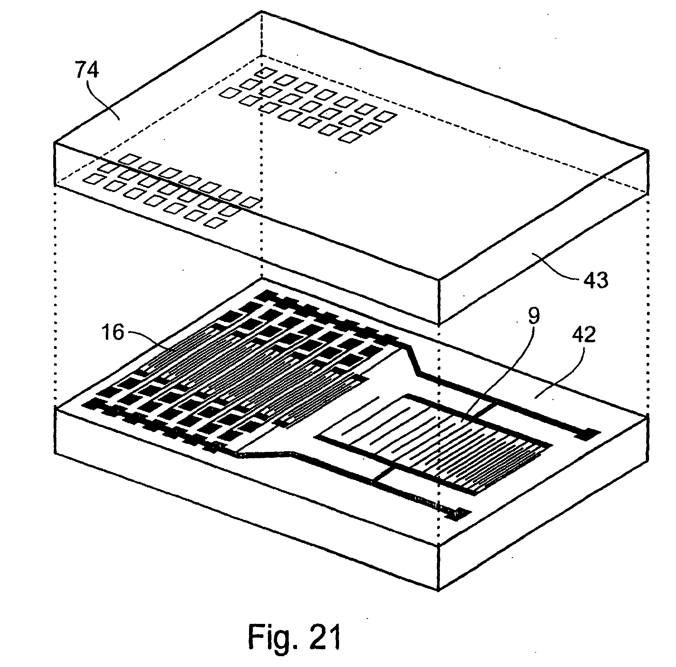

Fig. 21       Darstellung einer erfindungsgemäßen SAW-Wandler-Einrichtung mit einer Programmierung durch einen Siliziumchip;

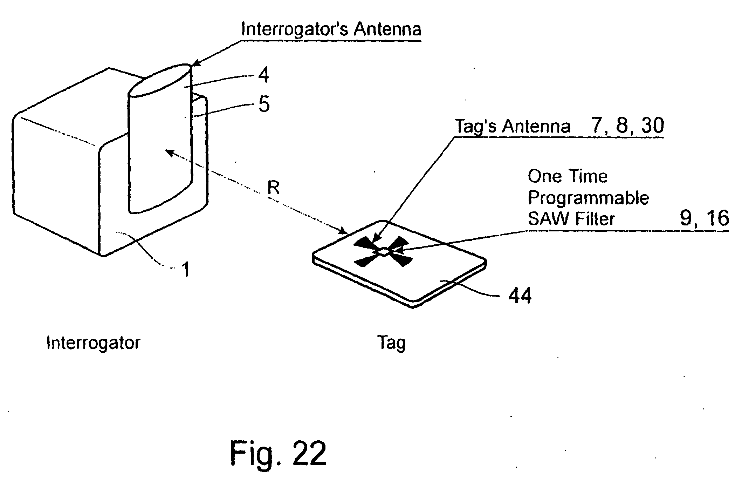

Fig. 22       Darstellung eines Identifizierungssystems mit einer Abfrageeinheit und einem erfindungsgemäßem TAG (passives TAG);

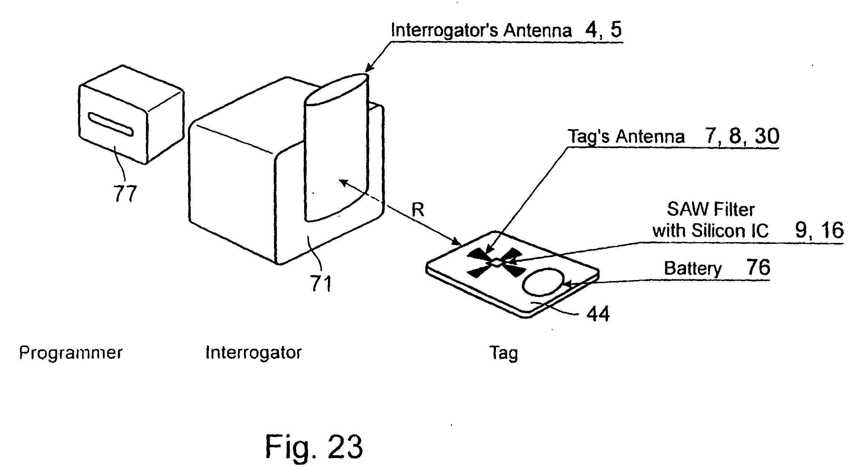

Fig. 23       wie Fig. 22 jedoch mit einem reprogrammierbaren passiven TAG;

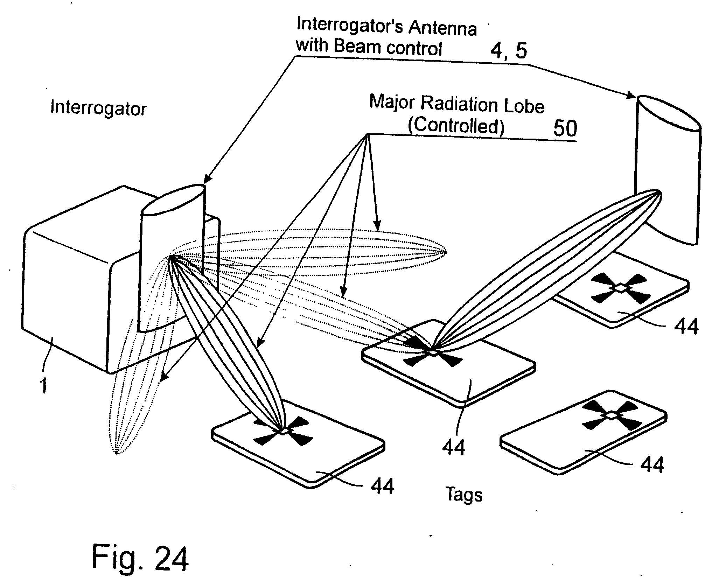

Fig. 24       Darstellung eines erfindungsgemäßen Identifizierungssystems mit mehreren Abfrageeinheiten und mehreren TAGs;

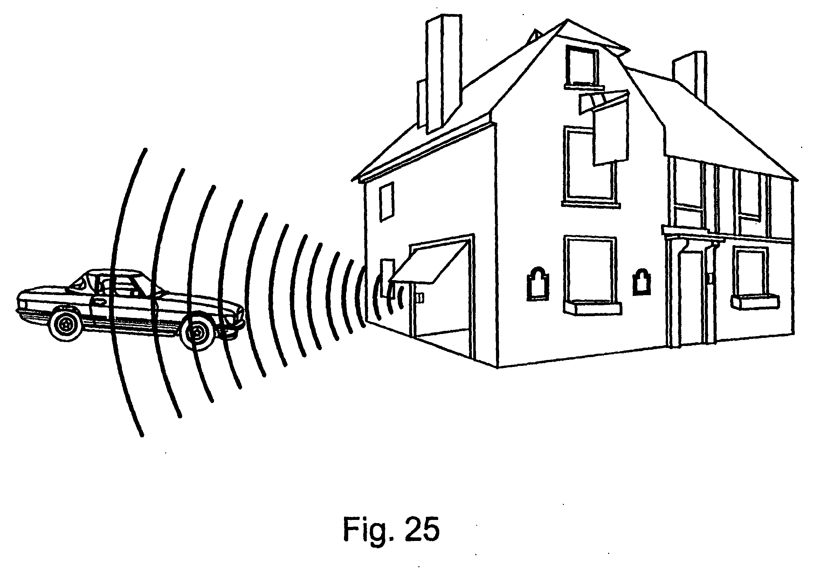

Fig. 25       Darstellung eines Anwendungsbeispiels eines erfindungsgemäßen Identifizierungssystems;

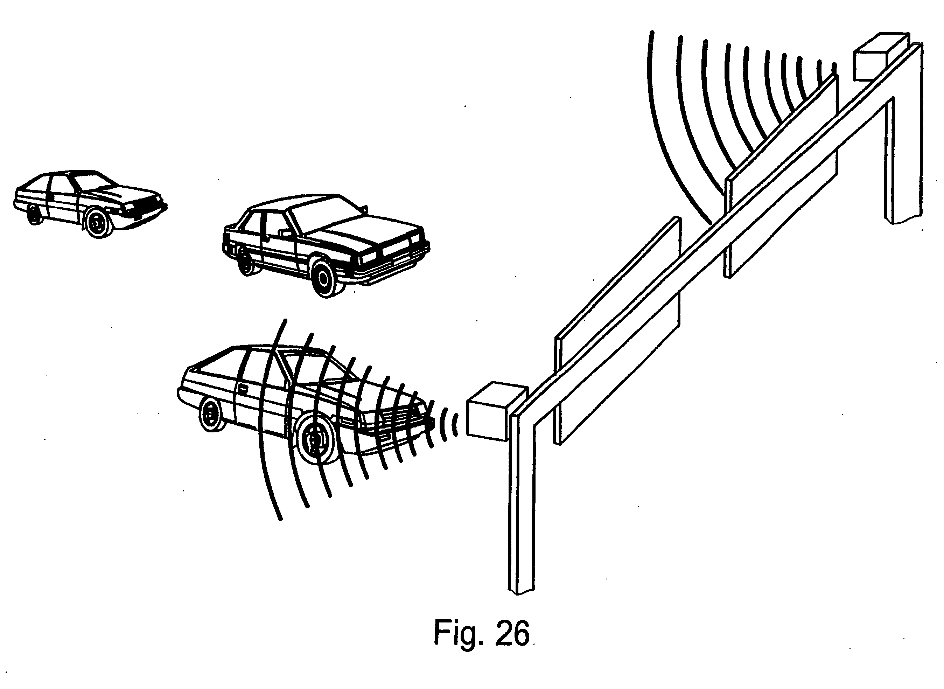

Fig. 26       Darstellung eines weiteren Anwendungsbeispiels eines erfindungsgemäßen Identifizierungssystems;

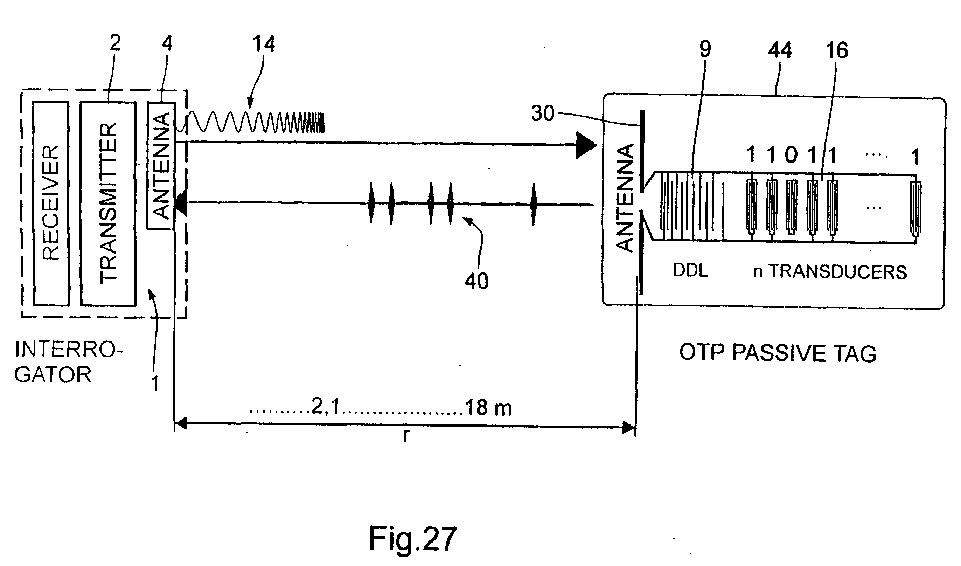

Fig. 27       Darstellung eines erfindungsgemäßen Identifizierungssystems mit einem passiven TAG;

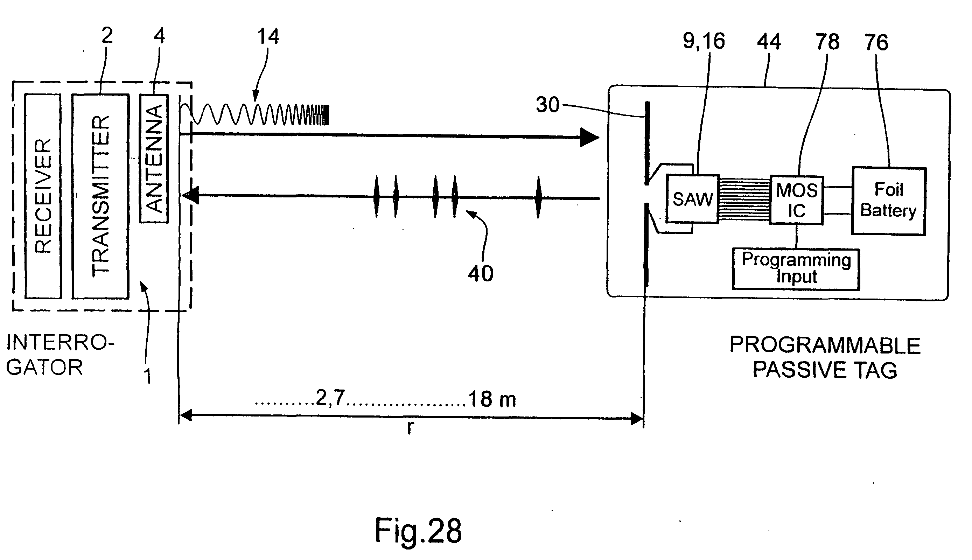

Fig. 28       Darstellung eines erfindungsgemäßen Identifizierungssystems mit einem reprogrammierbaren passiven TAG;

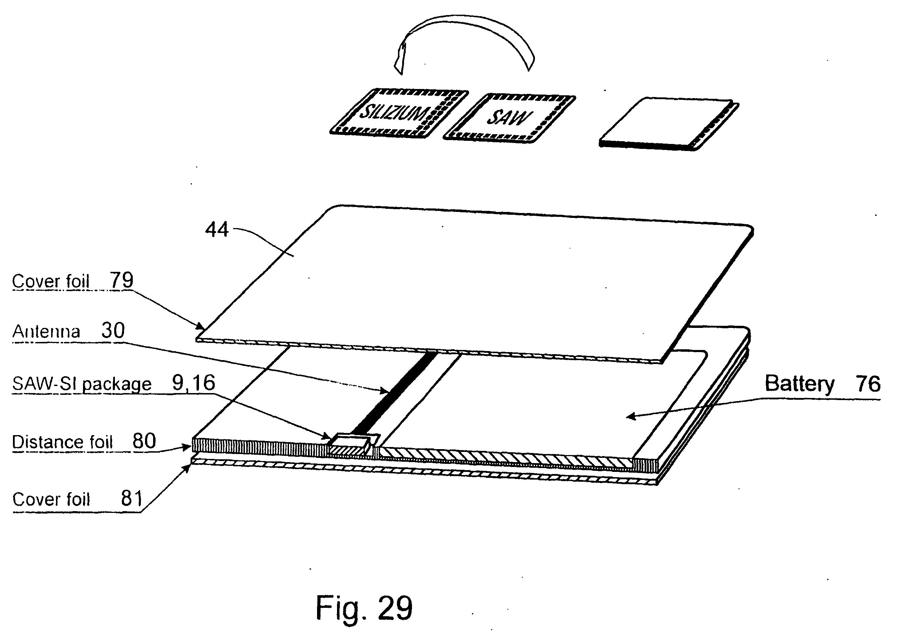

Fig. 29       schematische Darstellung eines erfindungsgemäßen TAGs;

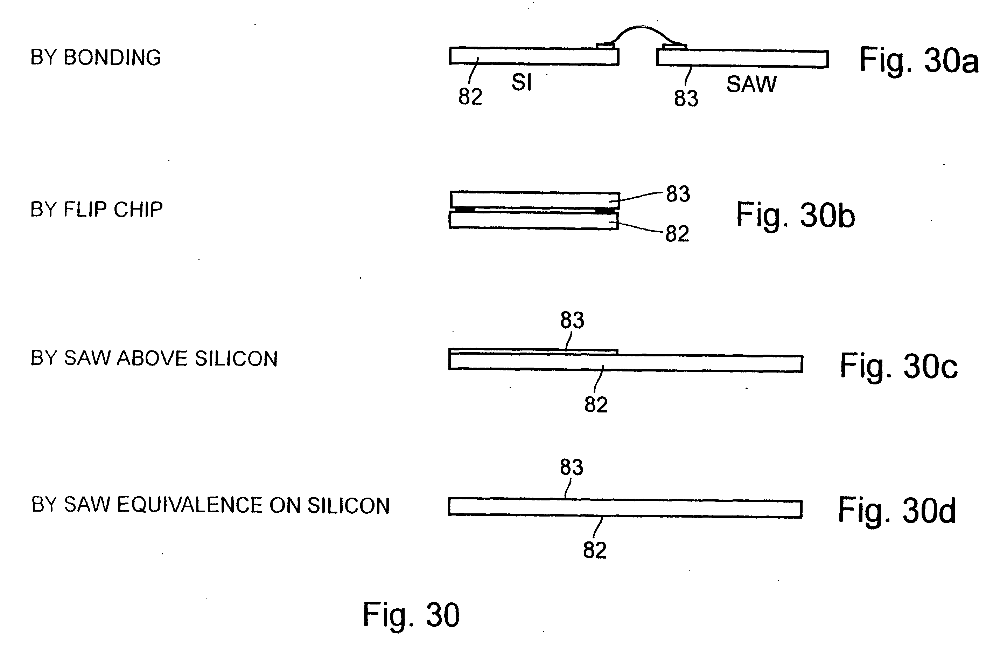

Fig. 30       Darstellung der verschiedenen Verbindungsweisen eines SAW mit Silizium;

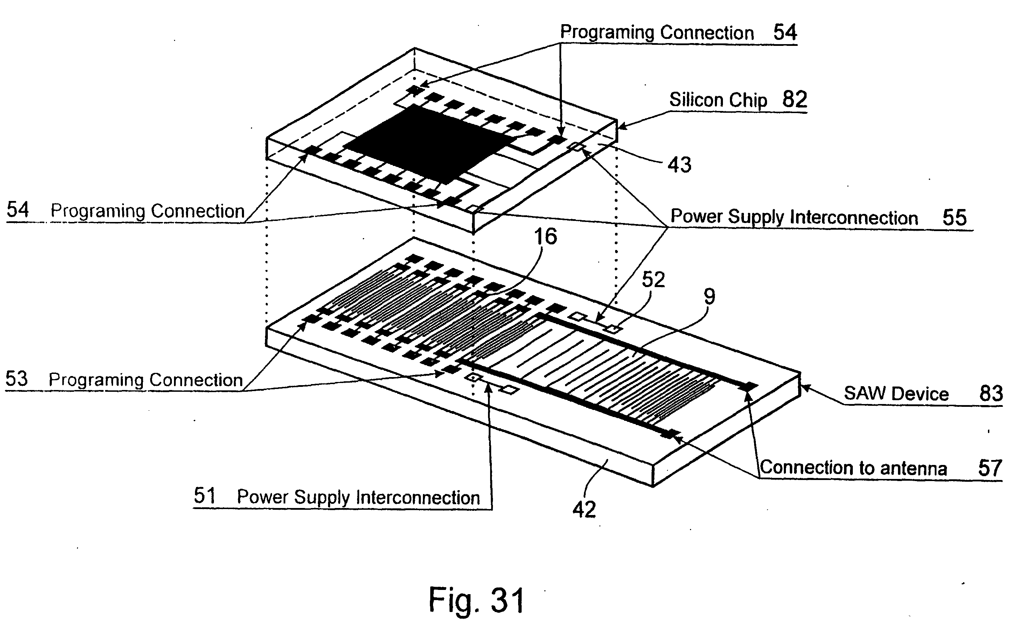

Fig. 31       Darstellung der Verbindung einer SAW-Struktur mit einem Siliziumchip zur Programmierung des TAG;

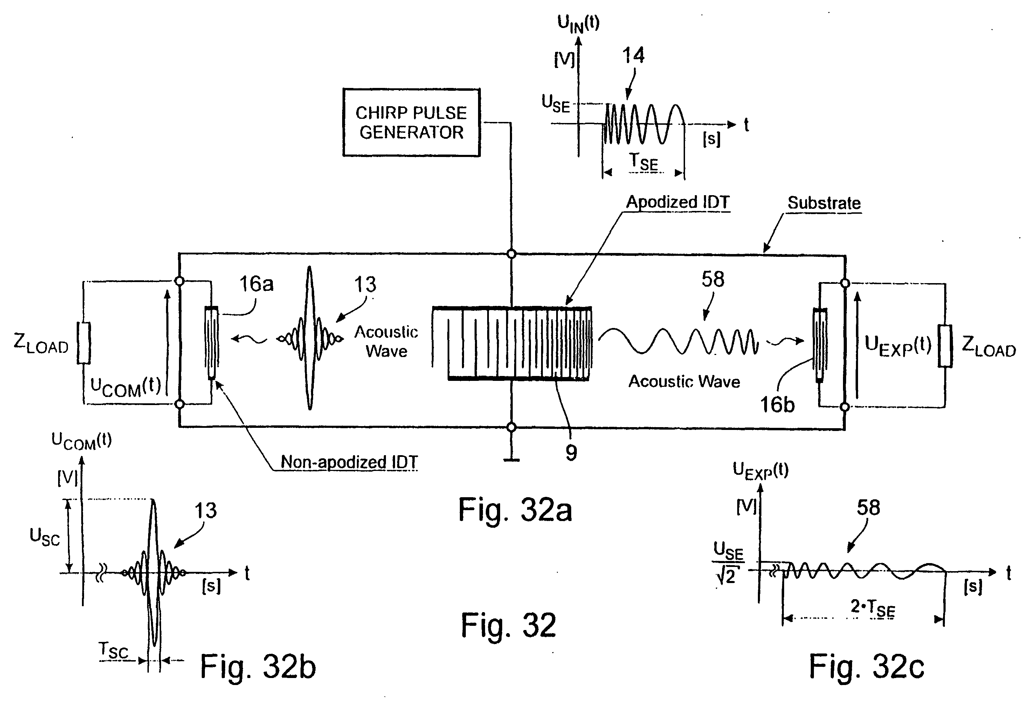

Fig. 32       Darstellung einer SAW-Struktur mit einer komplementären dispersiven Wandlereinrichtung (DDL) zur Erzeugung von komprimierten und expandierten Pulssignalen;

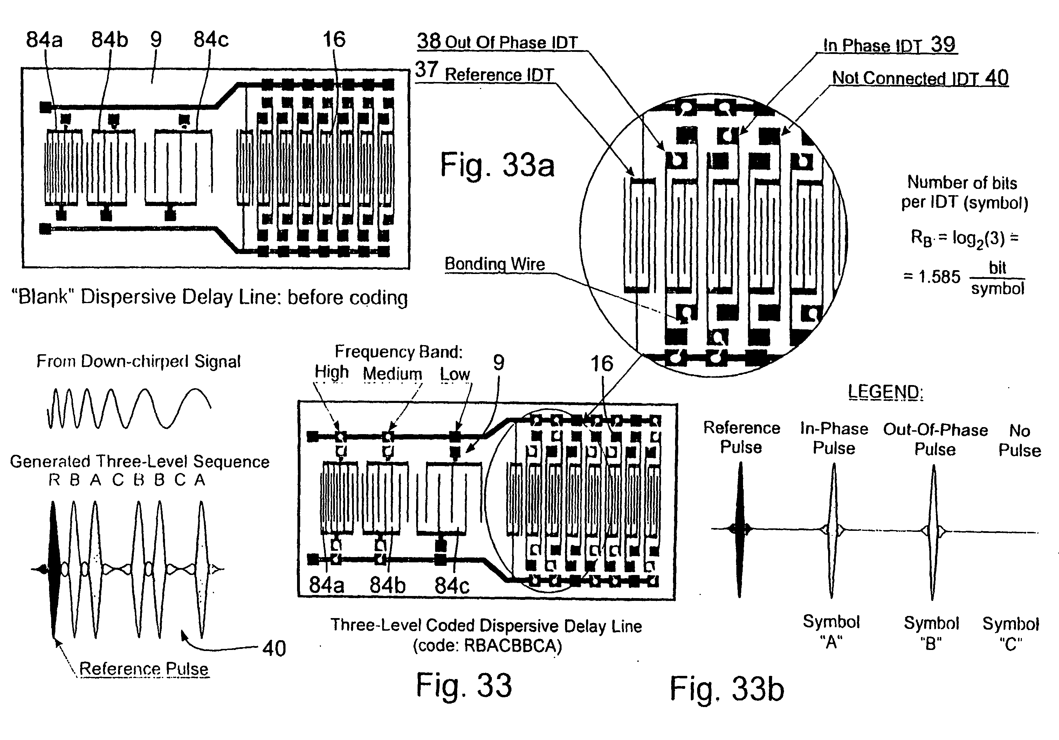

Fig. 33    Darstellung der Struktur einer programmierbaren dispersiven Wandlereinrichtung (DDL);

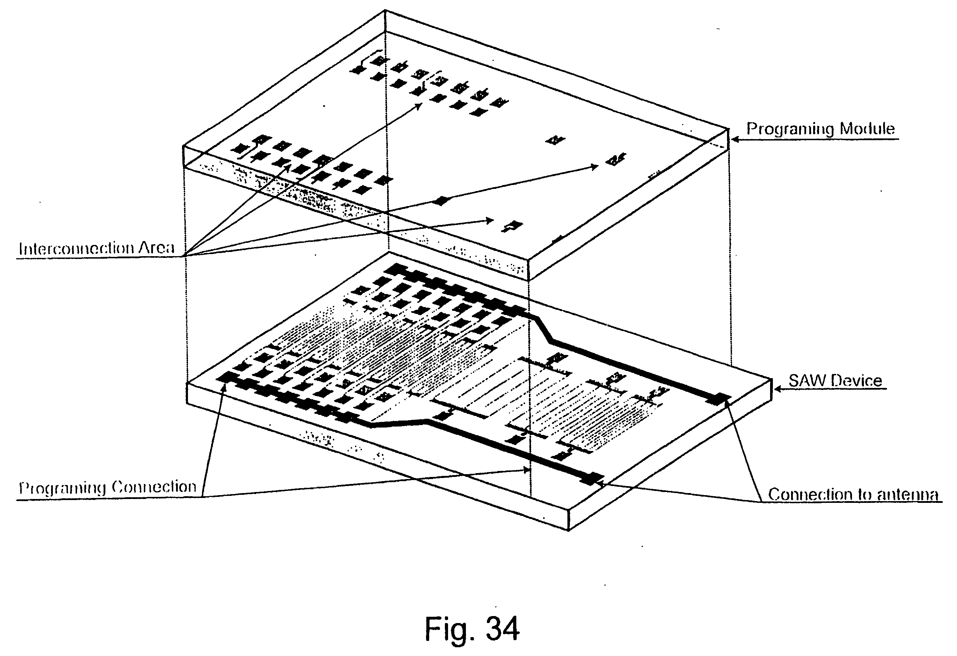

Fig. 34    Darstellung der Verbindung zwischen einer SAW-Struktur und einem Programm-Modul;

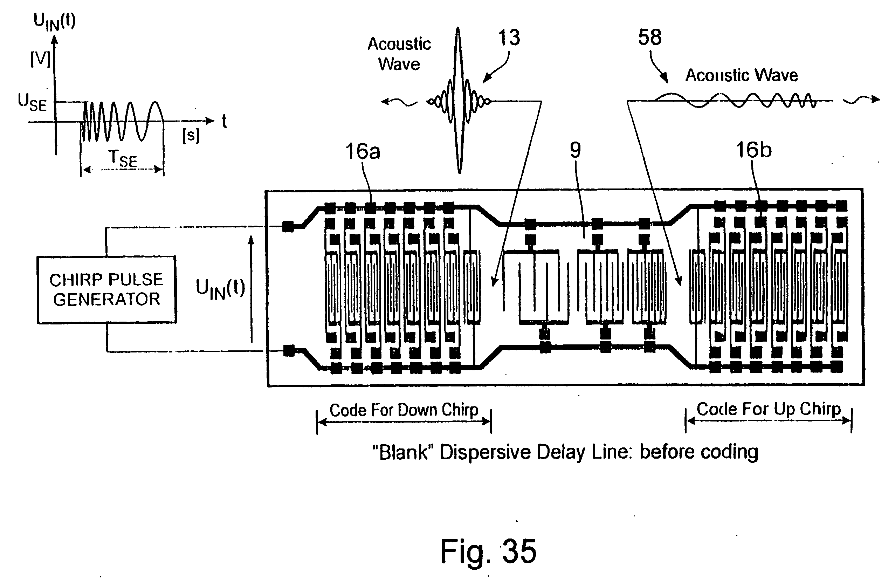

Fig. 35    Darstellung einerprogrammierbaren dispersiven Wandlereinrichtung mit der Erzeugung von zwei unabhängigen Codes (Fall für ein Down-Chirp-Signal);

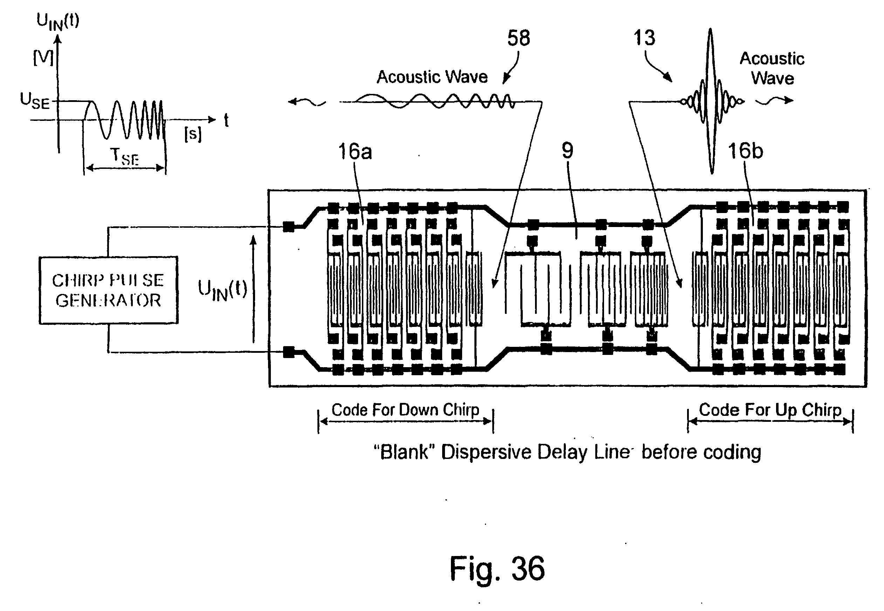

Fig. 36    Darstellung wie in Figur 35 (Fall für ein Up-Chirp-Signal);

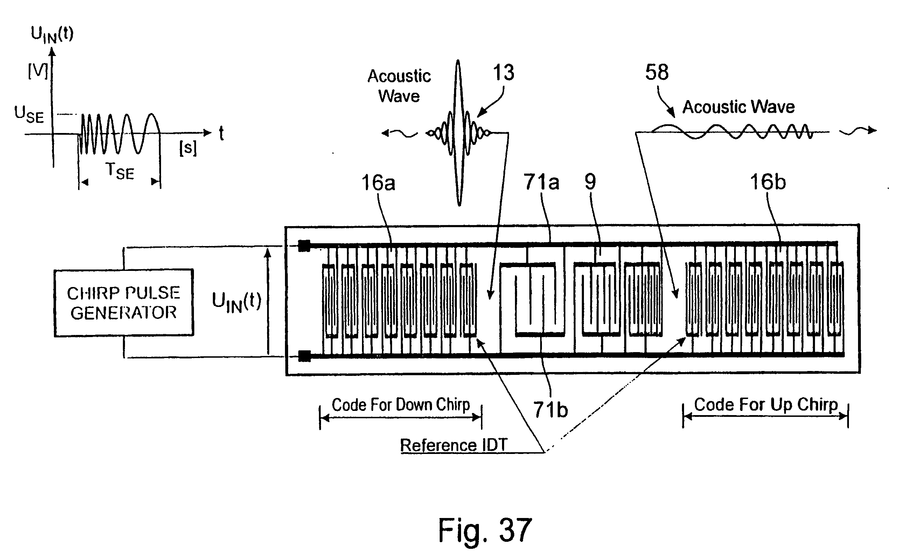

Fig. 37    Darstellung einer SAW-Struktur mit einer programmierbaren dispersiven Wandlereinrichtung und zwei nicht dispersiven Wandlereinrichtungen (Fall für Down-Chirp-Signal);

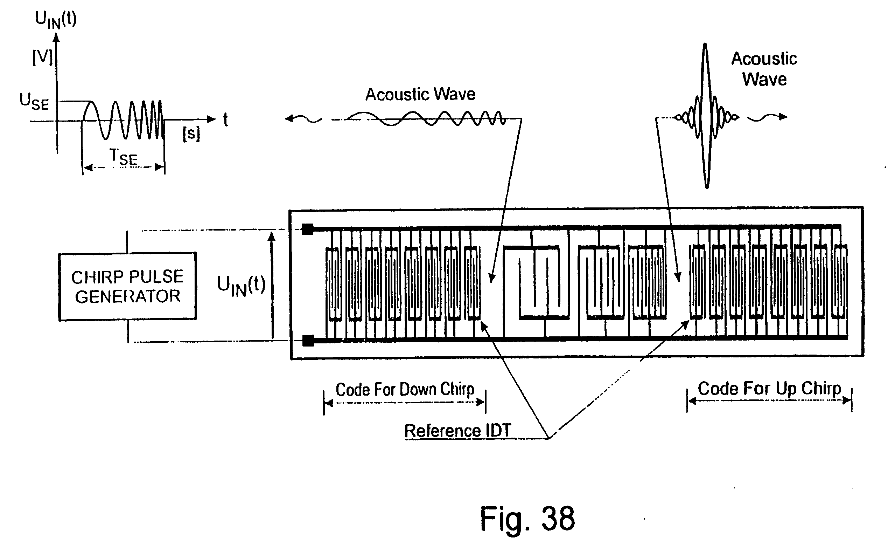

Fig. 38    wie Figur 37 (Fall für Up-Chirp-Signal);

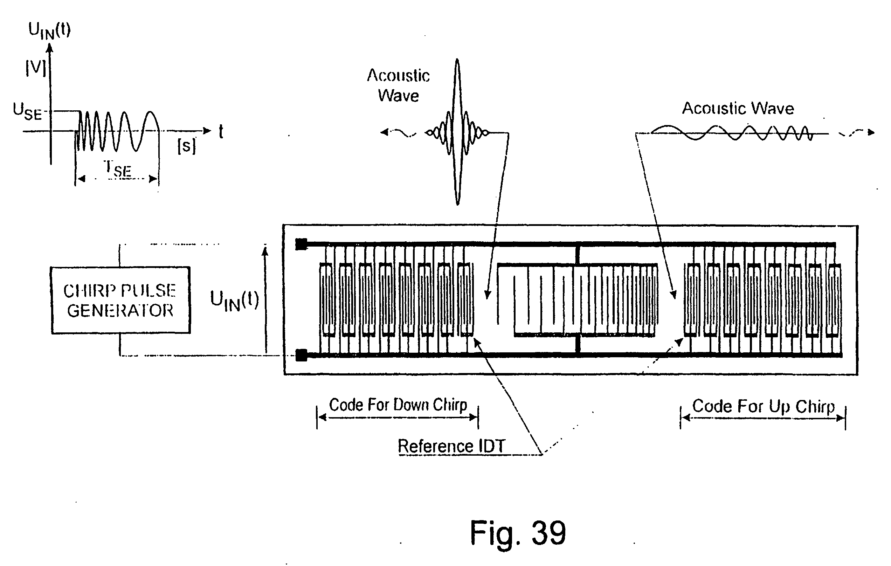

Fig. 39    Darstellung einer dispersiven Wandlereinrichtung zwischen zwei nichtdispersiven Wandlereinrichtungen (Fall für Down-Chirp-Signal);

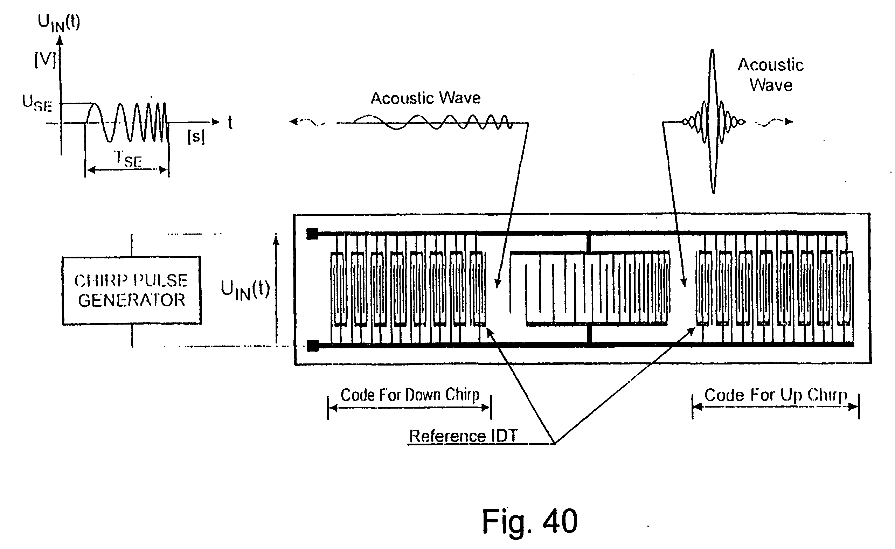

Fig. 40    wie Figur 39 (Fall für Up-Chirp-Signal);

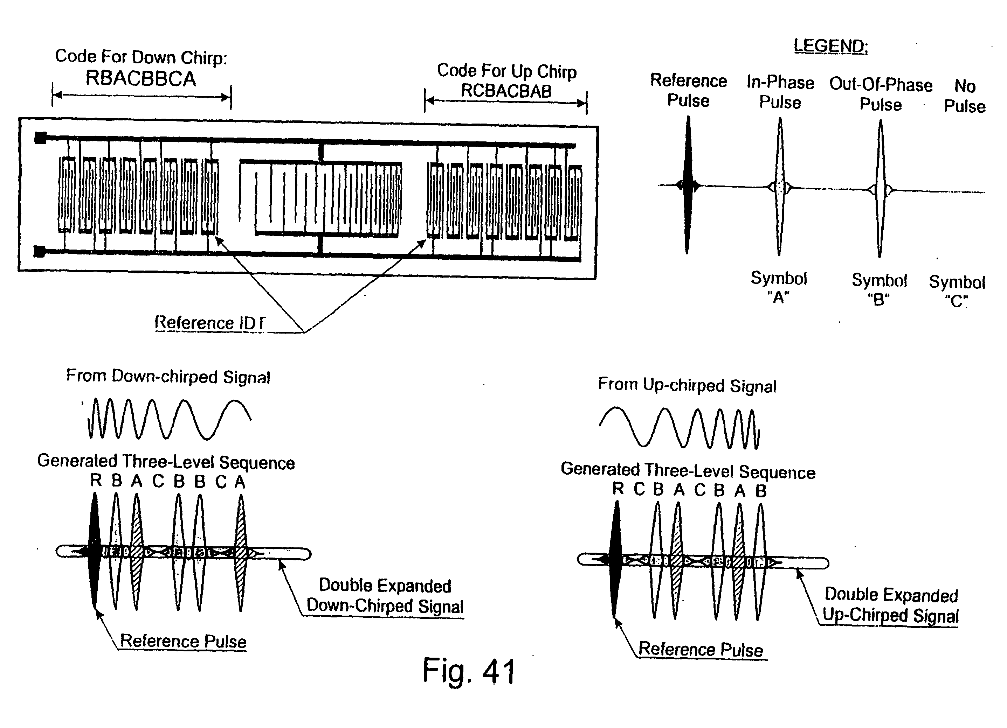

Fig. 41    Darstellung einer programmierten SAW-Struktur mit einer dispersiven Wandlereinrichtung zwischen zwei nichtdispersiven Wandlereinrichtungen;

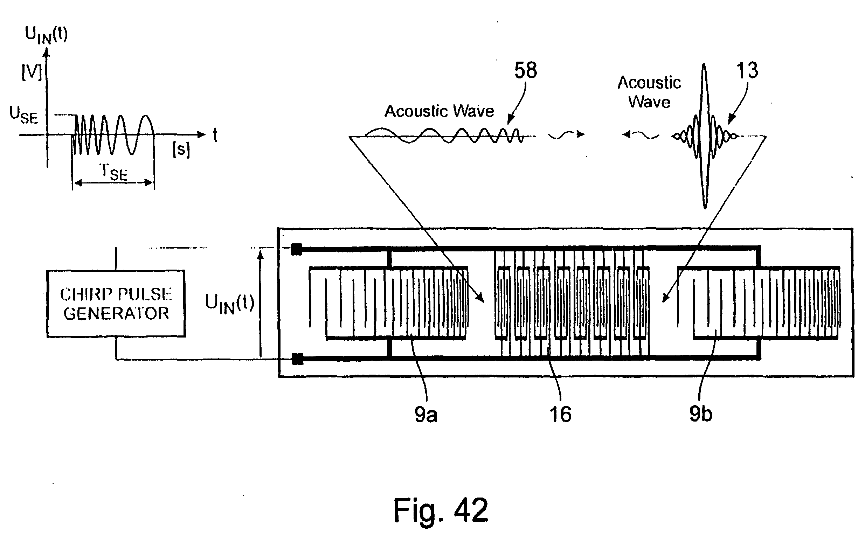

Fig. 42    Darstellung einer SAW-Struktur mitzwei dispersiven Wandlereinrichtungen, die eine nicht dispersive Wandlereinrichtung einschließen (Fall für Down-Chirp-Signal);

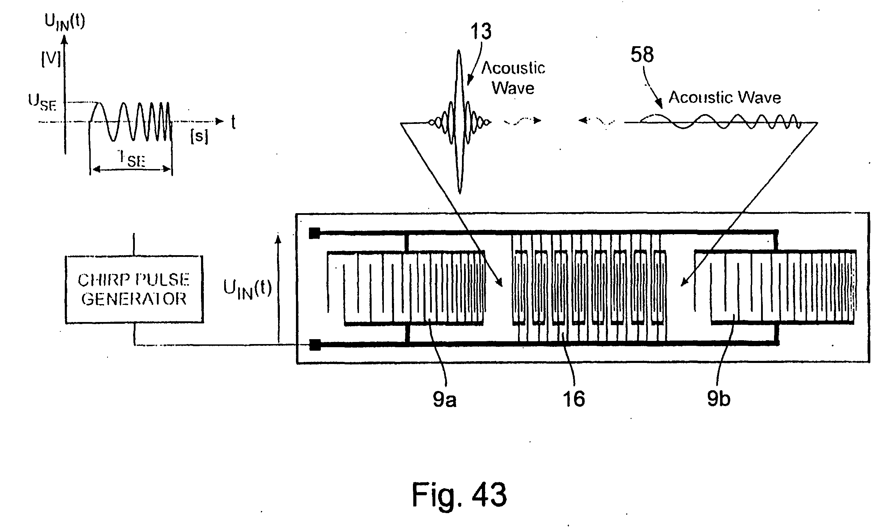

Fig. 43    wie Figur 42 (Fall für Up-Chirp-Signal);

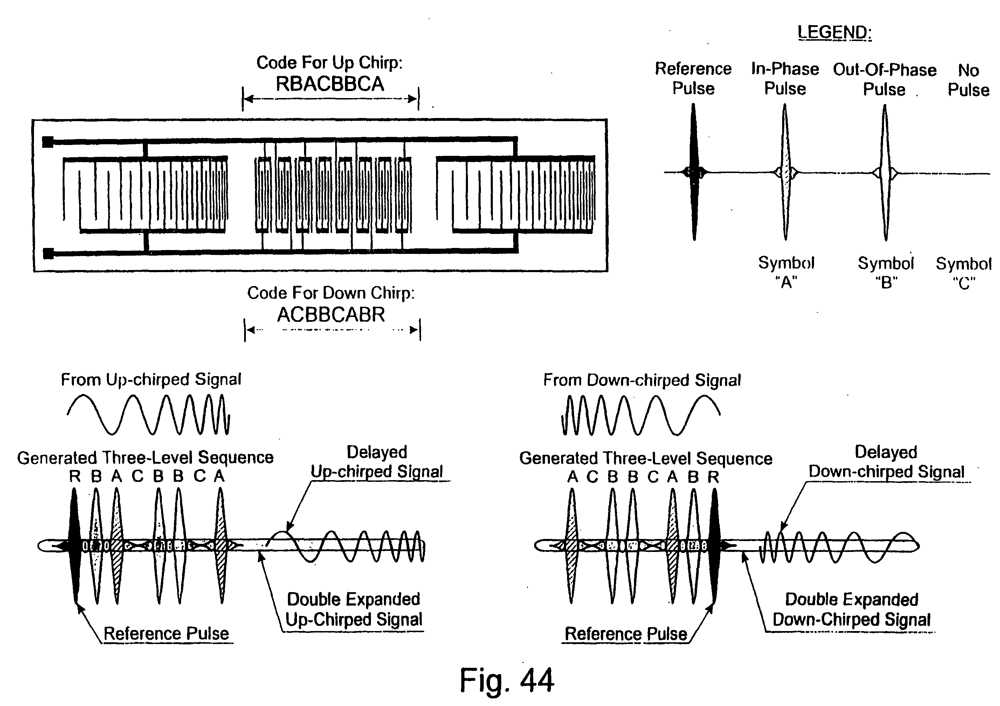

Fig. 44    Darstellung einer SAW-Struktur mit zwei dispersiven Wandlereinrichtungen, die eine nicht dispersive Wandlereinrichtung einschließen und die Signalverläufe bei einer programmierten SAW-Struktur;

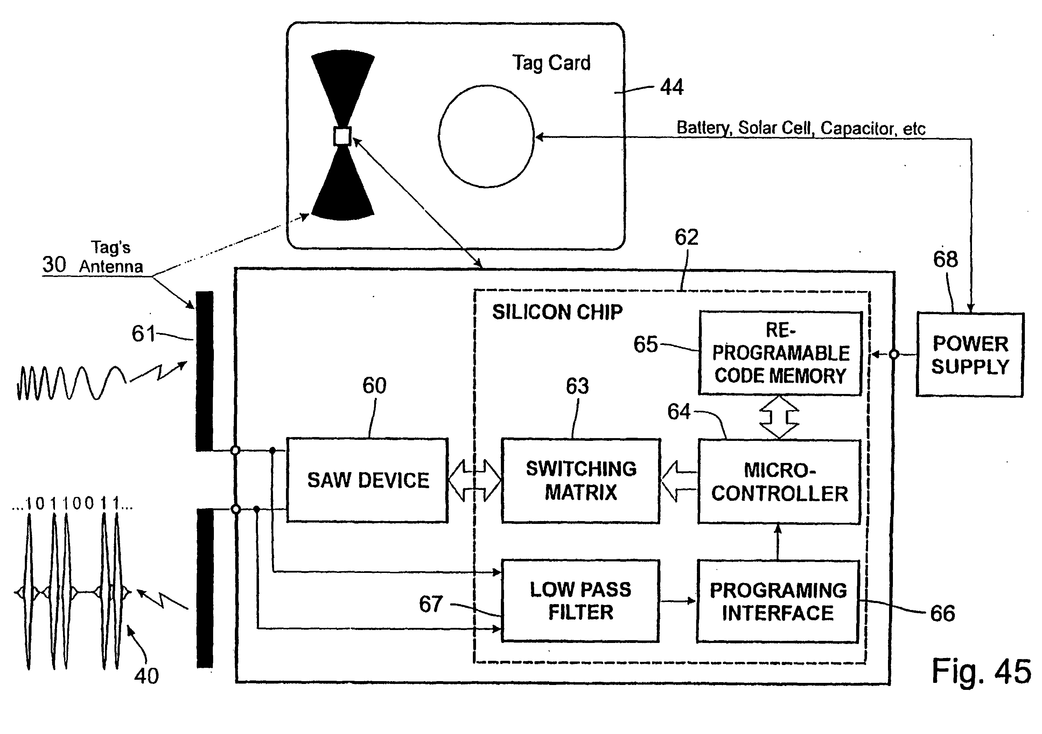

Fig. 45    Blockschaltbild eines wiederprogrammierbaren TAGs;

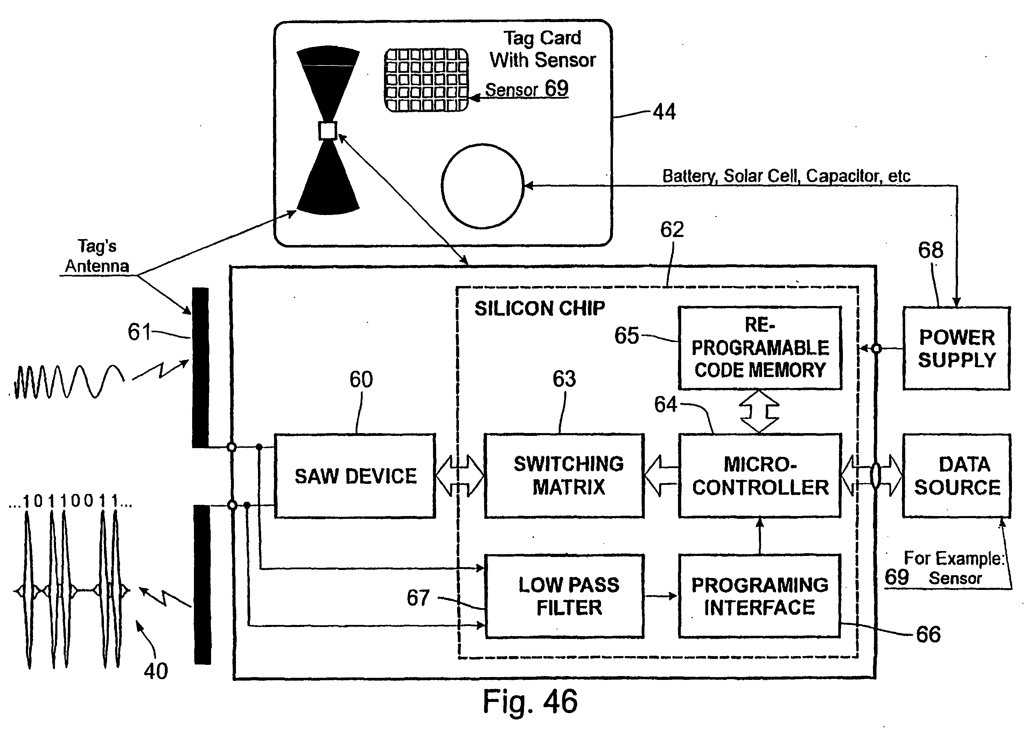

Fig. 46    Darstellung eines wiederprogrammierbaren TAGs bei Anschluß an eine externe Datenquelle;

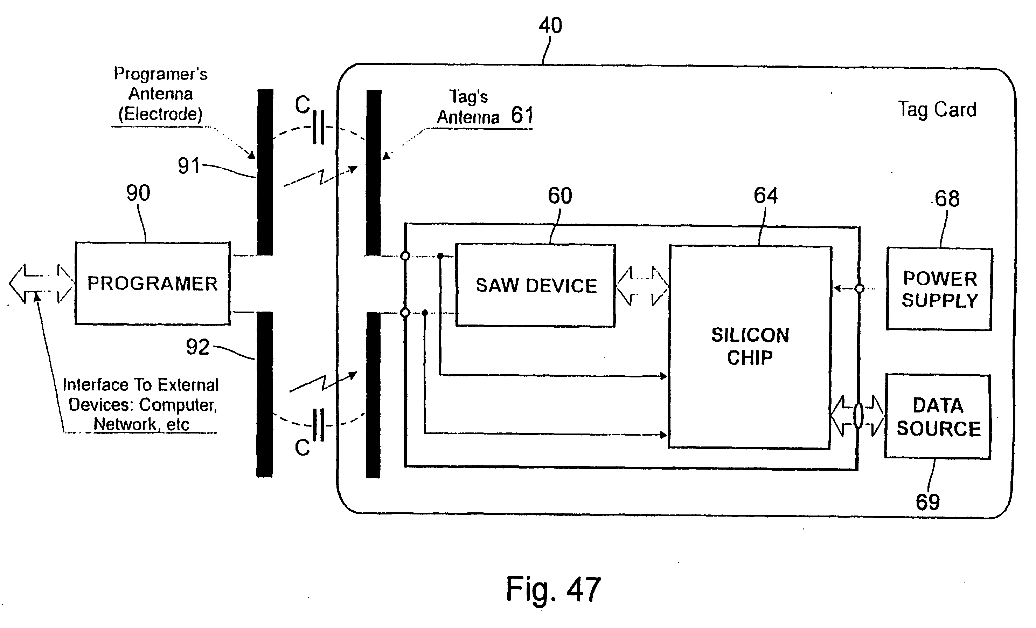

Fig. 47    Blockschaltbild eines wiederprogrammierbaren TAGs mit Programmiereinrichtung;

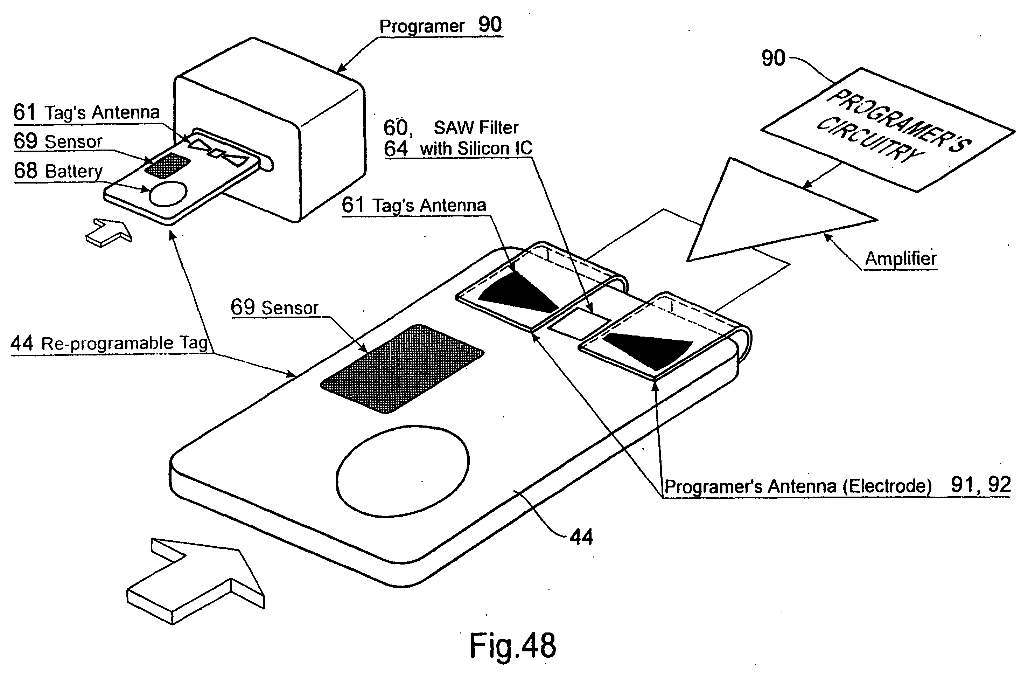

Fig. 48    Darstellung eines wiederprogrammierbaren TAGs und der Prinzipdarstellung für die Programmierung.

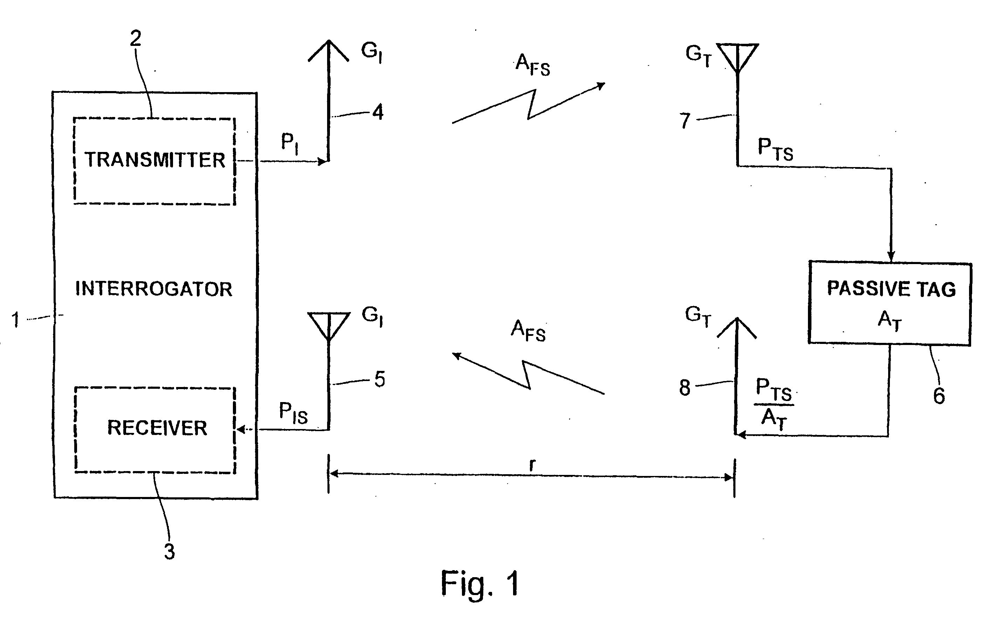

Fig. 1 zeigt in einem Blockschaltdiagramm eine Abfrageeinheit 1 (Interrogator) bestehend aus einer Sendeeinheit 2 und einer Empfangseinheit 3. Der Sendeeinheit 2 ist eine Antenne 4 und der Empfangseinheit 3 ist eine Antenne 5 zugeordnet. Ferner zeigt das Diagramm eine Identifikationseinheit 6 (TAG) (TAG), auch "passive TAG" genannt. Dieses TAG 6 verfügt über eine Empfangsantenne 7 sowie über eine Sendeantenne 8.

Die Antennen 4 und 5 der Abfrageeinheit 1 als auch die Antennen 7 und 8 können einstückig ausgeführt sein, d.h. die Sende- und Empfangsantennen sind in jeweils einer einzigen Antenneneinheit realisiert.

Die Abfrageeinheit 1 generiert ein Signal in der Sendeeinheit 2 und sendet dieses über die Antenne 4. Das von der Antenne 4 ausgesendete Signal wird mittels der TAG-Antenne 7 empfangen und das TAG sendet als Antwort auf das Empfangssignal ein TAG-eigenes (Identifikations-)Signal, welches wiederum von der Empfangseinheit 3 der Abfrageeinheit 1 empfangen wird. Damit eine solche Frage-Antwort-Kommunikation zwischen der Abfrageeinheit 1 und dem TAG 6 stattfinden kann, ist bei limitierter Sendeleistung ein Maximalabstand möglich. Wird dieser Abstand überschritten, gibt es Störungen in der Frage-Antwort-Kommunikation zwischen der Abfrageeinheit und dem TAG.

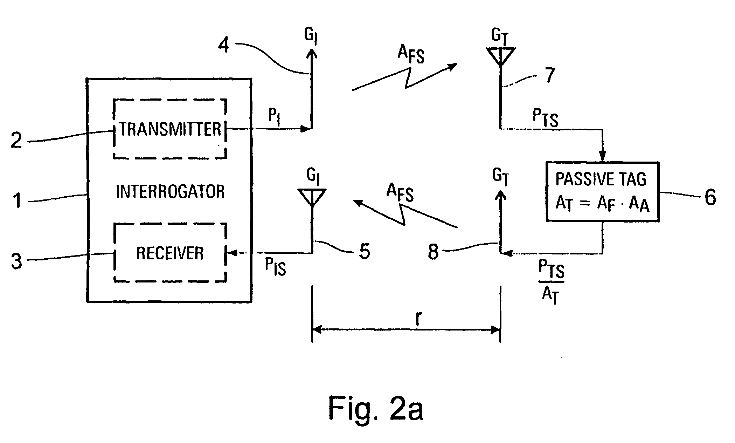

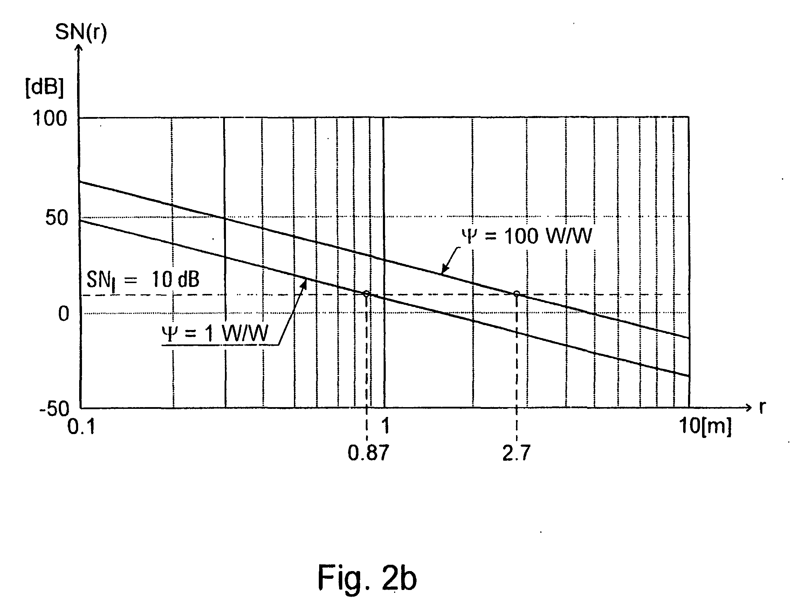

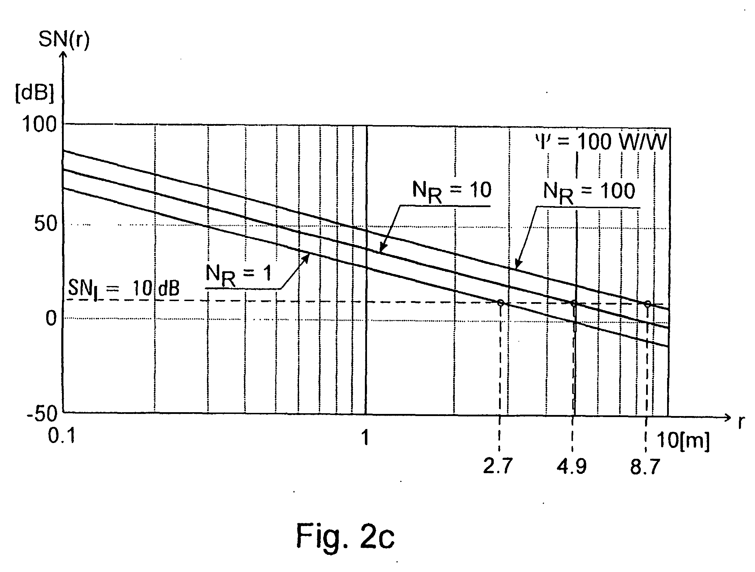

Fig. 2 zeigt in Fig. 2a das bereits in Fig. 1 dargestellte Identifikationssystem. Fig. 2b zeigt den Signalrauschfaktor SN(r) aufgetragen über die Entfernung r zwischen dem TAG und der Abfrageeinheit. Für das Gesamtsystem gelten hierbei z.B. die folgenden Bedingungen:

$A_A$ = 10 W/W (10 dB),
     Total Additional Losses;

gesamte zusätzliche Verluste

$A_F$ = 1000 W/W (30dB),

Insertion losses of the Filter/DDL;

Einfügungsdämpfung des Filters (DDL),

$B_N$ = 100 MHz,

Equivalent System Noise Bandwidth;

Rauschbandbreite

$B_S$ = 80 MHz,

Frequency Bandwidth of the Signal;

Frequenzbandbreite des Chirp-Signals

F = 1 (3dB),

System Noise Figure;

Systemrauschfaktor

$f_c$ = 2.443 GHz,

Carrier frequency;

Trägerfrequenz

$G_I$ 16 W/W (12 dBi),

Antenna Gain of the Interrogator;

Antennengewinn der Abfrageeinheiten

$G_T$ = 1 W/W (0 dBi);

Antenna Gain of the Tag;

Antennengwinn des TAG

$k = 1.38 \cdot 10^{-23}$ J/K;

Boltzmann's Constant;

Boltzmann-Konstante

$P_I$ = 10 mW;

Power of the Interrogator;

Leistung der Abfrageeinheit

$R_O$ = 50 Ω;

Nominal Impedance;

nominale Impedanz

$SN_I$ = 10 W/W (10dB);

Required S/N Ratio for Interrogator's Receiver;

benötigtes S/N-Verhältnis für den Empfänger der Abfrageeinheit

$T_O$ = 297 K (+25°C);

Ambient Temperature;

Umgebungstemperatur

$T_{SE}$ = 1.25 µs;

Expanded Signal Time Duration;

Dauer des gedehnten Signals.

Fig. 2b zeigt den Signal-Rausch-Abstand des Empfängers der Abfrageeinheit bei einem passiven TAG. Hierbei zeigt der Buchstabe Ψ den Dehnungsfaktor für eine dispersive Verzögerungsleitung, gemessen in [W/W]. Bei einem Dehnungsfaktor von Ψ = 1 W/W wird die SNI-Grenze von 10 dB bereits bei 0,87 m erreicht, während bei einem Dehnungsfaktor von Ψ = 100 W/W das Signalrauschverhältnis (SN-Ratio) für den Empfänger der Abfrageeinheit erst bei 2,7 m erreicht wird. Das erfindungsgemäße TAG-Identifikationssystem weist beispielsweise ein Ψ von 100 W/W auf.

Fig. 2c zeigt, wie sich die Abfrageentfernung r (= Entfernung zwischen TAG und Abfrageeinheit) erhöhen läßt, wenn nicht nur mit einer einzigen Abfrage gearbeitet wird, sondern wenn die Zahl $N_R$ der Abfragen innerhalb einer bestimmten Zeiteinheit erhöht wird und wenn die Antwortsignale des TAGs über $N_R$ Abfragen korreliert werden. Die Zahl der Abfragen wird hierbei mit der Variablen $N_R$ angegeben. Bei $N_R$ = 1 beträgt die noch vertretbare Abfrageentfernung wiederum 2,7 m, wie bei der oberen Kurve in Fig. 2b. Wird bei gleichem Dehnungsfaktor Ψ (im Beispiel = 100 W/W) die Anzahl der Abfragen auf beispielsweise $N_R$ = 100 erhöht, dann vergrößert sich die maximale Abfrageentfernung auf 8,7 m.

Fig. 5 zeigt wiederum einen Teil der Fig. 1 (Fig. 5a). Fig. 5b und 5c zeigen die Leistung $P_{TS}(r)$, die von einem TAG in Abhängigkeit der Entfernung r zum Transmitter empfangen wird. In den Figuren 5b und 5c erkennt man deutlich, daß die Leistung $P_{TS}$ bei einer Trägerfrequenz von beispielsweise 2442 MHz deutlich - bezogen auf einen bestimmten Entfernungsort -größer ist, als bei einer Trägerfrequenz von 5800 MHz.

Fig. 6 zeigt in Fig. 6b und 6c die Leistungskurvendarstellung der Signal-Leistung $P_{IS}(r)$, welche in der Abfrageeinheit empfangen wird. Auch hier erkennt man deutlich, daß die Leistung bezogen auf einen bestimmten Empfangsort bei der Trägerfrequenz von beispielsweise 2442 MHz deutlich größer ist als bei einer Trägerfrequenz von 5800 MHz.

Fig. 7 zeigt in Fig. 7a das Blockschaltbild einer dispersiven Wandlereinrichtung 9 (Dispersive Delay-Line DDL). Hierbei wird mittels eines Generators (Gen) mit der Qeullimpedanz $Z_S$ über den Eingangsklemmen der dispersiven Wandlereinrichtung ein Eingangssignal $U_{IN}(t)$ erzeugt. Das Eingangssignal $U_{IN}(t)$ ist hierbei ein Chirp-Signal -Fig. 7b und Fig. 7d -, genauer gesagt, ein Up-Chirped-Signal mit einer Amplitude $U_{SE}$ von 1 V und einer Zeitdauer $T_{SE}$ von einer Mikrosekunde. Die Trägerfrequenz beträgt hierbei 1000 MHz und die Bandbreite des Chirp-Signals beträgt ca. 100 MHz.

Bei dem dargestellten Chirp-Signal handelt es sich um einen linear frequenzmodulierten Impuls der Dauer $T_{SE}$, innerhalb derer sich die Frequenz von einer unteren zu einer oberen Frequenz stetig linear steigend (upchirp) oder fallend (downchirp) ändert. Die Differenz zwischen oberer und unterer Frequenz stellt die Bandbreite $B_S$ des Chirp-Impulses dar. Die gesamte Dauer $T_{SE}$ des Impulses, multipliziert mit der Bandbreite $B_S$ des Impulses, wird als Dehnungs- oder Spreizfaktor $\Psi$ bezeichnet, wobei gilt:

$$\Psi = B_S \times T_{SE}$$

Bei linear frequenzmodulierten impulsen, bei denen die Frequenz innerhalb der Bandbreite $B_S$ sich während der Zeit $T_{SE}$ stetig ändert, ergibt sich der Modulationsindex $\mu$ als Quotient von Bandbreite und Zeit, also

$$\mu = 2^* \, \pi^* \, B_S/T_{SE} \, [1/s^2];$$

demzufolge kann man $\mu$ auch als Frequenzbeschleunigung auffassen.

Ist t[s] die Zeit, wobei $t = t_0 = 0$ die zeitliche Mitte eines Chirp-Impulses darstellen soll, $T_{SE}$[s] die Dauer des linear modulierten Impulses, $\omega_0$[rad/s] die Mittenkreisfrequenz zur Zeit $t_0$, $\Delta\omega$[rad/s] die Abweichung der Kreisfrequenz; $\mu$[rad/s$^2$] die Frequenzbeschleunigung und $U_{SE}$[V] die Amplitude des frequenzmodulierten Impulses, dann lassen sich die beiden linear frequenzmodulierten Impulse upchirp(+) und downchirp(-) wie folgt definieren:

$$U_{in}(t) = U_{SE} \cdot COS\left(\omega_0 \cdot t \pm \frac{\mu \cdot t^2}{2}\right), \qquad \text{für} \quad |t| \leq \frac{T_{SE}}{2}$$

$$U_{in}(t) = 0, \qquad \text{für } |t| > \frac{T_{SE}}{2}$$

Wird ein derartiges Signal auf eine entsprechend dimensionierte, dispersive Verzögerungsleitung (DDL) gegeben, deren Phasengang parabelförmig und deren Gruppenlaufzeitverhalten linear ist, dann entsteht als Ausgangssignal $U_{OUT}(t)$ ein komprimiertes Signal der Form:

$$U_{OUT}(t) = U_{SE} \cdot \sqrt{\frac{2}{\pi \cdot \mu}} \cdot \frac{\sin(\pi \cdot B_S \cdot t)}{t} \cdot \cos(\omega_o t)$$

oder alternativ:

$$U_{OUT}(t) = U_O \cdot \sqrt{B_S \cdot T} \cdot \frac{\sin(\pi \cdot B_S \cdot t)}{\pi \cdot B_S \cdot t} \cdot \cos(\omega_o t).$$

Während das Signal $U_{IN}(t)$ in Fig. 7b schematisch dargestellt ist, ist der Signalverlauf des Ausgangssignals $U_{OUT}(t)$ in Fig. 7c (ebenfalls schematisch) aufgezeichnet. Hierbei bezeichnet $T_{SC}$ den zeitlichen Abstand der beiden Nullstellen des Hauptmaximums von $U_{OUT}(t)$. $T_{SC}$ bestimmt sich zu:

$$T_{SC} = 2 / B_S$$

Fig. 7d zeigt in einer etwas anderen Darstellung das Chirp-Signal nach Fig. 7b. Das Chirp-Signal hat eine zeitliche Länge von einer Microsekunde bei einer Signalamplitude von 1V.

Fig. 7e zeigt das Ausgangs-Puls-Signal der DDL 9 (Fig. 7a) und zeigt das gleiche Ausgangs-Puls-Signal der DDL zeitlich gedehnt (Horizontal Zoom).

Fig. 9a und 9b zeigen das Verhalten des Signalrauschfaktors SN(r), bezogen auf die Entfernung r zwischen dem TAG und der Abfrageeinheit, in Abhängigkeit von unterschiedlichen Dehnungsfaktoren $\psi$ und unterschiedlichen Abfragezyklen $N_R$.

Fig. 10 zeigt beispielhaft ein Oberflächenwellensubstrat, auf dem zur Erzeugung eines Oberflächenwellen-Chirp-Signals eine dispersive Verzögerungsleitung (DDL) in Form eines gewichteten Interdigitalwandlers (IDT) angeordnet ist.

Das Signal zur Anregung des dispersiven Wandlers wird folgendermaßen erzeugt: Das sinx/x - förmige Signal des Generators 10 und das im Trägerfrequenzgenerator 11 erzeugte Trägerfrequenzsignal werden den Eingängen eines Vierquadrantenmultiplizierers 12 zugeführt. Am Ausgang des Multiplizierers 12 entsteht das bereits vorbeschriebene Puls-Signal 13.

Wird dieses Pulssignal 13 auf den dispersiven Wandler 9 gegeben, dann entstehen zwei Oberflächenwellen 14, 15, die sich auf dem Substrat in entgegengesetzter Richtung ausbreiten. Beide Oberflächenwellen haben eine zueinander komplementäre Chirp-Charakteristik. Im Bild dargestellt ist eine erste Oberflächenwelle 14 mit upchirp-Charakteristik auf der linken Seite und eine zweite Oberflächenwelle 15 mit downchirp-Charakteristik auf der rechten Seite des dispersiven Wandlers.

Wenn die Oberflächenwellen 14 bzw. 15 die nichtdispersiven Wandler 16a bzw. 16b erreichen, dann entstehen an den Klemmen dieser Wandler wieder elektrische Signale mit upchirp-Charakteristik $U_{UP}(t)$ über dem Wandler 16a bzw. mit downchirp-Charakteristik $U_{DOWN}(t)$ über dem Wandler 16b. Der zeitliche Verlauf dieser beiden Signale ist in Fig. 10b bzw. 10c dargestellt.

Fig. 11 a zeigt eine OFW-Wandleranordnung, bei der ein Chirp-Signal $U_{IN}(T)$ 18 zunächst auf einen nichtdispersiven Wandler 16 gegeben wird. Dieser erzeugt dann eine entsprechende "gechirpte" akustische Welle, die in einem dispersiven Wandler 9 empfangen wird, so daß ausgangsseitig wiederum das bereits beschriebene und bekannte zeitkomprimierte Pulssignal $U_{OUT}(T)$ nach Fig. 11 c erzeugt wird. Die Signalfunktionen des Eingangssignals und des Ausgangssignals sind in den Teilfiguren 11b und 11c dargestellt.

Das gleiche Ergebnis erhält man, wenn das chirpförmige Eingangssignal $U_{IN}(t)$ an den dispersiven Wandler 9 gelegt wird und das Ausgangssignal $U_{OUT}(t)$ über dem nichtdispersiven Wandler 16 abgegriffen wird. Dieser Zusammenhang ist in Fig. 12 dargestellt.

Fig. 13a zeigt eine ähnliche Anordnung wie Fig. 12, hier jedoch sind auf der dem dispersiven Wandler 9 gegenüberliegenden Seite des Substrats zwei nichtdispersive Wandler 16 hintereinander, d.h. räumlich gestaffelt, angeordnet. Bei Anregung des dispersiven Wandlers mit einem Chirp-Signal $U_{IN}(t)$ - Fig. 13b - entstehen ausgangsseitig zwei komprimierte Pulssignale $U_{OUT1}(t)$, $U_{OUT2}(t)$ gleichen Signalverlaufs - Fig. 13c -, die aber wegen der Laufzeit der akustischen Welle auf dem Substrat um den Abstand $\Delta T_{21}$ gegeneinander zeitversetzt sind.

Um die Auswertung des Antwortsignals zu erleichtern, sollte der Zeitversatz $\Delta T_{21}$ mindestens gleich $T_{SC}$ sein, vorzugsweise ist der Zeitversatz $\Delta T_{21}$ jedoch etwa drei bis zehnmal so groß wie der Abstand der Nullstellen des Hauptmaximums von $U_{OUT1}(t)$ bzw. $U_{OUT2}(t)$. Der Zeitversatz zwischen den beiden gepulsten Ausgangssignalen wird benötigt, damit die Abfrageeinheit beim Empfang dieser Signale diese jeweils sicher detektieren und untersuchen kann.

Fig. 14 zeigt in der Darstellung nach Fig. 14a eine OFW-Wandler-Einrichtung mit einem dispersiven Wandler 9 und einer nichtdispersiven Wandlereinrichtung 20 bestehend aus acht nichtdispersiven Wandlern 16. In ihrer Realisierung auf dem OFW-Substrat sind dispersive und nichtdispersive Wandler vergleichbar. Beide weisen eine "positive" Elektrode 21 bzw. 22 und eine negative Elektrode 23 bzw. 24 auf. Die Elektroden weisen mit den freien Leitungsenden 25 (Fingern) zueinander und die freien Leitungsenden 25 sind ineinander verschränkt, ohne sich jedoch zu berühren. Die positiven Elektroden der nichtdispersiven Wandler 16 sind in Fig. 14a über eine gemeinsame Busleitung - nachfolgend positive Busleitung genannt - 26 verbunden. Die negativen Elektroden 23 der nichtdispersiven Wandler 16 sind in Fig. 14a über eine negative Busleitung 27 miteinander verbunden. Wie in Fig. 14a zu sehen ist, sind dispersive Wandler 9 und nichtdispersive Wandlereinrichtung 20 elektrisch voneinander getrennt, und ihre Kopplung besteht lediglich in der akustischen Oberflächen-Wellenkopplung. In Fig. 14a sind alle nichtdispersiven Wandler in der gleichen Weise an die jeweiligen positiven und negativen Busleitungen angeschlossen. Dies bedeutet, daß sie bei Anregung mit einem OFW-Pulssignal, generiert vom dispersiven Wandler 9, mit einer Pulsfolge reagieren würden, wobei jeder Puls gegenüber dem vorherigen zeitlich versetzt ist, jedoch die gleiche Gestalt hat. Dies kommt einer Codierung bzw. Programmierung von acht logischen Einsen "11111111" gleich.

Fig. 14b zeigt die Anordnung nach Fig. 14a, nunmehr jedoch mit einer codierten/programmierten nichtdispersiven Wandleranordnung. Die Codierung/Programmierung besteht hierbei im konkreten Beispiel darin, daß die Verbindungsleitung zwischen den Elektroden und den Busleitungen des zweiten, fünften und sechsten Wandlers entfernt bzw. unterbrochen sind. Bei einer Anregung mit einem OFW Pulssignal - generiert vom dispersiven Wandler 9 - können diese Wandler mithin kein elektrisches Signal in die Busleitung abgeben, so daß sich eine Pulsfolge ergibt, die einem Code "10110011" entspricht. Die Entfernung bzw. die Unterbrechung von bestehenden Elektroden-Busleitungs-Verbindungen ist eine erste, bevorzugte Programmierungsart. Die Entfernung bzw. Unterbrechung von Verbindungsleitungen zwischen den positiven und negativen Elektroden kann durch jedwede Technologie, vorteilhafterweise durch ein Laserschneiden (Laser Cutting) oder Ätzen erfolgen.

Fig. 15 zeigt eine weitere Ausgestaltung der bereits in Fig. 14b dargestellten Oberflächen-Wellen-Wandler-Einrichtung, bei der die positive Elektrode 22 des dispersiven Wandlers 9 elektrisch von der positiven Busleitung 26 getrennt. Gleiches gilt auch für die negative Elektrode 24 des dispersiven Wandlers und die negative Busleitung 27 des nichtdispersiven Wandlers. Wie in Fig. 15 zu sehen, ist sowohl dem Elektrodenpaar des dispersiven Wandlers als auch den Busleitungen der nichtdispersiven Wandlereinrichtung jeweils eine Antenne (30 bzw. 33) zugeordnet. Die Antenne 33 besteht aus zwei Teilen 31 und 32, wobei der erste Teil 31 mit der positiven Elektrode und der zweite Teil 32 mit der negativen Elektrode des dispersiven Wandlers 9 verbunden ist.

Bei der Anregung dergezeigten Oberflächen-Wellen-Wandler-Einrichtung mit einem eingangsseitigen Chirp-Signal 14 reagiert die Wandlereinrichtung wie bereits beschrieben ausgangsseitig mit einer Pulsfolge in der logischen Bedeutung "10110011". Dieserbeispielhafte Kennzeichencode wurde bereits anhand von Fig. 14 beschrieben. Man erkennt, daß an den Stellen, an denen der zweite, fünfte und sechste Wandler der Wandlereinrichtung 16 nicht mit den positiven und negativen Busleitungen verbunden ist, auch kein Impuls erzeugt wird, was sich in dem Interrogator leicht lesen, feststellen und auswerten läßt. Man erkennt auch, daß das Ausgangssignal ein Signal mit zwei logischen Zuständen ist, nämlich den Zuständen "Impuls", gleichbedeutend mit logisch "1" und dem Zustand "kein Impuls" gleichbedeutend mit dem logischen Zustand "0". In Fig. 15 ist oben beispielhaft eine Identifikations"TAG-CARD" gezeigt, auf der die OFW-Wandler-Einrichtung angeordnet ist und auf der zu sehen ist, daß die beiden Antennenanordnungen - Empfangsantenne 30, Sendeantenne 33 - gekreuzt auf der Karte angeordnet sind.

Fig. 16 zeigt in Fig. 16c eine Oberflächen-Wellen-Wandler-Einrichtung, bei der die positive Elektrode des dispersiven Wandlers 9 mit der positiven Elektrode des nichtdispersiven Wandlers 16 und die negative Elektrode des dispersiven Wandlers 9 mit der negativen Elektrode des nichtdispersiven Wandlers 16 verbunden sind.

Ein vom Impulsgenerator abgegebenes Chirp-Signal liegtdann gleichzeitig über dem dispersiven Wandler 9 wie über dem nichtdispersiven Wandler 16 an. Dabei komprimiert der dispersive Wandler 9 das Chirp-Signal und erzeugt eine erste pulsförmige Oberflächenwelle in Richtung -siehe auch Fig. 16a-des nichtdispersiven Wandlers, während gleichzeitig der nichtdispersive Transducer eine entgegengesetzt gerichtete zweite Oberflächenwelle erzeugt, die sich in Richtung - siehe auch Fig. 16b - des dispersiven Wandlers ausbreitet. Diese zweite Oberflächenwelle weist eine dem empfangenen Signal entsprechende, chirpförmige Charakteristik auf.

Die erste pulsförmige OFW wird beim Eintreffen am nichtdispersiven Wandler auch in ein pulsförmiges elektrisches Signal umgewandelt, während die zweite chirpförmige OFW beim Eintreffen am dispersiven Transducer komprimiert und in ein ebenfalls pulsförmiges elektrisches Signal verwandelt wird, das zeitgleich und phasengenau mit dem elektrischen Pulssignal des nichtdispersiven Wandlers auf den Busleitungen der Elelektroden auftritt. Fig. 16 stellt also symbolisch den Nachweis dar, wonach die Anordnung nach 16a und nach 16b superponiert werden können, um 16e zu erhalten.

Da das Anregungssignal und das Antwortsignal der Anordnung zeitversetzt auftreten, sich beide Signale also nicht gegenseitig beeinflussen können, erlaubt es diese Anordnung, nicht nur gemeinsame Busleitungen sondern auch eine gemeinsame Antenne zu verwenden, die gleichzeitig Empfangs- und Sendeantenne des TAGs ist.

Fig. 17 zeigt beispielhaft die Struktur einer TAG-Karte mit der in Fig. 16c vorgestellten Anordnung, bei der die Elektroden des dispersiven Wandlers mit den gemeinsamen Busleitungen 71 der nichtdispersiven Wandler verbunden sind. Die gezeigte Wandlereinrichtung reagiert auf ein elektromagnetisches Chirp-Signal 14 als Eingangssignal mit einer Pulsfolge 40, die die logische Bedeutung einer Binärfolge von " 10110011" hat. Es versteht sich von selbst, daß die Zahl n der nichtdispersiven Wandler 16 sich leicht erhöhen läßt, beispielsweise auf mehr als 30 und daß sich hieraus eine Vielzahl von Programmierungsmöglichkeiten, nämlich mehr als $2^{30}$ ergeben.

Fig. 18 zeigt eine weitere alternative Ausführungsform der Erfindung. Fig. 18a zeigt die bekannte Struktur einer erfindungsgemäßen Wandleranordnung mit einem dispersiven Wandler 9 und n = 8 nichtdispersiven Wandlern 16. Nunmehr sind jedoch die zweiten bis achten nichtdispersiven Wandler sowohl mit ihrer positiven als auch mit ihrer negativen Elektrode gleichzeitig an die negative und positive Busleitung angeschlossen. Nur der erste, der dem dispersiven Wandler nächstliegende nichtdispersive Wandler 37 ist mit seiner positiven Elektrode an die positive Busleitung und mit seiner negativen Elektrode an die negative Busleitung angeschlossen. Dieses erste Wandlerglied 37 dient - wie noch später ausgeführt wird - als Referenzelement für die anderen nichtdispersiven Wandler. Fig. 18b zeigt die Struktur aus Fig. 18a, nunmehr jedoch mit einer codierten/programmierten nichtdispersiven Wandleranordnung. Hierbei ist zu sehen, daß beispielsweise der zweite Wandler 38, welcher zum Referenzelement 37 am nächsten liegt,

## EP 1 163 632 B1

mit seiner negativen Elektrode nur an der positiven Busleitung und mit seiner positiven Elektrode nur an der negativen Busleitung angeschlossen ist. Alle anderen ursprünglich vorhandenen Verbindungen zu einer Busleitung werden durch die Codierung getrennt. Gleiches gilt auch für die fünften und sechsten Wandler. Die dritten, vierten, fünften und sechsten Wandler der nichtdispersiven Wandleranordnung sind normal, also mit der positiven Elektrode an der positiven Busleitung und der negativen Elektrode an der negativen Busleitung angeschlossen. Wird nunmehr ein TAG mit einer wie in Fig. 18b dargestellten Wandlerstruktur mit einem Chirp-Signal, beispielsweise einem Down-Chirp-Signal angeregt, so antwortet das TAG-System mit einer Pulsfolge, bestehend aus 8 Pulsen. Der erste Puls - siehe Fig. 18c - ist der Referenzimpuls, erzeugt vom Referenzelement 37. Alle weiteren Pulse, die von nichtdispersiven Wandlerelementen herrühren, die genauso zur positiven und negativen Busleitung geschaltet sind wie das Referenzglied, liegen in Phase mit dem Referenzimpuls. Die zweiten, fünften und sechsten nichtdispersiven Wandlerelemente jedoch erzeugen aufgrund ihrer umgekehrten Schaltung zur positiven und negativen Busleitung Pulssignale, welche nicht zum Referenzimpuls nicht in Phase liegen. Fig. 18d zeigt diesen Zusammenhang, wobei ein Puls, welcher "in Phase" liegt mit dem Referenzimpuls als "Bit 1" interpretiert wird, und ein Puls, welcher "Out of Phase" zum Referenzimpuls liegt, als "Bit 0" interpretiert wird.

Fig. 18e zeigt noch einmal in der Vergrößerung die Strukturanordnung der positiven und negativen Elektroden zu den positiven und negativen Busleitungen bei dem Referenzelement 37, einem "Out of Phase"-Wandler 38 und einem "In Phase"-Wandler 39. Aus Platzspargründen ist in Fig. 18b die zugehörige Antenne 30 mit ihrem Teil 31 und 32 nicht eingezeichnet.

Fig. 19 zeigt in einer weiteren vorteilhaften Ausführungsform eine "Quasi"-Zusammenschaltung der Strukturen, wie sie bereits anhand der Fig. 17 und 18 beschrieben wurden. Fig. 19a zeigt wiederum die OFW-Wandler-Einrichtung im "uncodierten/unprogrammierten" Zustand, bei dem also die positiven und negativen Elektroden der nichtdispersiven Wandler jeweils an der positiven und negativen Busleitungen angeschlossen sind. Fig. 19b zeigt eine Codierung, bei der nunmehr einzelne, nichtdispersive Wandleranordnungen entweder "in Phase" an die Busleitung angeschlossen sind, oder "Out of Phase" an die Busleitung angeschlossen sind oder gar nicht an die Busleitung angeschlossen sind. Dies ist in Fig. 19c noch einmal in der Vergrößerung dargestellt. Von links nach rechts sieht man hier wiederum das Referenzglied 37, den "Out of Phase"-Wandler 38, den "in Phase"-Wandler 39, sowie den nicht verbundenen Wandler 40. Fig. 19d zeigt in der Legende die Interpretation der Pulssignale, welche von den verschiedenen Wandlern erzeugt werden. Wandler 37 erzeugt wieder das Referenzpulssignal, Wandler 38 ein Pulssignal, das sich außerhalb der Phase (out of phase) befindet mit dem Referenzpulssignal, Wandler 39 ein Signal, das sich in Phase mit dem Referenzpulssignal befindet und Wandler 40 erzeugt kein Pulssignal, weil es nicht an die Busleitungen angeschlossen ist. Bei Anregung der Wandlereinrichtung mit einem Chirp-Signal stellt also der dispersive Wandler wiederum ein Pulssignal zur Verfügung, auf welches die nichtdispersive Wandleranordnung 16 mit der Pulsfolge 41 antwortet. Da das Ausgangssignal wenigstens drei logische Zustände aufweisen kann, ist auch die Codierkapazität bzw. Programmkapazität entsprechend hoch, denn während bei einem System mit zwei möglichen Zuständen und (wie im Beispiel) acht Wandlern inclusive eines Referenzwandlers die maximale Code-Kapazität $2^{(8-1)} = 128$ beträgt, sind nunmehr $3^{(8-1)} = 2187$ verschiedene Möglichkeiten gegeben, was eine weitere Steigerung der Effizienz ermöglicht und gegenüber der in Fig. 18 dargestellten Lösung eine Kapazitätssteigerung um den Faktor 17, also um 1700%, zur Folge hat.

Fig. 20 zeigt eine Wandleranordnung, welche von der Signalverarbeitung identisch ist wie die in Fig. 19 gezeigte Oberflächen-Wellen-Wandler-Einrichtung. Jedoch sind hier im Ausgangspunkt vor der Programmierung/Codierung die zweiten bis achten (also n-1) nichtdispersiven Wandler weder mit der positiven noch mit der negativen Busleitung verbunden. Jede Elektrode der einzelnen nichtdispersiven Wandler weist zwei Anschlußpunkte 73a, 73b auf, wobei ein Anschlußpunkt 73a der positiven 71 a und ein Anschlußpunkt 73b der negativen Busleitung 71 b zugeordnet bzw. hierzu benachbart angeordnet ist. Die gleiche Programmierung wie bei der in Fig. 19 gezeigten Lösung wird nunmehr durch das entsprechende Verbinden 72 der Anschlußelektroden mit den jeweils gewünschten Busleitungen hergestellt. Diese Verbindung kann vorteilhafterweise auch durch Bonding, wie es aus der Chip-Verarbeitung zum Anschluß von Siliziumchips bekannt ist, durchgeführt werden. Fig. 20b und 20c zeigen die gebondeten Verbindungen 72 der jeweiligen Elektrodenanschlüsse an die Busleitungsanschlüsse. Es liegt auf der Hand, daß mit einem Bonding jede gewünschte Programmierung sehr leicht durchgeführt werden kann und daß hierbei besonders vorteilhaft ist, daß die Grundstruktur der Wandlereinrichtung - s. Fig. 20a - stets gleichbleibend ist. Dies ermöglicht eine kostengünstige Herstellung.

Fig. 21 zeigt eine zu Fig. 20 alternative Möglichkeit der Verbindung der Elektrodenanschlüsse mit den Busleitungsanschlüssen der nichtdispersiven Wandler 16. Hierbei wird auf einer unteren "Platte", die Oberflächen-Wellen-Wandler-Struktur (SAW-Struktur) in der wie in Fig. 20a dargestellten Struktur aufgebracht. Hierbei kann es sich um einen Massenartikel handeln, der sich günstig herstellen läßt. Zur Programmierung wird nunmehr auf die untere Platte 42 eine obere Platte 43, beispielsweise ein Siliziumchip 74, gelegt. Diese obere Platte weist auf ihrer Unterseite bereits vorgefertigte "den Code festlegende" Verbindungen auf, so daß erst bei Auflage der oberen Platte 43 auf die untere Platte 42 die jeweils gewünschten Verbindungen der nichtdispersiven Übertrager zu den positiven und negativen Busleitungen hergestellt werden. Auch die Fertigung von "Verbindungsplatten" - wie die Platte 43 - läßt sich sehr kostengünstig durchführen. Das Verbinden der beiden Platten kann durch die verschiedensten Verbindungstechniken erfolgen, beispielsweise durch Verkleben, Flip-Chip-Technologie etc. Durch die Verwendung der beiden Platten, ist auch automatisch die SAW-Struktur geschützt und braucht nicht mehr eigens mit einer Schutzfolie versehen zu werden. Wird die Verbindung der Platten erst beim Endkunden durchgeführt, so bestimmt dieser die Identifikation und Aktivierung der SAW-Struktur und somit des TAGs.

Fig. 22 zeigt in einer überschaulichen Darstellung ein Identifikationssystem, bestehend aus der Abfrageeinheit 1 und einem TAG 44, auf dem die anhand der beschriebenen Figuren gezeigten SAW-Strukturen realisiert sind. Im dargestellten Beispiel ist das TAG nur ein einziges Mal (OTP - one time programmable) programmierbar, beispielsweise durch das Aufbringen der Platten - wie anhand von Fig. 21 gezeigt - oder durch ein Bonding - wie anhand von Fig. 20 gezeigt - oder durch ein Entfernen von Leitungen - wie anhand von Fig. 19 gezeigt. Es konnte ermittelt werden, daß die Maximaldistanz zwischen dem TAG und der Abfrageeinheit 1 bei der zulässigen Feldstärke $H_{max}$ der Abfrageeinheit noch 2,7 m betragen kann, damit eine sichere Abfragekommunikation gewährleistet ist. Die Abfragedistanz von 2,7 m wurde erreicht, wenn die Abfrageeinheit ein Chirp-Signal als Abfragesignal aussandte. Wenn ein Chirp-Signal ausgesandt wird und die Zahl der Abfragen erhöht wird, beispielsweise auf 100 ($N_r$ = 100), so betrug im Vergleichsfall die Abfragedistanz r bereits 8,7 m. Bei Verwendung eines Chirp-Signals als Abfragesignal und 2000 Abfragen ($N_r$ = 2000), beträgt die Abfragedistanz r bereits 18 m. Es läßt sich bei den TAGs ohne weiteres erreichen, daß mit diesen mehr als $10^9$ verschiedene Codes programmieren lassen, so daß das Identifikationssystem über eine sehr große Variabilität/ Kapazität verfügt.

Fig. 23 zeigt die in Fig. 22 dargestellte Anordnung eines Identifikationssystems, bestehend aus einer Abfrageeinheit 1 und einem TAG 44. Allerdings ist das dargestellte Tag 44 hierwiederprogrammierbar (RP-re-programmable). Diese Wiederprogrammierung läßt sich erreichen, wenn - siehe auch Fig. 19a - die positiven und negativen Elektroden der nichtdispersiven Wandler 16 jeweils gleichzeitig mit den positiven und negativen Busleitungen verbunden sind. Zur wiederholbaren Programmierung werden bei den Verbindungspads hier nicht feste Verbindungen, wie zum Beispiel Bonding-Drähte, benutzt, sondern es werden Schaltelemente, das sind vorzugsweise Feldeffekttransistoren, zwischengeschaltet, die mit einem Schaltungstreiber verbunden sind. Der Schaltungstreiber steuert die Stellung "offen" oder "geschlossen" der Schaltertransistoren. Die Transistoren lassen sich nunmehr in einer einfachen Schaltung steuern. Die für den Betrieb der Schaltung notwendige Energie läßt sich mit einer Batterie 76 auf dem TAG zur Verfügung stellen, wobei diese Batterie vorzugsweise eine Folienbatterie ist. Eine drastische Erhöhung von Programmcodemöglichkeiten läßt sich auch dadurch erreichen, daß beispielsweise zwischen den aufeinanderfolgenden Abfragen mit Abfragesignalen ein Code umgeschaltet wird, so daß bezogen auf eine bestimmte Zeiteinheit - beispielsweise die Zeiteinheit von zwei Chirp-Signalen - k( = 2) verschiedene Codes programmiert sind. Somit läßt sich die Zahl der möglichen Codes durch eine automatische Programmierung durch ein Programmieren 77 die Zahl der möglichen Codes erheblich vervielfachen, beispielsweise in einen Bereich von $2^{9k}$ wobei K $\geq$ 1 ist. Ist k = 3, bestehen bereits $2^{27}$ Programm/Codemöglichkeiten, was eine große Programmierkapazität bedeutet bzw. es erlaubt, ein Identifizierungssystem mit einer beliebig großen Menge von Identifikations-TAGs vorzusehen. Theoretisch ist dann die Anzahl der Varianten nur noch von der Speicherkapazität des IC und von der Zeitdauer der Übermittlung abhängig.

Fig. 24 zeigt eine Anordnung einer Abfrageeinheit 1 mit mehreren Antennen 5, wobei jede Antenne über eine Hauptstrahlungskeule 50 verfügt und somit nur TAGs identifizieren kann, die in einem bestimmten räumlichen Winkel zur Antenne angeordnet sind. Die Hauptstrahlungskeulen lassen sich auf die gewünschte Richtung einstellen, was eine sehr große Selektion der Abfrage in bezug auf den jeweiligen geografischen Ort eines TAGs bedeutet. Wird ein TAG gleichzeitig von zwei Antennen "abgefragt", läßt sich somit auch sehr genau der exakte geografische Ort des TAGs feststellen.

Fig. 25 zeigt ein typisches Anwendungsbeispiel des erfindungsgemäßen TAGs. Hierbei sei angenommen, daß die Abfrageeinheit in der Garage eines Hauses angeordnet ist. Das TAG ist hierbei im Auto angeordnet, besser noch integraler Bestandteil des Automobils, beispielsweise in der Windschutzscheibe, so daß es dort nicht ohne weiteres entfernt werden kann. Sobald sich das Automobil dem Haus nähert, ist irgendwann einmal die Entfernung erreicht, in der die Abfrageeinheit nach dem Aussenden von Abfragesignalen ein TAG-codiertes-Signal empfängt und dieses identifiziert. Stimmt bei der Auswertung der TAG-Code mit dem Code überein, auf den eine Auswertungseinheit des Interrogators wartet, so wird durch Steuerung eines automatischen Garagentorantriebs die Garage geöffnet. Es versteht sich von selbst, daß es hierbei vorteilhaft wäre, wenn die Garage nur dann geöffnet wird, wenn TAG-Code-Signale empfangen werden, die von Automobilen stammen, deren Besitzer auch eine Zugangsberechtigung zur Garage haben. Die dargestellte Lösung ist sehr vorteilhaft auch bei Hotelgaragen, so daß der Hotelgast nach dem Einchecken im Hotel dort ein TAG bekommt und sein Automobil in die Garage fahren kann, ohne sich hierfür einen herkömmlichen Schlüssel besorgen zu müssen. Das TAG kann hierbei gleichzeitig auch der Zimmerschlüssel sein, wenn die Zimmertür über eine entsprechende Abfrageeinheit und einen Öffnungsmechanismus, welcher von der Abfrageeinrichtung gesteuert wird, verfügt. Nach dem Auschecken des Gastes wird seine Kennung auf "non valid" gesetzt, so daß sich weder die Hoteltür noch die Hotelgarage dann öffnen lassen. Dieses System setzt einen einfachen Datennetzverbund voraus, welcher sich problemlos herstellen läßt.

Fig. 26 zeigt ein weiteres Anwendungsbeispiel. Hierbei ist eine übliche Situation auf einer Autobahn gezeigt, bei der mehrere Fahrzeuge unterhalb eines Beschilderungsmastes hindurchfahren. An diesem Beschilderungsmast sitzen zwei Abfrageeinheiten, links und rechts am Mast. Sobald sich das Automobil nähert und in den Bereich des Maximalabstandes kommt, kann die Abfrageeinheit das vom TAG zurückgesandte Code-Signal - das TAG ist wiederum im Auto, am Auto oder integraler Bestandteil des Autos, beispielsweise der Windschutzscheibe - verarbeiten und an eine zentrale Dateneinheit schicken. Somit lassen sich nicht nur Verkehrsströme überwachen, sondern auch einzelne Automobile einfach identifizieren. Ist beispielsweise ein identifiziertes Autmobil gestohlen, wissen die entsprechenden Überwachungseinheiten der Polzei sehr schnell, wo sich das Automobil befindet und in welche Richtung es fährt. Somit ist ein sehr schneller Zugriff möglich.

Es versteht sich von selbst, daß die erfindungsgemäße Oberflächen-Wellen-Wandler-Einrichtung, also das erfindungsgemäße TAG sich an allen möglichen Produkten anbringen läßt, sei es als Karte, sei es als Klebefolie o. dgl. Zum Diebstahlschutz von Produkten bietet es sich an, daß das TAG integraler Bestandteil der Produkte ist, was auch dann gegeben ist, wenn es auf dem Produkt aufgeklebt ist oder mit diesem auf sonstige Weise fest verbunden ist.

Fig. 27 zeigt noch einmal in der Übersicht Funktionsweise und Struktur des erfindungsgemäßen TAGs, wobei im gezeigten Beispiel das TAG nur einmal programmierbar ist. Die noch zumutbare Entfernung zwischen dem TAG und der Abfrageeinheit hängt hierbei im wesentlichen von der Zahl der Abfragungen vor allem aber auch vom Abfragesignal ab, welches vorteilhafterweise ein Chirp-Signal ist, aber auch ein sonstiger Radiofrequenzimpuls sein kann. Als Antwort auf das Abfragesignal, wenn dies ein Chirp-Signal ist, sendet das TAG eine Pulsfolge zurück, deren Amplitude und/oder Phase von der Programmierung der nichtdispersiven Wandler abhängt.

Die Struktur eines erfindungsgemäßen Identifikationssystems mit einem erfindungsgemäßen wiederprogrammierbaren TAG zeigt Fig. 28. Hierbei ist zu erkennen, daß die SAW-Filterstruktur 9, 16 mit einem MOS-IC 78 verbunden ist, mit dem die Transistoren, die in der Verbindungsleitung zwischen den positiven Elektroden und den Busleitungen der nichtdispersiven Wandler liegen, geschaltet werden. Über eine Programmeingabe kann die Programmierung jederzeit geändert werden. Zur Energieversorgung ist z.B. eine Folienbatterie 76 (vorgeladene Kapazität, Solarzelle usw.) vorgesehen, so daß das wiederprogrammierbare TAG 44 über eine möglichst lange Lebensdauer verfügt. Selbstverständlich läßt sich mit einer Batterie auch die Zulässigkeitsdauer solcher TAGs voreinstellen, was beispielsweise bei Kartensystemen vorteilhaft ist, so daß eine Karte mit einem erfindungsgemäßen TAG nur für eine bestimmte Zeit gültig ist. Hierzu ist es vorteilhaft, wenn das TAG auch über eine Uhrzeit-Schaltung verfügt.

Fig. 29 zeigt die Fertigung eines erfindungsgemäßen TAGs, wobei dieses aus drei Schichten 79, 80 und 81 besteht, und die erste und die dritte Schicht 79, 81 eine Schutzschicht darstellen und die mittlere Schicht 80 aus einer Distanzfolie gebildet ist, innerhalb derer die erfindungsgemäße Oberflächen-Wellen-Wandler-Struktur (SAW) zusammen mit der Antenne und der Folienbatterie angeordnet ist.

Fig. 30 zeigt verschiedene Möglichkeiten zur Verbindung eines SAW (Surface Acoustic Waves)-Chips und eines Silizium-Verbindungschips, wobei auf dem Silizium-Verbindungschip die jeweiligen Verbindungen angeordnet sind, damit eine Programmierung/Codierung des SAW gewährleistet ist. Die Verbindung kann einmal wie dargestellt durch ein Bonding erfolgen - Fig. 30a - oder durch eine sogenannte Flip-Chip-Technologie - s. Fig. 30b - bei der der Silizium-Verbindungschip auf den SAW-Chip ähnlich wie in der Flip-Chip-Technologie geklappt wird. Es ist auch möglich, die SAW-Struktur oberhalb der Silizium-Verbindungsstruktur anzuordnen - Fig. 30c - oder die SAW-Struktur und die jeweiligen Verbindungen gleich in einem Fertigungsvorgang auf einer Siliziumscheibe vorzusehen.

Wird die Programmierung/Codierung einer SAW-Struktur durch das Aufbringen einer Verbindung hergestellt, beispielsweise durch Aufbringen eines Silizium-Verbindungschips-Flipchip-Technologie -s. Fig. 30b-, wird erstdurch die Programmierung der TAG selbst aktiviert, denn ohne die Verbindung hat der TAG noch keinerlei Funktion eines Oberflächenwandlers. Ein solches System hat somit praktisch die Funktion eines "Schlüssels", welcher gleichzeitig das "Schloß" programmiert und aktiviert. Bei Anregung mit einem Chirp-Signal sendet also ein derart programmiertes/aktiviertes/ccodiertes TAG die gewünschte Pulsfolge aus, die als identifizierende Schlüssel-Schtoß-Stellung des TAGs genau identifiziert bzw. gekennzeichnet ist. Es hängt hierbei allein vom Betreiber des Identifikationssystems ab, ob doppelte Identifizierungskennzeichen vorkommen dürfen. Doppelte Identifizierungskennzeichen bieten sich beispielsweise bei Personen und Warengruppen an, die in irgendeiner Weise zugeordnet sind.

Fig. 31 zeigt die Verbindung zwischen einer OFW-Schaltung 83 und einem Siliziumchip 82, wobei die OFW-Struktur auf der unteren Platte 42 der Siliziumchip auf der oberen Platte 43 angeordnet ist. Die untere Platte 42 mit der OFW-Struktur weist Netzanschlußbereiche 51 und 52 sowie Programmierverbindungsanschlüsse 53 auf. Die obere Platte, die nur zum Teil die untere Platte bedeckt, so daß noch ein Teil der Netzspannungsanschlüsse 51 und 52 unbedeckt bleibt, weist ebenfalls Programmierverbindungsanschlüsse 54 und Netzverbindungsanschlüsse 55 auf. Ferner weist die obere Platte einen Siliziumchip 82 auf, dessen Struktur noch in Fig. 45 näher erläutert wird.

Beim Auflegen der oberen auf die untere Platte liegen sowohl die zugehörigen Programmanschlüsse 53 und 54 als auch die Netzspannungsanschlüsse 51,52 und 55 übereinander, wobei ein Teil der Netzspannungsanschlüsse 51 und 52 von der Platte unbedeckt bleibt. Es wäre jetzt sehr einfach, über eine entsprechende Energieversorgung, die an die Netzspannungsanschlüsse angelegt wird und eine entsprechende Programmierung über die Antennenanschlüsse 57 den Siliziumchip 82 und somit die OFW-Struktur, also das TAG 44, zu programmieren. Hierbei ist eine Neuprogrammierung jederzeit möglich.

Fig. 32 zeigt die Anordnung einer nichtdispersiven Wandleranordnung mittig auf dem OFW-Substrat. Empfängt der dispersive Wandler 9 einen von einem Chirp-Puls-Generator erzeugten Chirp-Impuls, so erzeugt er zwei akustische Oberflächenwellen, nämlich ein komprimiertes Oberflächen-Wellen-Pulssignal 13 und einen expandierten Chirp-Impuls 58. In Fig. 32 ist zu erkennen, daß sich der komprimierte Puls 1 nach links und das expandierte Chirp-Pulssignal nach rechts (in der Zeichnung) bewegt. Die jeweiligen Signale treffen auf jeweils eine nichtdispersive Wandlereinrichtung, so daß ausgangsseitig die Signale $U_{COM}(t)$ und $U_{EXP}(t)$ als elektrische Signale erzeugt werden. Die jeweilige Signalform des komprimierten wie auch des expandierten Signals sind in Fig. 32b und 32c dargestellt. Eine solche Anordnung hat den Vorteil, von der Abfrageeinheit einmal Up-Chirps und nachfolgend Down-Chirps zu senden, um auf diese Weise die Programmkapazität zu erhöhen oder auf unterschiedliche Abfrage-Hierarchien zu wechseln.

Fig. 33 zeigt eine weitere alternative Ausführungsform der Erfindung. Hierbei sind die nichtdispersiven Wandler wie bereits anhand von Fig. 20 erläutert ausgeführt. Der dispersive Wandler 9 ist jedoch mehrteilig ausgeführt, im dargestellten Beispiel besteht er aus drei Teilen 84a, 84b, 84c, wobei der erste Teil geeignet ist hochfrequente Signale, der zweite Teil geeignet ist mittelfrequente Signale und der dritte Teil in der Lage ist niederfrequente Signal zu verarbeiten und entsprechende Oberflächenwellen-Signale zu erzeugen. Fig. 33a zeigt, daß die drei Teile des dispersiven Wandlers 9 unverbunden zu der jeweiligen positiven und negativen Busleitung verbunden angeordnet sind. Die jeweiligen positiven und negativen Elektroden der jeweiligen dispersiven Wandlerteile weisen Anschlußflächen auf, die zu den negativen und positiven Busleitungen benachbart angeordnet liegen.

Fig. 33b zeigt die Bondierung der ersten beiden dispersiven Wandlerteile 9, so daß diese an den jeweils positiven bzw. negativen Bus angeschlossen sind. Der dritte Teil, im dargestellten Beispiel der niederfrequente dispersive Wandlerteil ist nicht an die Busleitung angeschlossen. Somit ist auch die dispersive Wandlereinrichtung 9 programmierbar, was die gesamte Programmier- bzw. Codierkapazität des Systems erhöht. Das in Fig. 33b dargestellte TAG muß also mit einem Chirp-Signal angeregt werden, dessen Frequenzbandbreite auf die Bandbreite des hochfrequenten und mittelfrequenten dispersiven Wandlerteils abgestimmt ist. Bei einer anderen Programmierung der dispersiven Wandlereinrichtung müßte ein anderes Abfragesignal verwendet werden, damit überhaupt auf das Abfragesignal mit einem TAG-Signal geantwortet werden kann.

Fig. 34 zeigt die bereits in Fig. 33 beschriebene Programmierung des TAGs mit einer programmierbaren dispersiven Wandlereinrichtung, wobei die Programmierung durch das Auflegen einer oberen Platte auf die untere Platte, welche bereits anhand von Fig. 33a erläutert wurde, erfolgt. Die obere Platte weist entsprechend der Programmierung gewünschte Verbindungsflächen auf, die auf die jeweiligen Anschlußkontakte der positiven und negativen Elektroden der dispersiven und nichtdispersiven Wandler passen.

Fig. 35 zeigt eine weitere alternative Ausführungsform der Erfindung. Nunmehr ist links und rechts von der programmierbaren dispersiven Wandlereinrichtung 9 jeweils eine nichtdispersive Wandlereinrichtung 16a und 16b angeordnet. Jede dieser Wandlereinrichtungen 16a, 16b sind mit einem unterschiedlichen Code programmierbar. Wie bereits anhand von Fig. 32 erläutert, erzeugt die dispersive Wandlereinrichtung bei Empfang eines Chirp-Signals ein zeitkomprimiertes Pulssignal und ein expandiertes Chirp-Pulssignal. Im dargestellten Beispiel wandert das zeitkomprimierte Pulssignal zur linken und das expandierte Chirp-Pulssignal zur rechten Seite. Im dargestellten Beispiel wird eine Pulsfolge nur von der nichtdispersiven Wandlereinrichtung links von der dispersiven Wandlereinrichtung erzeugt, wenn das TAG mit einem Down-Chirp-Signal angeregt wird. Bei Anregung mit einem Up-Chirp-Signal istdie Codierung der Pulsfolge durch die Wandlereinrichtung 16 rechts von der dispersiven Wandlereinrichtung 9 bestimmt. Mithin wird ein bestimmter Code durch das Up-Chirp- und ein anderer Code durch das Down-Chirp-Signal bestimmt.

Die zu Fig. 35 komplementäre Struktur für das Up-Chirp- und Down-Chirp-Signal zeigt Fig. 36.

Die Fig. 37 und 38 zeigen die zu Fig. 35 und 36 ähnliche Struktur mit einer programmierbaren dispersiven Wandlereinrichtung 9 und beiderseits hiervon angeordneten nichtdispersiven Wandlereinrichtung 16. Im dargestellten Beispiel nach Fig. 37 und 38 ist das TAG nicht programmiert bzw. befindet sich in dem Zustand vor der Programmierung. Die Programmierung kann wie bereits anhand Fig. 14 erläutert, durch das Auftrennen bzw. Entfernen von bestimmten Verbindungsleitungen zwischen den Elektroden und den jeweiligen Busleitungen 71a, 71b erfolgen.

Fig. 39 und 40 zeigen die Anordnung einer "einteilig" ausgeführten dispersiven Wandlereinrichtung 9, die beidseitig wiederum von jeweils einer nichtdispersiven Wandlereinrichtung 16 eingeschlossen ist, wobei beide nichtdispersiven Wandlereinrichtungen unterschiedlich programmierbar sind. Fig. 39 zeigt die Anordnung für ein Down-Chirp-Impuls als Abfragesignal, Fig. 40 zeigt den Fall für ein Up-Chirp-Impuls als Abfragesignal. Die Programmierung kann wiederum durch das Entfernen der Verbindungsleitung erfolgen.

Fig. 41 zeigt die Pulssignalfolge bei Anregung mit einem Down-Chirp-Signal sowie einem Up-Chirp-Signal. Der Code für das Down-Chirp-Signal wird hierbei durch die Buchstabenfolge "RBACBBCA" und der Code für das Up-Chirp-Signal wird durch die Buchstabenfolge "RCBACBAB" festgelegt. Die hierfür notwendige Programmierung ist Fig. 41 unmittelbar zu entnehmen. Die jeweiligen Pulssignalfolgen für das Down-Chirp-Signal bzw. das Up-Chirp-Signal als Abfragesignal sind in Fig. 41 b und 41 c dargestellt. Hierbei ist zu erkennen, daß die Signalfolge der komprimierten Pulse von dem expandierten Chirp-Signal überlagert wird, daß jedoch die Amplitude des expandierten Chirp-Signals weit unterhalb der Maximalamplituden der zeitkomprimierten Pulse liegt und deshalb eine ausreichend gute Unterscheidung zwischen den zeitkomprimierten Pulssignalen und dem expandierten Chirp-Signal möglich ist.

Fig. 42 zeigt eine weitere alternative Ausführungsform der Erfindung. Hierbei sind zwei dispersive Wandlereinrichtungen auf dem TAG angeordnet, die eine nichtdispersive Wandlereinrichtung einschließen. Bei Anregung mit einem Down-Chirp-Pulssignal erzeugt die erste dispersive Wandlereinrichtung 9a ein expandiertes Chirp-Pulssignal und die zweite dispersive Wandlereinrichtung 9b ein zeitkomprimiertes Pulssignal. Der hierzu komplementäre Fall ist in Fig. 43 dargestellt, so daß beim Up-Chirp-Pulssignal als Abfragesignal die erste Wandlereinrichtung 9a ein zeitkomprimiertes Pulssignal und die zweite dispersive Wandlereinrichtung 9b ein expandiertes Chirp-Signal generiert.

Fig. 44 zeigt die Signalstruktur der in Fig. 42 und 43 gezeigten OFW-Struktur bei Anregung mit einem Up-Chirp- und bei Anregung mit einem Down-Chirp-Signal.

Hierbei ist zu erkennen, daß die jeweiligen Pulscodefolgen 40 für das Up- und Down-Chirp-Signal reziprok zueinander liegen, so daß eine Abfrageeinheit bei der zeitlich versetzten Generierung eines Up-Chirp- und Down-Chirp-Signals die reziproken Pulssignalfolgen auf ihre (reziproke) Übereinstimmung überprüfen kann, was zur Erhöhung der Abfragesicherheit führt und nur dann zulässige Ergebnisse erlaubt, wenn das TAG in der dargestellten Weise strukturiert ist. Fehlt also dem TAG beispielsweise die zweite dispersive Wandlereinrichtung, so würde die Abfrageeinheit auf das Down-Chirp-Signal keine Pulssignalfolge empfangen, und möglicherweise die Auswertung mit "non-valid" werten.

Fig. 45 zeigt die Struktur eines wiederprogrammierbaren passiven TAGs. Hierbei weist das TAG die bereits beschriebene OFW (SAW)-Struktur 60, eine Antenneneinrichtung 61 sowie ein Siliziumchip 62 auf. Der Siliziumchip weist eine Schaltmatrix 63, einen Mikrocontroller 64, einen wiederprogrammierbaren Speicher 65, ein programmierbares Interface 66 sowie einen Tiefpaßfilter 67 auf. Ferner verfügt der Siliziumchip über einen Anschluß zu einer Energieversorgung 68, beispielsweise einer Batterie, einer Solarzelle, einer Ladungskapazität etc. Das Tiefpaßfilter 67 ist mit den Antennenteilen der Antenne 61 verbunden. Ferner ist die OFW-Struktur 60 mit der Schaltmatrix 63 verbunden, welche ihrerseits wiederum mit dem Mikrocontroller 64 verbunden ist, welcher mit dem Speicher 65 und dem Interface 66 verbunden ist.

Eine weitere Ausführungsform des TAGs nach Fig. 45 ist in Fig. 46 dargestellt. Hierbei weist der Mikrocontroller eine weitere Schnittstelle zu einer Datenquelle 69 auf, die im dargestellten Beispiel durch einen Sensor gebildet wird, über den Daten, vorzugsweise Programmierdaten - z.B. Temperatur, Umweltdaten, biometrische Daten (z.B. Fingerabdruck) -in den Mikrocontroller eingegeben werden können, so daß die OFW-Struktur dementsprechend programmiert werden kann.

Das Prinzip der Programmierung zeigt Fig. 47. Hierbei ist zu erkennen, daß das bereits in der Fig. 46 beschriebene TAG mit einer Programmiereinrichtung 90, welche über Programmierantennen 91 und 92 verfügt, gekoppelt ist. Die Programmiereinrichtung 90 kann ihrerseits mit einem externen Gerät, beispielsweise einem Computer, einem Netzwerk etc. in Datenverbindung stehen. Zur Programmierung werden die Programmierdaten über die Antennen des Programmierers 90 auf das TAG 44 übertragen und es ist möglich, mehrere Programmierungen bzw. mehrere verschiedene Codes in den Codespeicher 65 abzulegen und über den Mikrocontroller die OFW-Struktur entsprechend zu programmieren. Über die Datenquellen 69 können hierbei die verschiedenen Codes ausgewählt werden.

Die Programmierung des wiederprogrammierbaren TAGs ist in der Systemdarstellung nach Fig. 48 weiter erläutert. Hierbei ist zu erkennen, daß das TAG in eine Programmiereinrichtung 90 eingeführt wird, in der ein einzelner Identifizierungscode oder eine Vielzahl von Identifizierungscodes in den Codespeicher des TAGs geladen werden. Die Programmierdaten werden im niederfrequenten Frequenzband übertragen, so daß sie vom Tiefpaßfilter erfaßt werden können. Die Datenaufbereitung der Programmierdaten erfolgt im Programmierinterface. In Fig. 48 ist zu sehen, daß die Antennen 91, 92 des Programmierers 90 sehr nahe angeordnet sind zu den TAG-Antennen, damit die für die Programmierung notwendige hohe Übertragungsenergie zur Verfügung gestellt werden kann.

Ist das TAG an einer Meßeinrichtung, z.B. Umweltdatenmeßeinrichtung, angeordnet, ist es zweckmäßig, daß über eine Dateneingabe Meßdaten auf das TAG übertragen werden, so daß bei einer entsprechenden Abfrage das TAG eine Pulscodefolge aussendet, welche das jeweilige Meßsignal repräsentiert. Es ist somit mit einfachsten Mitteln möglich, Meßsignale von einem Meßgerät drahtlos abzufragen, ohne daß das Meßgerät über eine eigene aktive Sendeeinrichtung verfügt. Durch eineentsprechende Steuerung derDateneingabe, können auch ganze Meßsignalfolgen bei der entsprechenden Abfrage des TAGs an die Abfrageeinheit übertragen werden.

Bei der vorbeschriebenen Meßsignalabfrage mittels des TAGs bietet es sich an, daß jedes Meßsignal einen bestimmten Identifikationscode enthält, welcher das jeweilige TAG und damit das entsprechende Meßgerät identifiziert. Die weiteren codierten Daten repräsentieren dann das gewünschte abzufragende Meßsignal. Statt der beschriebenen Meßeinrichtung kann dasTAG mitjederanderen denkbaren Datenquelle gekoppelt werden, welche Daten an das TAG überträgt, die ihrerseits vom Interrogator abfragbar sind. Eine solche Datenquelle kann auch ein medizinischtechnisches Gerät oder eine Datenverarbeitungseinrichtung sein.

Bei der Erfindung ist es selbstverständlich auch möglich, daß das TAG einmal programmierbare nichtdispersive Wandler und wiederprogrammierbare nichtdispersive Wandler aufweist, so daß nur ein Teil der Pulssignalfolge frei programmierbar ist.

Es ist auch möglich, die dispersive Wandlereinrichtung durch eine nichtdispersive Wandlereinrichtung zu ersetzen. Hierbei ist es dann zweckmäßig, wenn als Abfragesignal ein klassisches Pulssignal verwendet wird, so daß das TAG dann mit der gewünschten Pulssignalfolge auf das Abfragesignal antwortet.

Es ist auch möglich, daß der Interrogator bereits eine identifizierende Pulsfolge aussendet, auf die nur ein TAG, welches so programmiert ist, wie es der Identifikationspulsfolge entspricht, mit einem gewünschten Antwortsignal reagiert. Somit ist es möglich, auch die Anwesenheit von bestimmten Ident-TAGs zu einer Vielzahl von anderen TAGs selektiv zu ermitteln.

Es ist auch möglich, daß der Interrogator zunächst ein Chirp-Signal sendet und hierauf folgend eine Identifikations-Pulsfolge, so daß für das gesuchte TAG eine sehr zuverlässige Abfrage erfolgen kann.

Aus der vorliegenden Beschreibung ist auch ersichtlich, daß eine Vielzahl von dispersiven Wandlereinrichtungen mit einer weiteren Vielzahl von nicht dispersiven Wandlereinrichtungen kombiniert werden kann, wobei die nicht dispersive Wandlereinrichtung auch eine unterschiedliche Anzahl von nicht dispersiven Einzelwandlern aufweisen kann.

Die beschriebenen Abbildungen zeigen nur eine prinzipielle Struktur, in der die Wirkungsweise der erfindungsgemäßen Anordnung verdeutlicht wird. Es sind vielfältige, schaltungstechnische Variationen denkbar, die die gleiche Funktion beinhalten. Ausdrücklich erwähnt seien hierbei Serienschaltungen von Inter-Digital-Wandlern (IDT). Diese können eingesetzt werden, um die Kapazität der Wandleranordnungen gering zu halten.

Insbesondere kann das Layout der Metallelektroden der SHW-Filter auf viele verschiedene Arten erfolgen (z. B. Split-Finger-Technologie), wobei die dargestellten Realisierungen nur die prinzipielle Funktionsweise beschreiben. Desweiteren ist die geometrische Anordnung der Wandler nicht auf geradlinige Ausbreitung der OFW beschränkt. Zur besseren Ausnutzung der Chip-Fläche könnte die OFW durch gut reflektierende Reflektoren umgelenkt werden. Der dabei auftretende Reflektionsverlust ist gering, da eine maximale Reflektion durch periodische Strukturen leicht erreicht werden kann.

Desweiteren ist es möglich, bei der Richtungsänderung der OFW durch Reflektoren eine Kompression der Signale erfolgt, indem die Reflektorstruktur eine Chirp-Charakteristik aufweist. Auf diese Weise ist es auch möglich, den dispersiven IDT durch einen linearen IDT zu realisieren, indem ein dispersiver Reflektor nachgeschaltet ist, so daß dieser die OFW komprimiert und auf die codierte Anordnung der nichtdispersiven IDT reflektiert.

**Patentansprüche**

1. Oberflächen-Wellen-Wandler-Einrichtung, bestehend aus der Kombination einer ersten Übertragungseinrichtung (9) vom dispersiven Typ und einer zweiten Übertragungseinrichtung vom nichtdispersiven Typ, letztere bestehend aus einer Vielzahl von nichtdispersiven Wandlern (16), die mit einem Identifikationscode kodiert sind, wobei der jeweilige Abstand benachbarter nichtdispersiver Wandler gleich ist und der Beitrag eines einzelnen Wandlers zum Code dadurch bestimmt ist, ob und mit welcher Polarität ein Anschluss an die Elektroden des Wandlers besteht.

2. Oberflächen-Wellen-Wandler-Einrichtung nach Anspruch 1,
   **dadurch gekennzeichnet, daß** die n nichtdispersiven Wandler (16) so programmiert/kodiert und/oder geschaltet sind, daß sie bei Anregung mit einem Signal ein die Oberflächen-Wellen-Wandler-Einrichtung identifizierendes Signal aussenden.

3. Oberflächen-Wellen-Wandler-Einrichtung nach einem der vorhergehenden Ansprüche,
   **dadurch gekennzeichnet, daß** ein jeder nichtdispersive Wandler eine positive und eine negative Elektrode aufweist und daß der positiven Elektrode der n Wandler eine positive Busleitung und der negativen Elektrode der n Wandler eine negative Busleitung örtlich zugeordnet istund daßdie gewünschte Kodierung/Identifizierung der Oberflächen-Wellen-Wandler-Einrichtung durch die Wahl der Verbindung zwischen den positiven bzw. negativen Wandler-Elektroden zu den positiven bzw. negativen Busleitungen ausgeführt ist.

4. Oberflächen-Wellen-Wandler-Einrichtung nach einem der vorhergehenden Ansprüche, wobei die Einrichtung auf ein elektromagnetisches Eingangssignal mit einem Ausgangssignal reagiert und das Ausgangssignal dergestalt ist, daß es wenigstens drei verschiedene logische Zustände (ABC) aufweist.

5. Oberflächen-Wellen-Wandler-Einrichtung nach einem der vorhergehenden Ansprüche,
   **dadurch gekennzeichnet, daß** bei Empfang eines Chirp-Signals die Einrichtung eine Vielzahl von Impulsen erzeugt, die als Ausgangssignale zeitlich nacheinander ausgesendet werden.

6. Oberflächen-Wellen-Wandler-Einrichtung nach einem der vorhergehenden Ansprüche,
**dadurch gekennzeichnet, daß** die Einrichtung bei Empfang eines Chirp-Signals m-Pulssignale nacheinander aussendet wobei n> = m ist und m der Zahl der n nichtdispersiven Wandler entspricht, die kein Pulssignal bereitstellen.

7. Oberflächen-Wellen-Wandler-Einrichtung nach einem der vorhergehenden Ansprüche,
**dadurch gekennzeichnet, daß** die positive Elektrode der Übertragungseinrichtung vom dispersiven Typ mit der positiven Busleitung und die negative Elektrode des Wandlers vom dispersiven Typ mit der negativen Busleitung verbunden ist.

8. Oberflächen-Wellen-Wandler-Einrichtung nach einem der vorstehenden Ansprüche,
**dadurch gekennzeichnet, daß** die Einrichtung eine Antenneneinrichtung aufweist, bestehend aus zwei Teilen, wobei der erste Teil der Antenne mit der positiven Busleitung und der andere Teil mit der negativen Busleitung verbunden ist.

9. Oberflächen-Wellen-Wandler-Einrichtung nach einem der vorhergehenden Ansprüche,
**dadurch gekennzeichnet, daß** alle Wandler über eine Programmierungsschaltung elektrisch parallel geschaltet sind.

10. Oberflächen-Wellen-Wandler-Einrichtung nach einem der vorhergehenden Ansprüche,
**dadurch gekennzeichnet, daß** wenigstens einer der n nichtdispersiven Wandler als Referenzelement dient.

11. Oberflächen-Wellen-Wandler-Einrichtung nach einem der vorhergehenden Ansprüche,
**dadurch gekennzeichnet, daß** Wandler (16) vom nichtdispersiven Typ nur auf einer Seite oder auf beiden Seiten der Wandlereinrichtung (9) vom dispersiven Typ angeordnet sind.

12. Oberflächen-Wellen-Wandler-Einrichtung nach einem der vorhergehenden Ansprüche,
**dadurch gekennzeichnet, daß** bei Empfang eines Eingangssignals, welches ein kurzer Radiofrequenzimpuls ist, dieses Signal von der dispersiven Übertragungseinrichtung in eine erste Chirp-förmige Oberflächenwelle umgewandelt wird, die sich in Richtung der n nichtdispersiven Wandler ausbreitet und beim Passieren der nichtdispersiven Wandler elektrische Chirp-Impulse auslöst, deren Überlagerung auf den Busleitungen den programmierten Code repräsentiert, während im selben Zeitraum die durch das Eingangssignal ebenfalls angeregten nichtdispersiven Wandler eine den programmierten Code repräsentierende Folge von Oberflächen-Wellen erzeugen, deren Charakteristik gleich der des Eingangssignals ist und die sich in Richtung der dispersiven Übertragungseinrichtung ausbreiten, dort in elektrische Impulse Chirp-förmiger Charakteristik umgewandelt werden, welche zeitgleich und phasengenau mit den durch die erste Oberflächen-Welle erzeugten Chirp-Impulsen der nichtdispersiven Wandler ausgesendet werden.

13. Oberflächen-Wellen-Wandler-Einrichtung nach einem der vorhergehenden Ansprüche,
**dadurch gekennzeichnet, daß** die Übertragungseinrichtung Signale generiert, welche auch in einer Entfernung (r) von mehr als 2 m noch gut empfangbar sind.

14. Oberflächen-Wellen-Wandler-Einrichtung nach einem der vorhergehenden Ansprüche,
**dadurch gekennzeichnet, daß** ein Chirp-Signal als Eingangssignal eine zeitliche Länge von 0,5 bis 1,5 µs, vorzugsweise 1 µs aufweist und daß das Chirp-Signal eine Frequenzbandbreite von 50 bis 250 MHz aufweist.

15. Oberflächen-Wellen-Wandler-Einrichtung nach einem der vorhergehenden Ansprüche,
**dadurch gekennzeichnet, daß** ein Pulssignal, welches von der Wandlereinrichtung vom dispersiven Typ bei Empfang eines Chirp-Signals generiert wird, im wesentlichen eine Hauptimpuls-Zeitdauer ($T_{SC}$) aufweist, welche nach der folgenden Formel berechnet wird,

$$T_{SC} = \frac{2}{B}$$

wobei B die Bandbreite des Chirp-Signals ist.

16. Oberflächen-Wellen-Wandler-Einrichtung nach einem der vorhergehenden Ansprüche,
**dadurch gekennzeichnet, daß** der zeitliche Abstand von aufeinanderfolgenden Pulssignalen der zweiten Wandler-Einrichtung vom nichtdispersiven Typ wenigstens so groß ist, wie die zeitliche Dauer ($T_{SC}$) des Pulssignals.

17. Oberflächen-Wellen-Wandler-Einrichtung nach Anspruch 16,
**dadurch gekennzeichnet, dass** der Abstand ein mehrfaches, insbesondere das fünfbis zehnfache der Zeitdauer eines einzelnen Pulses beträgt.

18. Oberflächen-Wellen-Wandler-Einrichtung nach einem der vorhergehenden Ansprüche,
**dadurch gekennzeichnet, daß** die ersten und zweiten Wandler-Einrichtungen (9, 16) Inter-Digitalübertrager (IDT) sind.

19. Oberflächen-Wellen-Wandler-Eincichtung nach einem der vochergehenden Ansprüche,
**dadurch gekennzeichnet, daß** die nichtdispersiven Wandler (16) auf ein Puls-Signal mit einem bi-phasigen Pulssignal reagieren, wobei vorzugsweise die Phasenlage des einzelnen Pulssignals davon abhängt, ob die positive bzw. negative Elektrode des entsprechenden Wandlers (16) an die positive oder negative Busleitung angeschlossen ist.

20. Oberflächen-Wellen-Wandler-Einrichtung nach einem der vorhergehenden Ansprüche,
**dadurch gekennzeichnet, daß** alle aktiv-geschalteten nichtdispersiven Wandler (16) mit der positiven Elektrode an die positive Busleitung und mit der negativen Elektrode an die negative Busleitung angeschlossen sind.

21. Oberflächen-Wellen-Wandler-Einrichtung nach einem der vorhergehenden Ansprüche,
**dadurch gekennzeichnet, daß** die Wandler-Einrichtung vom nichtdispersiven Typ Wandler (16) aufweist, welche bei Anregung mit einem Signal entweder ein Signal erzeugen, welches in Phase ist (In-Phase) mit dem Anregungssignal oder ein Signal erzeugen, welches nicht in Phase (out-of-Phase) ist mit dem Anregungssignal oder kein Signal erzeugen.

22. Oberflächen-Wellen-Wandler-Einrichtung nach einem der vorhergehenden Ansprüche,
**dadurch gekennzeichnet, daß** die Programmierung/Kodierung der Wandler vom nichtdispersiven Typ dadurch erfolgt, daß jeweils gewünschte Verbindungsleitungen vom positiven oder negativen Bus zu den positiven und/ oder negativen Elektroden der Wandler vorgesehen sind, wobei die Verbindungsleitungen vorzugsweise gebondet sind.

23. Oberflächen-Wellen-Wandler-Einrichtung nach einem der vorhergehenden Ansprüche,
**dadurch gekennzeichnet, daß** die Programmierung/Kodierung der Wandler vom nichtdispersiven Typ dadurch bestimmt wird, daß Leitungen, die einerseits zwischen der positiven Busleitung und der positiven und negativen Elektrode der Wandler und andererseits zwischen der negativen Busleitung und den positiven und negativen Elektroden der Wandler bestehen, je nach gewünschter Kodierung aufgetrennt werden.

24. Oberflächen-Wellen-Wandler-Einrichtung nach einem der vorhergehenden Ansprüche,
**dadurch gekennzeichnet, daß** jede Elektrode eines Wandlers (16) vom nichtdispersiven Typ einen ersten und einen zweiten Anschluß aufweist und daß der erste Anschluß nahe der positiven Busleitung und der zweite Anschluß nahe der negativen Busleitung angeordnet ist.

25. Oberflächen-Wellen-Wandler-Einrichtung nach Anspruch 24,
**dadurch gekennzeichnet, daß** die Programmierung/Kodierung der Wandler vom nichtdispersiven Typ dadurch realisiert ist, daß auf einer unteren Platte nichtdispersive Wandler unverbunden zu den jeweiligen Busleitungen angeordnet sind und daß auf der unteren Platte eine obere Platte angeordnet ist, auf deren der unteren Platte zugeordneten. Seite Verbindungsleitungen angeordnet sind, die in der gewünschten Weise die positiven/negativen Elektroden mit der positiven oder negativen Busleitung verbinden.

26. Oberflächen-Wellen-Wandler-Einrichtung nach einem der vorhergehenden Ansprüche,
**dadurch gekennzeichnet, daß** wenigstens einer der Wandler vom nichtdispersiven Typ Signalleitungen aufweist, die die positive Elektrode und die negative Elektrode mit beiden Busleitungen verbinden und daßim Signalweg der Verbindungsleitungen Schalter liegen, wobei die Schalter vorzugsweise Transistoren sind.

27. Oberflächen-Wellen-Wandler-Einrichtung nach Anspruch 26;

**dadurch gekennzeichnet, daß** die Einrichtung einen Schaltungstreiber mit Speicher zur Steuerung der Schaltung und eine Energieversorgungseinrichtung, beispielsweise eine Batterie zur Versorgung des Schaltungstreibers und/oder der Schalter mit Energie aufweist.

28. Oberflächen-Wellen-Wandler-Einrichtung nach einem der vorhergehenden Ansprüche,
**dadurch gekennzeichnet, daß** die Wandler-Einrichtung in einer Karte integriert ist, die im wesentlichen aus drei übereinander angeordneten Schichten besteht, wobei die erste Schicht und die dritte Schicht eine Schutzschicht darstellen, zwischen der die zweite Schicht liegt, innerhalb der die erste und zweite Wandlereinrichtung (9, 16) sowie die Antenne (30) ausgebildet sind.

29. Oberflächen-Wellen-Wandler-Einrichtung nach einem der vorhergehenden Ansprüche,
**dadurch gekennzeichnet, daß** auf der einen Seite der Übertragungseinrichtung vom dispersiven Typ ein erster Satz von p nichtdispersiven Wandlern (16) und auf der anderen Seite ein zweiter Satz von q nichtdispersiven Wandlern (16) angeordnet ist, daß der erste Satz von p Wandlern mit einem Code 1 und der zweite Satz von q Wandlern mit einem Code 2 programmiert ist und daß die Codes vorzugsweise voneinander verschieden sind.

30. Oberflächen-Wellen-Wandler-Einrichtung nach einem der vorhergehenden Ansprüche,
**dadurch gekennzeichnet, daß** die Übertragungseinrichtung vom dispersiven Typ eine programmierbare Länge aufweist.

31. Oberflächen-Wellen-Wandler-Einrichtung nach einem der vorhergehenden Ansprüche,
**dadurch gekennzeichnet, daß** die Einrichtung auf einem Silizium-Substrat ausgebildet ist.

32. Oberflächen-Wellen-Wandler-Einrichtung nach einem der vorhergehenden Ansprüche,
**dadurch gekennzeichnet, daß** derjenige der n nichtdispersiven Wandler, welcher der dispersiven Wandler-Einrichtung am nächsten liegt, ein Referenz-Wandler (Referenzelement) bildet, dessen (Puls)-Signal als Reaktion auf ein (Puls)-Signal der dispersiven Wandlereinrichtung zuerst ausgesendet wird.

33. Oberflächen-Wellen-Wandler-Einrichtung nach einem der vorhergehenden Ansprüche, daß die Zahl n der nichtdispersiven Wandler (16) größer als 30 ist.

34. Oberflächen-Wellen-Wandler-Einrichtung nach einem der vorhergehenden Ansprüche,
daß von den n nichtdispersiven Wandlern n-k Wandler programmierbar bzw. programmiert sind, wobei k < = n ist.

35. Oberflächen-Wellen-Wandler-Einrichtung nach einem der vorhergehenden Ansprüche,
**dadurch gekennzeichnet, daß** das TAG einmal oder mehrfach programmierbar ist.

36. Oberflächen-Wellen-Wandler-Einrichtung nach Anspruch 35,
**dadurch gekennzeichnet, daß** die Einrichtung für die Wiederprogrammierbarkeit eine Steuerungseinrichtung (64) aufweist, weiche mit einer Schaltmatrix (63) verbunden ist, sowie eine Programmschnittstelle (66) und eine Speichereinrichtung aufweist, welche einen oder mehrere Identifikationscodes bzw. eine gewünschte Datenfolge speichern kann, und daß die Oberflächen-Wellen-Wandler-Einrichtung unter Verwendung der gespeicherten Daten programmierbar ist.

37. Verwendung einer Oberflächen-Wellen-Wandlereinrichtung nach einem der vorhergehenden Ansprüche für die Identifizierung von Waren, Menschen oder Tieren.

38. Verwendung nach Anspruch 37, **gekennzeichnet durch** eine Abfrage-/Auswerteeinheit (1) (Interrogator).

39. Verwendung nach Anspruch 38,
**dadurch gekennzeichnet, daß** der Interrogator (1) ein Abfragesignal aussendet und ein von der Oberflächen-Wellen-Wandler-Einrichtung zurückgesendetes Antwortsignal empfängt und auswertet.

40. Verwendung nach Anspruch 38 oder 39,
**dadurch gekennzeichnet, daß** der Interrogator (1) im Sende- und/oder Empfangsteil eine Stufe mit einer zur dispersiven Übertragungseinrichtung (9) komplementären Charakteristik enthält.

41. Verwendung nach Anspruch 38, 39 oder 40,

**dadurch gekennzeichnet, daß** der Interrogator (1) mit einer Datenverarbeitungseinrichtung und/oder einem Datenverarbeitungssystem/-Netz verbunden ist und an seinem Ausgang empfangene Identifizierungskennzeichen (Codes) ausgibt.

**42.** Verwendung nach einem der Ansprüche 38 bis 41,
**dadurch gekennzeichnet, daß** der Interrogator Mittel zur Phasendiskrimination aufweist.

**43.** Verwendung nach einem der Ansprüche 38-42,
**dadurch gekennzeichnet, daß** der Interrogator Mittel zum Aussenden eines Abfragesignals aufweist, wobei das Abfragesignal vorzugsweise ein Chirp-Signal oder ein Radiofrequenz-Impuls ist.

**44.** Verwendung nach einem der Ansprüche 38 bis 43,
**dadurch gekennzeichnet, daß** die Empfangseinheit des Interrogators (1) eine Stufe mit gegenüber der dispersiven Wandlereinrichtung gleicher Charakteristik und eine weitere Stufe mit entsprechend umgekehrter Charakteristik enthält.

**45.** Verwendung nach Anspruch 44,
**dadurch gekennzeichnet, daß** die Oberflächen-Wellen-Wandler-Einrichtung auf der einen Seite der dispersiven Wandler-Einrichtung (9) einen ersten Satz von p nichtdispersiven Wandlern (16) und auf der anderen Seite einen zweiten Satz von q nichtdispersiven Wandlern (16) aufweist, wobei die Elektroden der dispersiven Wandlereinrichtung mit der Antenne und mit den Busleitungen der nichtdispersiven Wandler verbunden sind, der erste Satz von p Wandlern mit einem Code 1 und der zweite Satz von q Wandlern mit einem Code 2 programmiert ist, daß das Abfragesignal des Interrogators ein kurzer Radiofrequenz-Impuls ist und die Empfangseinheit des Interrogators (1) eine Stufe mit gegenüber dem dispersiven Wandler gleicher Charakteristik und eine weitere Stufe mit entsprechend umgekehrter Charakteristik enthält, so daß ein vom Interrogator ausgesandtes und über die Antenne empfangenes Abfragesignal vom dispersiven Wandler in zwei sich in entgegengesetzte Richtung ausbreitende Chirp-förmige Oberflächen-Wellen komplementärer Charakteristik (up-chirp, down-chirp) umgewandelt wird, die bei Erreichen des ersten bzw. zweiten Satzes von p bzw. q Wandlern jeweils ein Code-Signal unterschiedlicher Codierung und ebenfalls unterschiedlicher Chirp-Charakteristik auslösen, so daß beide Sätze von nichtdispersiven Wandlern als Reaktion auf das Abfragesignals jeweils eine den betreffenden Code führende Reihe von Oberflächenwellen (SAW) in Richtung des dispersiven Wandlers aussenden, die dort in Code-Signale mit unterschiedlicher Chirp-Charakteristik umgewandelt werden, wodurch auf den gemeinsamen Busleitungen ein beide Codes führendes Signal entsteht, bestehend aus up-Chirp-Impulsen, die den ersten Code repräsentieren und down-Chirp-Impulsen, die den zweiten Code repräsentieren, und daß das auf den Busleitungen entstehende Signal über die Antenne zur Empfangseinheit des Interrogators übertragen wird und dort von den dispersiven Stufen komplementärer Charakteristik in eine erste, den Code 1 repräsentierende Folge und/oder eine zweite, den Code 2 repräsentierende Folge von Radiofrequenz-Impulsen umgewandelt wird.

**46.** Verwendung einer Oberflächen-Wellen-Wandler-Einrichtung nach einem der Ansprüche 1 bis 36,
**dadurch gekennzeichnet, dass** die Einrichtung mit einer Datenquelle gekoppelt ist und an die Einrichtung Daten überträgt, die von einer Abfrageeinheit abgefragt werden können.

**Claims**

**1.** Surface acoustic wave tag device, comprising a combination of a first transformation arrangement (9) of the dispersive type and a second transformation arrangement of the non-dispersive type, the latter comprising a plurality of non-dispersive transducers, wherein the respective spacings between adjacent non-dispersive transducers are the same and the contribution of an individual transducer to the code is determined by whether there is a connection to the electrodes of the transducer and, if so, of what polarity it is.

**2.** Surface acoustic wave tag device according to claim 1, **characterised in that** the n non-dispersive transducers (16) are so programmed/coded and/or connected that, when actuated by a signal, they emit a signal which identifies the surface acoustic wave tag device.

**3.** Surface acoustic wave tag device according to either of the forgoing claims, **characterised in that** each non-dispersive transducer has a positive and a negative electrode, **in that** a positive bus bar is spatially associated with the positive electrodes of the n transducers and a negative bus bar is spatially associated with the negative electrodes of the n transducers and **in that** the desired coding/identification of the surface acoustic wave tag device is performed by selecting the connection between the positive and negative transducer electrodes, and the positive and negative bus bars.

4. Surface acoustic wave tag device according to one of the foregoing claims, wherein the device responds to an electromagnetic input signal with an output signal and the output signal is such that it is of at least three different logic states (ABC).

5. Surface acoustic wave tag device according to one of the foregoing claims, **characterised in that** on receipt of a chirp signal the device generates a plurality of pulses which are emitted in temporal succession as output signals.

6. Surface acoustic wave tag device according to one of the foregoing claims, **characterised in that** on receipt of a chirp signal the device emits m pulse signals in succession, where n ≥ m and m is the number of the n non-dispersive transducers which do not produce a pulse signal.

7. Surface acoustic wave tag device according to one of the foregoing claims, **characterised in that** the positive electrode of the transformation arrangement of the dispersive type is connected to the positive bus bar and the negative electrode of the transducer of the dispersive type is connected to the negative bus bar.

8. Surface acoustic wave tag device according to one of the foregoing claims, **characterised in that** the device has an antenna device comprising two parts, the first part of the antenna being connected to the positive bus bar and the other part to the negative bus bar.

9. Surface acoustic wave tag device according to one of the foregoing claims, **characterised in that** all the transducers are connected in parallel electrically via a programming circuit.

10. Surface acoustic wave tag device according to one of the foregoing claims, **characterised in that** at least one of the n non-dispersive transducers acts as a reference element.

11. Surface acoustic wave tag device according to one of the foregoing claims, **characterised in that** transducers (16) of the non-dispersive type are arranged on only one side, or on both sides, of the transducer arrangement (9) of the dispersive type.

12. Surface acoustic wave tag device according to one of the foregoing claims, **characterised in that**, on receipt of an input signal which is a short radio-frequency pulse, this signal is converted by the dispersive transformation arrangement into a first surface wave of chirp form, which propagates in the direction of the n non-dispersive transducers and, on passing the non-dispersive transducers, triggers electrical chirp pulses which, when transferred to the bus bars, represent the programmed code, while over the same period the non-dispersive transducers, which are also actuated by the input signal, generate a sequence of surface waves representing the programmed code, the characteristic of which surface waves is the same as that of the input signal and which surface waves propagate in the direction of the dispersive transformation arrangement and are there converted into electrical pulses having a characteristic of chirp form which are emitted at the same time as and exactly in phase with the chirp pulses from the non-dispersive transducers which are generated by the first surface wave.

13. Surface acoustic wave tag device according to one of the foregoing claims, **characterised in that** the transformation arrangement generates signals which can still be received well even at a range (r) of more than 2 m.

14. Surface acoustic wave tag device according to one of the foregoing claims, **characterised in that** as an input signal a chirp signal has a temporal length of 0.5 to 1.5 μs and preferably 1 μs and **in that** the chirp signal has a frequency bandwidth of 50 to 250 MHz.

15. Surface acoustic wave tag device according to one of the foregoing claims, **characterised in that** a pulse signal which is generated by the transducer arrangement of the dispersive type on receipt of a chirp signal has substantially a main-pulse duration ($T_{sc}$) which is calculated from the following formula:

$$T_{sc} = \frac{2}{B}$$

where B is the bandwidth of the chirp signal.

**16.** Surface acoustic wave tag device according to one of the foregoing claims, **characterised in that** the temporal spacing of successive pulse signals from the second transducer arrangement, of the non-dispersive type, is at least as great as the temporal duration ($T_{sc}$) of the pulse signal.

**17.** Surface acoustic wave tag device according to claim 16, **characterised in that** the spacing is a multiple of, and in particular is five to ten times, the duration of a single pulse.

**18.** Surface acoustic wave tag device according to one of the foregoing claims, **characterised in that** the first and second transducer arrangements (9, 16) are interdigital transducers (IDT's).

**19.** Surface acoustic wave tag device according to one of the foregoing claims, **characterised in that** the non-dispersive transducers (16) respond to a pulse signal with a bi-phase pulse signal, in which case the phase angle of the individual pulse signal preferably depends on whether there is a connection between the positive or negative electrode of the relevant transducer (16) and the positive or negative bus bar respectively.

**20.** Surface acoustic wave tag device according to one of the foregoing claims, **characterised in that** all the non-dispersive transducers (16) which are connected to be active are connected to the positive bus bar by their positive electrode and to the negative bus bar by their negative electrode.

**21.** Surface acoustic wave tag device according to one of the foregoing claims, **characterised in that** the transducer arrangement of the non-dispersive type has transducers (16) which, when actuated by a signal, generate either a signal which is in-phase with the actuating signal, or a signal which is out-of-phase with the actuating signal, or no signal at all.

**22.** Surface acoustic wave tag device according to one of the foregoing claims, **characterised in that** the programming/coding of the transducers of the non-dispersive type is performed by providing connecting conductors as required in the given case from the negative or positive bus to the positive and/or negative electrodes of the transducers, the connecting conductors preferably being bonded.

**23.** Surface acoustic wave tag device according to one of the foregoing claims, **characterised in that** the programming/coding of the transducers of the non-dispersive type is determined by, in a manner suited to the desired coding, cutting conductors which are present on the one hand between the positive bus bar and the positive and negative electrodes of the transducers and on the other hand between the negative bus bars and the positive and negative electrodes of the transducers.

**24.** Surface acoustic wave tag device according to one of the foregoing' claims, **characterised in that** each electrode of a transducer (16) of the non-dispersive type has a first and a second terminal and **in that** the first terminal is arranged close to the positive bus bar and the second terminal close to the negative bus bar.

**25.** Surface acoustic wave tag device according to claim 24, **characterised in that** the programming/coding of the transducers of the non-dispersive type is effected by arranging non-dispersive transducers not connected to the respective bus bars on a bottom plate, and by arranging on the bottom plate a top plate, on whose side associated with the bottom plate are arranged connecting conductors which connect the positive/negative electrodes to the positive or negative bus bars in the desired manner.

**26.** Surface acoustic wave tag device according to one of the foregoing claims, **characterised in that** at least one of the transducers of the non-dispersive type has signal conductors which connect the positive electrode and the negative electrode to both bus bars, and **in that** there are switches in the signal path formed by the connecting conductors, the switches preferably being transistors.

**27.** Surface acoustic wave tag device according to claim 26, **characterised in that** the device has a memory-equipped switching driver for controlling the switching and a power supply means, such as a battery for example, for supplying the circuit driver and/or the switches with power.

**28.** Surface acoustic wave tag device according to one of the foregoing claims, **characterised in that** the transducer arrangement is incorporated in a card which is made up in essence of three layers arranged one above another, the first layer and the third layer constituting a protective layer between which lies the second layer, within which latter the first and second transducer arrangements (9, 16) and the antenna (30) are formed.

29. Surface acoustic wave tag device according to one of the foregoing claims, **characterised in that** a first set of p non-dispersive transducers (16) is arranged on one side of the transformation arrangement of the dispersive type and a second set of q non-dispersive transducers (16) is arranged on the other side, and **in that** the first set of p transducers is coded with a code 1 and the second set of q transducers is coded with a code 2, and **in that** the codes are preferably different from one another.

30. Surface acoustic wave tag device according to one of the foregoing claims, **characterised in that** the transformation arrangement of the dispersive type is of a programmable length.

31. Surface acoustic wave tag device according to one of the foregoing claims, **characterised in that** the device is formed on a silicon substrate.

32. Surface acoustic wave tag device according to one of the foregoing claims, **characterised in that** the one of the n non-dispersive transducers which is situated closest to the dispersive transducer arrangement forms a reference transducer (reference element) whose (pulse) signal is emitted first in response to a (pulse) signal from the dispersive transducer arrangement.

33. Surface acoustic wave tag device according to one of the foregoing claims, **characterised in that** the number n of non-dispersive transducers (16) is more than 30.

34. Surface acoustic wave tag device according to one of the foregoing claims, **characterised in that**, of the n non-dispersive transducers, n-k transducers are programmable or programmed, where $k \leq n$.

35. Surface acoustic wave tag device according to one of the foregoing claims, **characterised in that** the tag is programmable once or more than once.

36. Surface acoustic wave tag device according to claim 35, **characterised in that** the means for reprogrammability has a control means (64) which is connected to a switching matrix (63), and has a program interface (66) and a storage means which can store one or more identification codes or a desired sequence of data, and **in that** the surface acoustic wave tag device can be programmed by using the stored data.

37. Use of a surface acoustic wave tag device according to one of the foregoing claims for identifying goods, human beings or animals.

38. Use according to claim 37, **characterised by** an interrogator (1).

39. Use according to claim 38, **characterised in that** the interrogator (1) emits an interrogating signal and receives and analyses a reply signal transmitted back by the surface acoustic wave tag device.

40. Use according to claim 38 or 39, **characterised in that** the interrogator (1) contains in the transmitting and/or receiving section a stage having a characteristic complementary to the dispersive transformation arrangement (9).

41. Use according to claim 38, 39 or 40, **characterised in that** the interrogator (1) is connected to a data-processing means and/or a data-processing system/network and emits received identifying characters (codes) from its output.

42. Use according to one of claims 38 to 41, **characterised in that** the interrogator has means for phase discrimination.

43. Use according to one of claims 38-42, **characterised in that** the interrogator has means for emitting an interrogating signal, the interrogating signal preferably being a chirp signal or a radio-frequency pulse.

44. Use according to one of claims 38 to 43, **characterised in that** the receiving unit of the interrogator (1) contains a stage having a characteristic which is the same as that of the dispersive transducer arrangement and a further stage having a correspondingly inverted characteristic.

45. Use according to claim 44, **characterised in that** the surface acoustic wave tag device has a first set of p non-dispersive transducers (16) on one side of the dispersive transducer arrangement (9) and a second set of q non-dispersive transducers (16) on the other side, the electrodes of the dispersive transducer arrangement being connected to the antenna and to the bus bars of the non-dispersive transducers, the first set of p transducers being coded with a code 1 and the second set of q transducers being coded with a code 2, **in that** the interrogating signal from the interrogator is a short radio-frequency pulse and the receiving unit of the interrogator (1) contains a stage having a characteristic which is the same as that of the dispersive transducer and a further stage having a correspondingly inverted characteristic, which means that an interrogating signal which is emitted by the interrogator and received via the antenna is converted into two surface waves in chirp form having complementary characteristics (up-chirp and down-chirp), which surface waves propagate in opposite directions and, on respectively reaching the first and second set of p and q transducers each trigger a differently coded code signal also having a different chirp characteristic, which means that in response to the interrogating signal the two sets of non-dispersive transducers each emit a series of surface waves (SAW's) carrying the relevant code in the direction of the dispersive transducer, which surface waves are converted there into code signals having different chirp characteristics, by which means there is produced on the common bus bars a signal carrying both codes, comprising up-chirp pulses which represent the first code and down-chirp pulses which represent the second code, and **in that** the signal produced on the bus bars is transmitted via the antenna to the receiving unit of the interrogator and is there converted by the dispersive stages having complementary characteristics into a first sequence of radio-frequency pulses representing the code 1 and/or a second sequence of radio-frequency pulses representing the code 2.

46. Use of a surface acoustic wave tag device according to one of claims 1 to 36, **characterised in that** the device is coupled to a data source and transmits to the device data that can be interrogated by an interrogating unit.

**Revendications**

1. Dispositif transducteur à ondes de surface, comprenant la combinaison d'un premier dispositif de transmission (9) du type dispersif et d'un second dispositif de transmission du type non dispersif, ce dernier se composant d'une pluralité de transducteurs (16) non dispersifs, qui sont codés avec un code d'identification, les espacements respectifs de transducteurs voisins non dispersifs étant identiques et la contribution d'un seul transducteur au code étant déterminée par une liaison aux électrodes du transducteur et la polarité avec laquelle il se fait.

2. Dispositif transducteur à ondes de surface selon la revendication 1,
   **caractérisé en ce que** les n transducteurs (16) non dispersifs sont programmés/codés et/ou commutés de telle sorte que, en cas d'excitation avec un signal, ils émettent un signal identifiant le dispositif transducteur à ondes de surface.

3. Dispositif transducteur à ondes de surface selon l'une quelconque des revendications-précédentes,
   **caractérisé en ce que** chaque transducteur non dispersif présente une électrode positive et une électrode négative et **en ce qu'**une ligne de bus positive est attribuée localement à l'électrode positive des n transducteurs et une ligne de bus négative est attribuée localement à l'électrode négative des n transducteurs et **en ce que** le codage/l'identification souhaité du dispositif transducteur à ondes de surface est effectué par le choix de la liaison entre les électrodes de transducteur positives et négatives et les lignes de bus positives et négatives.

4. Dispositif transducteur à ondes de surface selon l'une quelconque des revendications précédentes, le dispositif réagissant à un signal d'entrée électromagnétique avec un signal de sortie et le signal de sortie étant conçu de telle sorte qu'il présente au moins trois états (ABC) logiques différents.

5. Dispositif transducteur à ondes de surface selon l'une quelconque des revendications précédentes,
   **caractérisé en ce que**, lors de la réception d'un signal Chirp, le dispositif génère un grand nombre d'impulsions qui sont émises de façon successive dans le temps sous la forme de signaux de sortie.

6. Dispositif transducteur à ondes de surface selon l'une quelconque des revendications précédentes,
   **caractérisé en ce que** le dispositif émet successivement m signaux d'impulsion en cas de réception d'un signal Chirp, où $n \geq m$ et m correspond au nombre des transducteurs non dispersifs qui ne fournissent pas de signal d'impulsion.

7. Dispositif transducteur à ondes de surface selon l'une quelconque des revendications précédentes,
   **caractérisé en ce que** l'électrode positive du dispositif de transmission du type dispersif est reliée à la ligne de bus positive et l'électrode négative du transducteur du type dispersif est reliée à la ligne de bus négative.

8. Dispositif transducteur à ondes de surface selon l'une quelconque des revendications précédentes, **caractérisé en ce que** le dispositif présente un système d'antenne comprenant deux parties, la première partie de l'antenne étant reliée à la ligne de bus positive et l'autre partie à la ligne de bus négative.

9. Dispositif transducteur à ondes de surface selon l'une quelconque des revendications précédentes, **caractérisé en ce que** tous les transducteurs sont branchés électriquement en parallèle au moyen d'un circuit de programmation.

10. Dispositif transducteur à ondes de surface selon l'une quelconque des revendications précédentes, **caractérisé en ce qu'**au moins l'un des n transducteurs non dispersifs sert d'élément de référence.

11. Dispositif transducteur à ondes de surface selon l'une quelconque des revendications précédentes, **caractérisé en ce que** des transducteurs (16) du type non dispersif sont disposés seulement sur un côté ou sur les deux côtés du dispositif transducteur (9) du type dispersif.

12. Dispositif transducteur à ondes de surface selon l'une quelconque des revendications précédentes, **caractérisé en ce que**, en cas de réception d'un signal d'entrée, qui est une courte impulsion de radiofréquence, ce signal est transformé par le système de transmission dispersif en une première onde de surface de forme Chirp, qui se propage en direction des n transducteurs non dispersifs et déclenche des impulsions électriques de Chirp lors du passage des transducteurs non dispersifs, impulsions dont la superposition sur les lignes de bus représente le code programmé, alors qu'au cours de la même période les transducteurs non dispersifs et également excités par le signal d'entrée génèrent une succession d'ondes de surface représentant le code programmé, dont la caractéristique est identique à celle du signal d'entrée et qui se propagent en direction du système de transmission dispersif, où elles sont converties en impulsions électriques avec une caractéristique en forme de Chirp, qui sont émises simultanément et de façon précise en phase avec les impulsions de Chirp, générées par la première onde de surface, des transducteurs non dispersifs.

13. Dispositif transducteur à ondes de surface selon l'une quelconque des revendications précédentes, **caractérisé en ce que** le système de transmission génère des signaux qui peuvent encore être bien reçus même à une distance (r) de plus de 2 mètres.

14. Dispositif transducteur à ondes de surface selon l'une quelconque des revendications précédentes, **caractérisé en ce qu'**un signal de Chirp présente comme signal d'entrée une longueur dans le temps de 0,5 à 1,5 μs, de préférence 1 μs et **en ce que** le signal de Chirp présente une largeur de bande de fréquence de 50 jusqu'à 250 MHz.

15. Dispositif transducteur à ondes de surface selon l'une quelconque des revendications précédentes, **caractérisé en ce qu'**un signal d'impulsion, qui est généré par le dispositif transducteur du type dispersif en cas de réception d'un signal de Chirp, présente sensiblement une durée d'impulsion principale ($T_{sc}$), qui est calculée selon l'équation suivante :

$$T_{sc} = 2/B$$

B étant la largeur de bande du signal de Chirp.

16. Dispositif transducteur à ondes de surface selon l'une quelconque des revendications précédentes, **caractérisé en ce que** l'intervalle de temps de signaux d'impulsion successifs du second dispositif transducteur du type non dispersif est au moins aussi grand que la durée dans le temps ($T_{sc}$) du signal d'impulsion.

17. Dispositif transducteur à ondes de surface selon la revendication 16, **caractérisé en ce que** l'intervalle représente plusieurs fois, en particulier cinq à dix fois, la durée d'une seule impulsion.

18. Dispositif transducteur à ondes de surface selon l'une quelconque des revendications précédentes, **caractérisé en ce que** les premier et second dispositifs transducteurs (9, 16) sont des transducteurs interdigitaux (IDT).

19. Dispositif transducteur à ondes de surface selon l'une quelconque des revendications précédentes, **caractérisé en ce que** les transducteurs non dispersifs (16) réagissent à un signal d'impulsion avec un signal d'impulsion à deux phases, la position de phase du signal d'impulsion individuel dépendant préférentiellement du fait que l'électrode positive ou l'électrode négative du transducteur (16) concerné est raccordée à la ligne de bus positive ou négative.

20. Dispositif transducteur à ondes de surface selon l'une quelconque des revendications précédentes, **caractérisé en ce que** tous les transducteurs (16) non dispersifs commutés de façon active sont raccordés avec l'électrode positive à la ligne de bus positive et avec l'électrode négative à la ligne de bus négative.

21. Dispositif transducteur à ondes de surface selon l'une quelconque des revendications précédentes, **caractérisé en ce que** le dispositif transducteur du type non dispersif présente des transducteurs (16) qui, en cas d'excitation avec un signal, génèrent soit un signal qui est en phase (in-phase) avec le signal d'excitation, soit un signal qui n'est pas en phase (déphasé-off) avec le signal d'excitation ou ne génèrent pas de signal.

22. Dispositif transducteur à ondes de surface selon l'une quelconque des revendications précédentes, **caractérisé en ce que** la programmation/le codage des transducteurs du type non dispersif s'effectuent par le fait qu'à chaque fois des lignes de liaison souhaitées allant du bus positif ou négatif aux électrodes positives et/ou négatives des transducteurs sont prévues, les lignes de liaison étant de préférence bondérisées.

23. Dispositif transducteur à ondes de surface selon l'une quelconque des revendications précédentes, **caractérisé en ce que** la programmation/le codage des transducteurs du type non dispersif sont déterminés par le fait que des lignes, qui existent d'une part entre la ligne de bus positive et l'électrode positive et l'électrode négative des transducteurs et d'autre part entre la ligne de bus négative et les électrodes positives et négatives des transducteurs, sont séparés en fonction du codage souhaité.

24. Dispositif transducteur à ondes de surface selon l'une quelconque des revendications précédentes, **caractérisé en ce que** chaque électrode d'un transducteur (16) du type non dispersif présente un premier raccordement et un deuxième raccordement et **en ce que** le premier raccordement est disposé à proximité de la ligne de bus négative et le deuxième raccordement à proximité de la ligne de bus négative.

25. Dispositif transducteur à ondes de surface selon la revendication 24, **caractérisé en ce que** la programmation/le codage des transducteurs non dispersifs sont réalisés par le fait que des transducteurs non dispersifs sont disposés sur une plaque inférieure sans être reliés aux lignes de bus respectives et **en ce que** sur la plaque inférieure est disposée une plaque supérieure sur le côté, attribuée à la plaque inférieure, de laquelle sont disposées des lignes de liaison qui relient de la façon souhaitée les électrodes positives/ négatives à la ligne de bus positive ou négative.

26. Dispositif transducteur à ondes de surface selon l'une quelconque des revendications précédentes, **caractérisé en ce qu'**au moins l'un des transducteurs du type non dispersif présente des lignes de signalisation qui relient l'électrode positive et l'électrode négative aux deux lignes de bus et **en ce que** des interrupteurs sont disposés dans le cheminement du signal des lignes de liaison, les interrupteurs étant de préférence des transistors.

27. Dispositif transducteur à ondes de surface selon la revendication 26, **caractérisé en ce que** le dispositif présente un module de commande de circuit avec mémoire pour la commande du circuit et un dispositif d'alimentation d'énergie, par exemple une batterie pour l'alimentation du module de commande de circuit et/ou des interrupteurs en énergie.

28. Dispositif transducteur à ondes de surface selon l'une quelconque des revendications précédentes, **caractérisé en ce que** le dispositif transducteur est intégré dans une carte, qui comprend essentiellement trois couches disposées l'une sur l'autre, la première couche et la troisième couche représentant une couche de protection, entre laquelle se trouve la deuxième couche, à l'intérieur de laquelle sont disposés le premier et le second dispositifs transducteurs (9, 16) et l'antenne (30).

29. Dispositif transducteur à ondes de surface selon l'une quelconque des revendications précédentes, **caractérisé en ce qu'**un premier ensemble de p transducteurs (16) non dispersifs est disposé sur un côté du dispositif de transmission du type dispersif et un second ensemble q de transducteurs (16) non dispersifs est disposé sur l'autre côté, **en ce que** le premier ensemble de p transducteurs est programmé avec un code 1 et le second ensemble de q transducteurs avec un code 2 et **en ce que** les codes sont de préférence différents les uns des autres.

30. Dispositif transducteur à ondes de surface selon l'une quelconque des revendications précédentes, **caractérisé en ce que** le dispositif de transmission du type dispersif présente une longueur programmable.

31. Dispositif transducteur à ondes de surface selon l'une quelconque des revendications précédentes, **caractérisé en ce que** le dispositif est conçu sur un substrat de silicium.

32. Dispositif transducteur à ondes de surface selon l'une quelconque des revendications précédentes, **caractérisé en ce que** celui des n transducteurs non dispersifs qui est le plus proche du dispositif transducteur dispersif constitue un transducteur de référence (élément de référence), dont le signal (d'impulsion) est émis d'abord comme réaction à un signal (d'impulsion) du dispositif transducteur dispersif.

33. Dispositif transducteur à ondes de surface selon l'une quelconque des revendications précédentes, **caractérisé en ce que** le nombre n des transducteurs (16) non dispersifs est supérieur à 30.

34. Dispositif transducteur à ondes de surface selon l'une quelconque des revendications précédentes, **caractérisé en ce que**, sur les n transducteurs non dispersifs, n-k transducteurs sont programmables ou programmés, k étant inférieur ou égal à n.

35. Dispositif transducteur à ondes de surface selon l'une quelconque des revendications précédentes, **caractérisé en ce que** le TAG est programmable une fois ou plusieurs fois.

36. Dispositif transducteur à ondes de surface selon la revendication 35, **caractérisé en ce que** le dispositif présente un système de commande (64) pour la reprogrammabilité, qui est relié à une matrice de commutation (63), et présente une interface de programme (66) et un dispositif de mémoire, qui peut stocker un ou plusieurs codes d'identification ou une succession de données souhaitée, et **en ce que** le dispositif transducteur à ondes de surface est programmable à l'aide des données mémorisées.

37. Utilisation selon l'une quelconque des revendications précédentes pour l'identification de marchandises, de personnes ou d'animaux.

38. Utilisation selon la revendication 37, **caractérisée par** une unité d'interrogation/analyse (1)(interrogateur).

39. Utilisation selon la revendication 38, **caractérisée en ce que** l'interrogateur (1) envoie un signal d'interrogation et reçoit et analyse un signal de réponse envoyé par le dispositif transducteur à ondes de surface.

40. Utilisation selon la revendication 38 ou 39, **caractérisée en ce que** l'interrogateur (1) contient dans la partie d'émission et/ou de réception un niveau avec une caractéristique complémentaire du dispositif de transmission (9) dispersif.

41. Utilisation selon la revendication 38, 39 ou 40, **caractérisée en ce que** l'interrogateur (1) est relié à un dispositif de traitement de données et/ou un système/réseau de traitement de données et envoie des repères d'identification (codes) reçus sur sa sortie.

42. Utilisation selon l'une quelconque des revendications 38 à 41, **caractérisée en ce que** l'interrogateur présente des moyens pour la discrimination de phase.

43. Utilisation selon l'une quelconque des revendications 38 à 42, **caractérisée en ce que** l'interrogateur présente des moyens pour l'émission d'un signal d'interrogation, le signal d'interrogation étant de préférence un signal Chirp ou une impulsion de radiofréquence.

44. Utilisation selon l'une quelconque des revendications 38 à 43, **caractérisée en ce que** l'unité de réception de l'interrogateur (1) contient un niveau avec une caractéristique identique par rapport au dispositif transducteur dispersif et un autre niveau avec une caractéristique inversée en conséquence.

**45.** Utilisation selon la revendication 44,
**caractérisée en ce que** le dispositif transducteur à ondes de surface présente sur le côté du dispositif transducteur (9) dispersif un premier ensemble de p transducteurs (16) non dispersifs et sur l'autre côté un second ensemble de q transducteurs (16) non dispersifs, les électrodes du dispositif transducteur dispersif étant reliées à l'antenne et aux lignes de bus du transducteur non dispersif, le second ensemble de p transducteurs étant programmé avec un code 1 et le second ensemble de q transducteurs avec un code 2, **en ce que** le signal d'interrogation de l'interrogateur est une brève impulsion de radiofréquence et l'unité de réception d'un interrogateur (1) contient un niveau avec une caractéristique identique par rapport au transducteur dispersif et un autre niveau avec une caractéristique inversée en conséquence, de sorte qu'un signal d'interrogation émis par l'interrogateur et reçu par l'antenne est transformé par le transducteur dispersif en deux ondes de surface en forme de Chirp, se propageant dans le sens opposé, de caractéristique complémentaire (up-chirp, down-chirp), qui déclenchent à chaque fois un signal de code de codage différent et également avec une caractéristique de Chirp différente lorsqu'on atteint le premier ou le second ensemble de p ou q transducteurs, de sorte que les deux ensembles de transducteurs non dispersifs envoient en réaction au signal d'interrogation respectivement une série guidant le code concerné d'ondes de surface (SAW) en direction du transducteur dispersif, qui sont transformées à cet endroit en signaux de code avec une caractéristique de Chirp différente, de sorte qu'il se forme sur les lignes de bus communes un signal guidant les deux codes, composé d'impulsions up-Chirp, qui représentent le premier code, et d'impulsions down-Chirp qui représentent le second code, et **en ce que** le signal se formant sur les lignes de bus est transmis par l'antenne à l'unité de réception de l'interrogateur et est transformé ici par les niveaux dispersifs présentant une caractéristique complémentaire en une première succession représentant le code 1 et/ou une seconde succession représentant le code 2 d'impulsions de radiofréquence.

**46.** Utilisation d'un dispositif transducteur à ondes de surface selon l'une quelconque des revendications 1 à 36,
**caractérisée en ce que** le dispositif est couplé avec une source de données et transmet au dispositif des données qui peuvent être interrogées par une unité d'interrogation.

Fig. 1

Fig. 2a

Fig. 2b

EP 1 163 632 B1

Fig. 2c

Fig. 5a

TRANSMITTER

Fig. 5b

EP 1 163 632 B1

Fig. 5c

Fig. 6a

EP 1 163 632 B1

Fig. 6b

Fig. 7a

$U_{IN}(t)$

$U_{SE}$

$T_{SE}$

Fig. 7b

$U_{OUT}(t)$

$U_{SC}$

$T_{SE}$

Fig. 7c

Fig. 7d

Fig. 7e

Fig. 7f

EP 1 163 632 B1

Fig. 9a

Fig. 9b

EP 1 163 632 B1

Fig. 10a

Fig. 10

Fig. 10b

Fig. 10c

EP 1 163 632 B1

Substrate

Dispersive IDT 9

CHIRP PULSE GENERATOR

16

15

$U_{IN}(t)$

18

Acoustic Wave

$U_{OUT}(t)$

$Z_{LOAD}$

Non-dispersive IDT

17

Fig. 11a

EP 1 163 632 B1

$U_{IN}(t)$

[V]

15

$U_{SE}$

t

[s]

$T_{SE}$

Fig. 11b

$U_{OUT}(t)$

[V]

$U_{SC}$

13

t

[s]

$T_{SC}$

Fig. 11c

Fig. 11

Fig. 12a

Fig. 12b

Fig. 12c

Fig. 12

9 Dispersive IDT

Substrate

CHIRP PULSE GENERATOR

$U_{IN}(t)$

13

Acoustic Wave

$U_{OUT1}(t)$

$U_{OUT2}(t)$

$Z_{LOAD2}$

$Z_{LOAD1}$

16 Non-dispersive IDT

Fig. 13a

$U_{IN}(t)$

[V]

15

$U_{SE}$

$T_{SE}$

t [s]

Fig. 13b

Fig. 13

$U_{OUT1}(t)$

[V]

$U_{SC}$

13

$T_{SC}$

t [s]

$U_{OUT2}(t)$

[V]

13

$\Delta T_{21}$

t [s]

Fig. 13c

EP 1 163 632 B1

Fig. 14a

Fig. 14b

EP 1 163 632 B1

Fig. 15

EP 1 163 632 B1

Fig. 16a

Fig. 16b

Fig. 16c

Fig. 16

EP 1 163 632 B1

Tag Card

Tag's Antenna

Fig. 17

71

16

71

9

32

30

31

14

1 0 1 1 0 0 1 1

40

Fig. 18e

In Phase IDT  39

38 Out Of Phase IDT
37 Reference IDT

16

LEGEND:

Reference     In-Phase     Out-Of-Phase
Pulse         Pulse        Pulse

              Bit "1"       Bit "0"

13

Fig. 18d

39  40
38
37
71
9  16

Fig. 18b

Fig. 18

9

16

Fig. 18a

From Down-chirped Signal

Generated Bi-Phase Sequence
R 0 1 1 0 0 1 1

Reference Pulse

Fig. 18c

**38** Out Of Phase IDT

**37** Reference IDT

In Phase IDT **39**

Not Connected IDT **40**

## Fig. 19a

Number of bits
per IDT (symbol)

$$R_B = \log_2(3) =$$

$$= 1.585 \ \frac{bit}{symbol}$$

## Fig. 19c

From Down-chirped Signal

Generated Three-Level Sequence
R B A C B B C A

Reference Pulse

## Fig. 19b

## Fig. 19

LEGEND:

| Reference Pulse | In-Phase Pulse | Out-Of-Phase Pulse | No Pulse |
|---|---|---|---|
| | Symbol "A" | Symbol "B" | Symbol "C" |

## Fig. 19d

EP 1 163 632 B1

**Fig. 20a**

"Blank" Dispersive Delay Line: before coding

From Down-chirped Signal

Generated Three-Level Sequence
R B A C B B C A

Reference Pulse

41

Three-Level Coded Dispersive Delay Line
(code: RBACBBCA)

**Fig. 20**

38 Out Of Phase IDT
37 Reference IDT
In Phase IDT 39
Not Connected IDT 40

Bonding Wire

**Fig. 20c**

Number of bits
per IDT (symbol)

$R_B = \log_2(3) =$

$= 1.585 \, \dfrac{bit}{symbol}$

**Fig. 20b**

LEGEND:

| Reference Pulse | In-Phase Pulse | Out-Of-Phase Pulse | No Pulse |
|---|---|---|---|
| Symbol "A" | Symbol "B" | Symbol "C" | |

EP 1 163 632 B1

Fig. 21

Interrogator's Antenna

4

5

Tag's Antenna   7, 8, 30

One Time
Programmable
SAW Filter        9, 16

R

1

44

Interrogator

Tag

Fig. 22

EP 1 163 632 B1

Fig. 23

Interrogator's Antenna
with Beam control        4, 5

Interrogator

Major Radiation Lobe
(Controlled)        50

1

44

44

44

44

Tags

Fig. 24

EP 1 163 632 B1

Fig. 25

EP 1 163 632 B1

Fig. 26

Fig.27

Fig.28

SILIZIUM    SAW

Cover foil   79

Antenna   30

SAW-SI package   9,16

Distance foil   80

Cover foil   81

44

Battery   76

Fig. 29

EP 1 163 632 B1

BY BONDING

Fig. 30a

BY FLIP CHIP

Fig. 30b

BY SAW ABOVE SILICON

Fig. 30c

BY SAW EQUIVALENCE ON SILICON

Fig. 30d

Fig. 30

EP 1 163 632 B1

Programing Connection 54

Silicon Chip 82

54 Programing Connection

43

Power Supply Interconnection 55

16

52

9

53 Programing Connection

SAW Device 83

51 Power Supply Interconnection

42

Connection to antenna 57

Fig. 31

EP 1 163 632 B1

CHIRP PULSE GENERATOR

$U_{IN}(t)$

[V]

14

$U_{SE}$

t

[s]

$T_{SE}$

Apodized IDT          Substrate

$Z_{LOAD}$

16a          13

Acoustic Wave

$U_{COM}(t)$

58

Acoustic Wave

16b

$U_{EXP}(t)$          $Z_{LOAD}$

Non-apodized IDT

9

Fig. 32a

$U_{COM}(t)$

[V]

13

$U_{SC}$

t

[s]

$T_{SC}$          Fig. 32b

Fig. 32

$U_{EXP}(t)$

[V]

58

$\dfrac{U_{SE}}{\sqrt{2}}$

t

[s]

$2 \cdot T_{SE}$

Fig. 32c

EP 1 163 632 B1

84a    84b    9    84c        16

38 Out Of Phase IDT

37 Reference IDT

In Phase IDT 39

Not Connected IDT 40

## Fig. 33a

"Blank" Dispersive Delay Line: before coding

Number of bits
per IDT (symbol)

$$R_B = \log_2(3) =$$

$$= 1.585 \; \frac{bit}{symbol}$$

Bonding Wire

From Down-chirped Signal

Frequency Band:
High   Medium   Low    9      16

Generated Three-Level Sequence
R B A C B B C A

84a    84b    84c

Three-Level Coded Dispersive Delay Line
(code: RBACBBCA)

40

Reference Pulse

## Fig. 33

## Fig. 33b

LEGEND:

Reference
Pulse

In-Phase
Pulse

Out-Of-Phase
Pulse

No
Pulse

Symbol
"A"

Symbol
"B"

Symbol
"C"

EP 1 163 632 B1

Programing Module

Interconnection Area

SAW Device

Programing Connection

Connection to antenna

Fig. 34

$U_{IN}(t)$

[V]

$U_{SE}$

$T_{SE}$

t

[s]

Acoustic
Wave

13

58

Acoustic Wave

16a

9

16b

CHIRP PULSE
GENERATOR

$U_{IN}(t)$

Code For Down Chirp

Code For Up Chirp

"Blank" Dispersive Delay Line: before coding

Fig. 35

EP 1 163 632 B1

Fig. 36

EP 1 163 632 B1

Fig. 37

Fig. 38

EP 1 163 632 B1

Fig. 39

Fig. 40

EP 1 163 632 B1

Fig. 41

Fig. 42

Fig. 43

EP 1 163 632 B1

LEGEND:

Reference Pulse · In-Phase Pulse · Out-Of-Phase Pulse · No Pulse

Symbol "A" · Symbol "B" · Symbol "C"

Code For Up Chirp: RBACBBCA

Code For Down Chirp: ACBBCABR

From Up-chirped Signal

Generated Three-Level Sequence R B A C B B C A

Delayed Up-chirped Signal

Double Expanded Up-Chirped Signal

Reference Pulse

From Down-chirped Signal

Generated Three-Level Sequence A C B B C A B R

Delayed Down-chirped Signal

Double Expanded Down-Chirped Signal

Reference Pulse

Fig. 44

Fig. 45

Fig. 46

Tag Card With Sensor

Sensor 69

44

Battery, Solar Cell, Capacitor, etc

Tag's Antenna

61

SILICON CHIP

62

68

POWER SUPPLY

65 — RE-PROGRAMABLE CODE MEMORY

64

60 — SAW DEVICE

63 — SWITCHING MATRIX

MICRO-CONTROLLER

DATA SOURCE

For Example: 69 Sensor

...10110011...

67 — LOW PASS FILTER

PROGRAMING INTERFACE

66

40

EP 1 163 632 B1

Fig. 47

Programer 90

61 Tag's Antenna

69 Sensor

68 Battery

60, SAW Filter
64 with Silicon IC

61 Tag's Antenna

69 Sensor

44 Re-programable Tag

90

PROGRAMER'S CIRCUITRY

Amplifier

Programer's Antenna (Electrode) 91, 92

44

Fig.48

EP 1 163 632 B1